(19) Europäisches Patentamt
European Patent Office
Office européen des brevets

(11) EP 3 823 053 A1

(12) **EUROPEAN PATENT APPLICATION**

(43) Date of publication:
**19.05.2021 Bulletin 2021/20**

(51) Int Cl.:
*H01L 51/00* (2006.01) *H01L 51/50* (2006.01)

(21) Application number: **20207360.7**

(22) Date of filing: **13.11.2020**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **14.11.2019 KR 20190146174**

(71) Applicant: **Samsung Display Co., Ltd.**
**Yongin-si**
**Gyeonggi-do**
**17113 (KR)**

(72) Inventors:
- **YOON, Bohyun**
**17113 Yongin-si (KR)**
- **KO, Heejoo**
**17113 Yongin-si (KR)**
- **SUN, Jinwon**
**17113 Yongin-si (KR)**
- **SHIN, Hyun**
**17113 Yongin-si (KR)**

(74) Representative: **Shearman, James Ward**
**Marks & Clerk LLP**
**15 Fetter Lane**
**London EC4A 1BW (GB)**

# (54) ORGANIC LIGHT-EMITTING DEVICE AND APPARATUS INCLUDING THE SAME

(57) An organic light-emitting device includes a first electrode; a second electrode facing the first electrode; and an organic layer disposed between the first electrode and the second electrode and including a first emission layer and a second emission layer; wherein the first emission layer is located closer to the first electrode than the second emission layer and includes a first hole transport host, a first electron transport host, and a first phosphorescent dopant, and, in the first emission layer, an amount of the first hole transport host is greater than an amount of the first electron transport host, the second emission layer includes a second hole transport host, a second electron transport host, and a second phosphorescent dopant, and, in the second emission layer, an amount of the second electron transport host is greater than an amount of the second hole transport host, and the first emission layer and the second emission layer are configured to emit light of substantially the same color.

FIG. 1

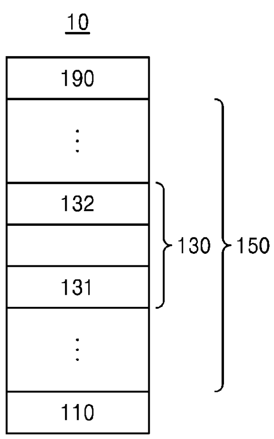


EP 3 823 053 A1

## Description

BACKGROUND

FIELD

Embodiments of the invention relate generally to display devices and, more particularly, to an organic light-emitting device and an apparatus including the same.

DISCUSSION OF THE BACKGROUND

Organic light-emitting devices are self-emission devices that produce full-color images, and also have wide viewing angles, high contrast ratios, short response times, and excellent characteristics in terms of brightness, driving voltage, and response speed, compared to devices in the art.

An example of the organic light-emitting devices may include a first electrode located on a substrate, and a hole transport region, an emission layer, an electron transport region, and a second electrode, which are sequentially located on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons.

According to electron spin statistics, singlet excitons and triplet excitons are formed in a ratio of 1: 3. Regarding these excitons, the transition between singlet excitons and triplet excitons occurs by inter-system crossing (ISC) or triplet-triplet fusion (TTF). In the case of devices using fluorescent emitters, light is formed while the singlet excitons transition from the excited state to the ground state, and in the case of devices using phosphorescent emitters, light is formed while the triplet excitons transition from the excited state to the ground state. However, many existing organic light-emitting devices suffer from reduced lifespans during operation.

The above information disclosed in this Background section is only for understanding of the background of the inventive concepts, and, therefore, it may contain information that does not constitute prior art.

SUMMARY

Applicant discovered that by combining emission layers of organic light-emitting devices with different attributes unexpected synergistic improvements in lifespan are obtained.

Organic emitting-light devices and apparatuses including the same constructed according to the principles and implementations of the invention have long lifespans. For example, the emission layer of an organic light-emitting device composed of one or more layers of certain compounds, particularly a first emission layer having an amount of a first hole transport host greater than the amount of the first electron transport host, and a second emission layer having a second electron transport host greater than an amount of the second hole transport host, where the first emission layer and the second emission layer emit light of the same color, exhibit improved lifespan.

Additional features of the inventive concepts will be set forth in the description which follows, and in part will be apparent from the description, or may be learned by practice of the inventive concepts.

According to one aspect of the invention, an organic light-emitting device includes: a first electrode; a second electrode facing the first electrode; and an organic layer disposed between the first electrode and the second electrode and including a first emission layer and a second emission layer; wherein the first emission layer is located closer to the first electrode than the second emission layer and includes a first hole transport host, a first electron transport host, and a first phosphorescent dopant, and, in the first emission layer, an amount of the first hole transport host is greater than an amount of the first electron transport host, the second emission layer includes a second hole transport host, a second electron transport host, and a second phosphorescent dopant, and, in the second emission layer, an amount of the second electron transport host is greater than an amount of the second hole transport host, and the first emission layer and the second emission layer are configured to emit light of substantially the same color.

The first hole transport host and the second hole transport host may each, independently from one another, be at least one of a compound represented by Formula 1:

<Formula 1>

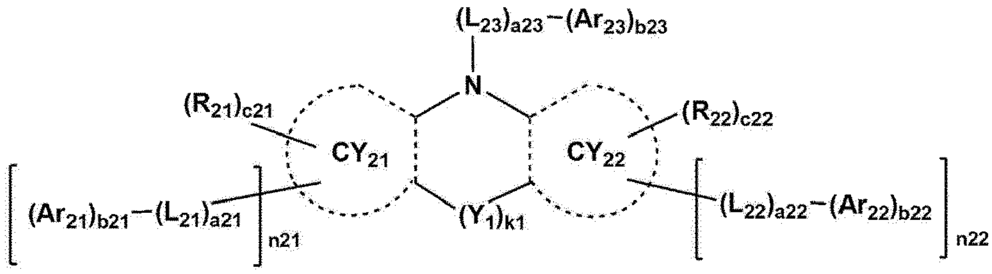

the first electron transport host and the second electron transport host are each, independently from one another, a compound represented by Formula 2:

<Formula 2>

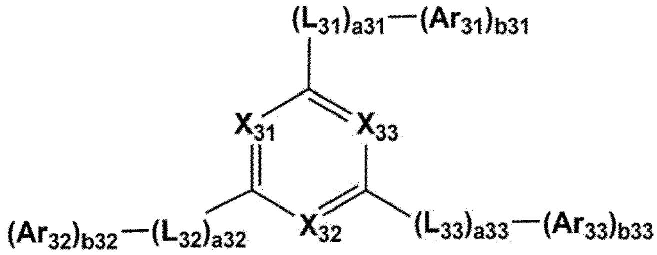

wherein, in Formula 1 and Formula 2,

$Y_1$ is a single bond, -O-, -S-, $-C(R_{24})(R_{25})-$, $-N(R_{24})-$, $-Si(R_{24})(R_{25})-$, -C(=O)-, $-S(=O)_2-$, $-B(R_{24})-$, $-P(R_{24})-$, or $-P(=O)(R_{24})(R_{25})-$;
k1 is 0 or 1;
$CY_{21}$ and CY22 are each, independently from one another, a $C_5$-$C_{60}$ carbocyclic group or a $C_1$-$C_{60}$ heterocyclic group;
$X_{31}$ is N or $C[(L_{34})_{a34}-(R_{31})]$, $X_{32}$ is N or $C[(L_{35})_{a35}-(R_{32})]$, and $X_{33}$ is N or $C[(L_{36})_{a36}-(R_{33})]$;
$L_{21}$ to L23 and $L_{31}$ to L36 are each, independently from one another, a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted C6-C60 arylene group, a substituted or unsubstituted $C_1$-$C_{60}$ heteroarylene group, a substituted or unsubstituted divalent non-aromatic fused polycyclic group, or a substituted or unsubstituted divalent non-aromatic fused heteropolycyclic group;
a21 to a23 and a31 to a36 are each, independently from one another, an integer from 0 to 5;
$Ar_{21}$ to Ar23 and $Ar_{31}$ to Ar33 are each, independently from one another, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_1$-$C_{60}$ heteroaryl group, a substituted or unsubstituted monovalent non-aromatic fused polycyclic group, or a substituted or unsubstituted monovalent non-aromatic fused heteropolycyclic group;
b21 to b23 and b31 to b33 are each, independently from one another, an integer from 1 to 8;
$R_{21}$, $R_{22}$, $R_{24}$, $R_{25}$, and $R_{31}$ to $R_{33}$ are each, independently from one another, hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy

group, a substituted or unsubstituted $C_1$-$C_{60}$heteroarylthio group, a substituted or unsubstituted monovalent non-aromatic fused polycyclic group, a substituted or unsubstituted monovalent non-aromatic fused heteropolycyclic group, -Si($Q_1$)($Q_2$)($Q_3$), -N($Q_1$)($Q_2$), - B($Q_1$)($Q_2$), -C(=O)($Q_1$), -S(=O)$_2$($Q_1$) and -P(=O)($Q_1$)($Q_2$);
c21 and c22 are each, independently from one another, an integer from 1 to 8;
n21 and n22 are each, independently from one another, an integer from 1 to 8;
at least two of $Ar_{21}$ to $Ar_{23}$, $R_{21}$ and $R_{22}$ are optionally linked to each other to form a substituted or unsubstituted $C_5$-$C_{60}$ carbocyclic group or a substituted or unsubstituted $C_1$-$C_{60}$ heterocyclic group;
at least two of $Ar_{31}$ to $Ar_{33}$ and $R_{31}$ to $R_{33}$ are optionally linked to each other to form a substituted or unsubstituted $C_5$-$C_{60}$ carbocyclic group or a substituted or unsubstituted $C_1$-$C_{60}$ heterocyclic group; and
at least one substituent of the substituted $C_5$-$C_{60}$ carbocyclic group, the substituted $C_1$-$C_{60}$ heterocyclic group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic fused polycyclic group, the substituted divalent non-aromatic fused heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted $C_1$-$C_{60}$ heteroaryloxy group, the substituted $C_1$-$C_{60}$ heteroarylthio group, the substituted monovalent non-aromatic fused polycyclic group, and the substituted monovalent non-aromatic fused heteropolycyclic group is:

deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each, independently from one another, substituted with at least one of deuterium, -F, -Cl, -Br, -I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic fused polycyclic group, a monovalent non-aromatic fused heteropolycyclic group, -Si($Q_{11}$)($Q_{12}$)($Q_{13}$), -N($Q_{11}$)($Q_{12}$), -B($Q_{11}$)($Q_{12}$), -C(=O)($Q_{11}$), -S(=O)$_2$($Q_{11}$), and -P(=O)($Q_{11}$)($Q_{12}$);
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic fused polycyclic group, and a monovalent non-aromatic fused heteropolycyclic group, each, independently from one another, optionally substituted with at least one of deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic fused polycyclic group, a monovalent non-aromatic fused heteropolycyclic group, -Si($Q_{21}$)($Q_{22}$)($Q_{23}$), -N($Q_{21}$)($Q_{22}$), -B($Q_{21}$)($Q_{22}$), - C(=O)($Q_{21}$), -S(=O)$_2$($Q_{21}$), and -P(=O)($Q_{21}$)($Q_{22}$); and
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), and - P(=O)($Q_{31}$)($Q_{32}$);
wherein $Q_1$ to $Q_3$, $Q_{11}$ to $Q_{13}$, $Q_{21}$ to $Q_{23}$, and $Q_{31}$ to $Q_{33}$ are each, independently from one another, hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a C6-C60 aryl group, a $C_1$-$C_{60}$ heteroaryl group, a monovalent non-aromatic fused polycyclic group, a monovalent non-aromatic fused heteropolycyclic group, a biphenyl group, and a terphenyl group.

The first hole transport host and the second hole transport host may be substantially identical to each other.

The first electron transport host and the second electron transport host may be substantially identical to each other.

The first emission layer and the second emission layer may each be configured to emit blue light having a maximum emission wavelength of about 400 nm to about 500 nm.

The first phosphorescent dopant and the second phosphorescent dopant may be substantially identical to each other.

The at least one of the first emission layer and the second emission layer may further include at least one of

a fluorescence dopant and a delayed fluorescence dopant.

The organic layer may further include a third emission layer disposed between the first emission layer and the second emission layer, and the third emission layer may include a third hole transport host, a third electron transport host, and a third phosphorescent dopant.

The amount of the first hole transport host in the first emission layer may be greater than an amount of the third hole transport host in the third emission layer, and the amount of the third hole transport host in the third emission layer may be greater than the amount of the second hole transport host in the second emission layer.

The amount of the second electron transport host in the second emission layer may be greater than an amount of the third electron transport host in the third emission layer, and the amount of the third electron transport host in the third emission layer may be greater than the amount of the first electron transport host in the first emission layer.

The third hole transport host and the third electron transport host of the third emission layer may have a weight ratio in the range of about 4: 6 to about 6: 4.

The first hole transport host, the second hole transport host, and the third hole transport host may be substantially identical to each other.

The first electron transport host, the second electron transport host, and the third electron transport host may be substantially identical to each other.

The first phosphorescent dopant, the second phosphorescent dopant, and the third phosphorescent dopant may be substantially identical to each other.

The first electrode may be an anode; the second electrode may be a cathode; and the organic layer further may include a hole transport region disposed between the first electrode and the first emission layer and an electron transport region disposed between the second emission layer and the second electrode.

The hole transport region may include at least one of a hole injection layer, a hole transport layer, a buffer layer, an emission auxiliary layer, and an electron blocking layer, and the electron transport region may include at least one of a hole blocking layer, a buffer layer, an electron control layer, an electron transport layer, and an electron injection layer.

The hole transport region may include a p-dopant having a lowest unoccupied molecular orbital energy level of less than about -3.5 eV.

The electron transport region may include a hole blocking layer including a hole blocking material; the hole blocking layer directly contacts the second emission layer; and the hole blocking material may be substantially the same as the second electron transport host.

The electron transport region may include a metal-containing material.

According to another aspect of the invention, an organic light-emitting device includes: a first electrode; a second electrode facing the first electrode; and an organic layer disposed between the first electrode and the second electrode and including an emission layer, having a first emission area and the second emission area; wherein, in the emission layer, the first emission area is located closer to the first electrode than the second emission area; each of the first emission area and the second emission area includes a hole transport host, an electron transport host, and a phosphorescent dopant; an amount of the hole transport host in the first emission area is greater than an amount of the electron transport host in the first emission area; an amount of the electron transport host in the second emission area is greater than an amount of the hole transport host in the second emission area; and
the phosphorescent dopant is an organometallic compound represented by Formula 4 or 5:

<Formula 4>

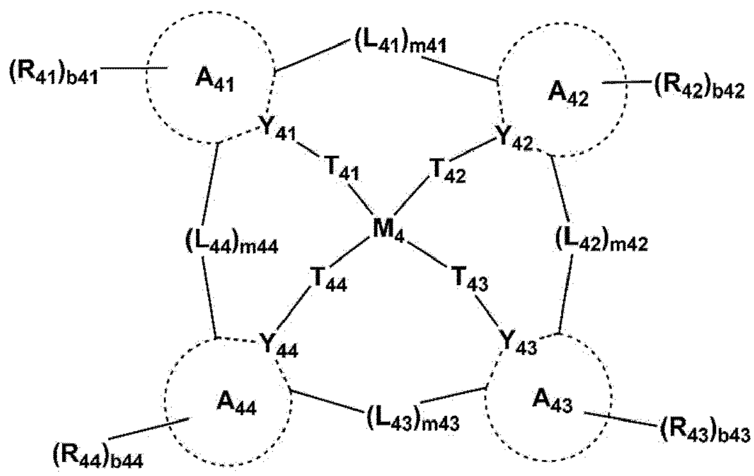

<Formula 5>

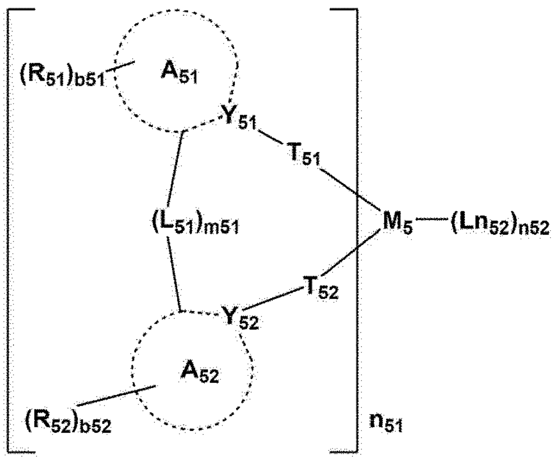

wherein, the variables are defined herein.

The emission layer may be configured to emit blue light having a maximum emission wavelength of about 400 nm to about 500 nm.

The amount of the hole transport host in the emission layer may gradually decrease from the first emission area toward the second emission area, and the amount of the electron transport host in the emission layer gradually may increase from the first emission area toward the second emission area.

The first electrode may be an anode, the second electrode may be a cathode, the organic layer further may include a hole transport region disposed between the first electrode and the emission layer and an electron transport region disposed between the emission layer and the second electrode, the hole transport region may include at least one of a hole injection layer, a hole transport layer, a buffer layer, an emission auxiliary layer, and an electron blocking layer, and the electron transport region may include at least one of a hole blocking layer, a buffer layer, an electron control layer, an electron transport layer, and an electron injection layer.

The hole transport region may include a p-dopant having a lowest unoccupied molecular orbital energy level of less than about -3.5 eV.

The electron transport region may include the hole blocking layer including a hole blocking material; the hole blocking layer may directly contact the emission area *(e.g.* layer); and the hole blocking material may be substantially identical to the hole transport host.

The electron transport region may include a metal-containing material.

An apparatus may include a thin-film transistor including a source electrode, a drain electrode, and an activation layer; and an organic light-emitting device as described above; wherein the first electrode of the organic light-emitting device may be electrically connected with one of the source electrode and the drain electrode of the thin-film transistor.

At least some of the above and other features of the invention are set out in the claims.

It is to be understood that both the foregoing general description and the following detailed description are explanatory and are intended to provide further explanation of the invention as claimed.

BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the inventive concepts.

FIG. 1 is a schematic cross-sectional diagram of an embodiment of an organic light-emitting device constructed according to principles of the invention.

FIG. 2 is a schematic cross-sectional diagram of another embodiment of an organic light-emitting device constructed according to principles of the invention.

FIG. 3 is a schematic cross-sectional diagram of yet another embodiment of an organic light-emitting device constructed according to principles of the invention.

FIG. 4 is a schematic diagram of an embodiment of an apparatus containing an organic light-emitting device constructed according to principles of the invention.

DETAILED DESCRIPTION

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods employing one or more of the inventive concepts disclosed herein. It is apparent, however, that various embodiments may be practiced without these specific details or with one or more equivalent arrangements. In other instances, well-known structures and devices are shown in block diagram form in order to avoid unnecessarily obscuring various embodiments. Further, various embodiments may be different, but do not have to be exclusive. For example, specific shapes, configurations, and characteristics of an embodiment may be used or implemented in another embodiment without departing from the inventive concepts.

Unless otherwise specified, the illustrated embodiments are to be understood as providing features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

The term "organic layer" as used herein refers to a single layer and/or a plurality of layers located between the first electrode and the second electrode of an organic light-emitting device. A material included in the "organic layer" is not limited to an organic material.

The expression "(an organic layer) includes a compound represented by Formula *"N"* (*N* is an integer)" as used herein may include a case in which an organic layer includes one compound of Formula *N* or two or more different compounds of Formula *N.*

FIG. 1 is a schematic cross-sectional diagram of an embodiment of an organic light-emitting device constructed according to principles of the invention.

Referring to FIG. 1, the organic light-emitting device 10 includes a first electrode 110; a second electrode 190 facing the first electrode 110; and an organic layer 150 including an emission layer 130. The emission layer 130 can have sublayers, such as a first emission layer 131 and a second emission layer 132, located between the first electrode 110 and the second electrode 190, wherein the first emission layer 131 is located closer to the first electrode 110 than the second emission layer 132.

The first emission layer 131 includes a first hole transport host, a first electron transport host, and a first phosphorescent dopant, and, in the first emission layer 131, the amount of the first hole transport host is greater than the amount of the first electron transport host,

The second emission layer 132 includes a second hole transport host, a second electron transport host, and a second phosphorescent dopant, and, in the second emission layer 132, the amount of the second electron transport host is greater than the amount of the second hole transport host.

The emission layer 130 of the organic light-emitting device 10 includes the first emission layer 131 and the second emission layer 132, and each of the first emission layer 131 and the second emission layer 132 includes the phosphorescent dopant, the hole transport host and electron transport host, wherein the ratio of the hole transport host and the electron transport host is controlled as described above. Accordingly, in the emission layer 130 of the organic light-emitting device 10, the balance between holes and electrons is controlled, and thus, the hole-electron recombination region is maintained within the emission layer 130. Therefore, exciton-polaron quenching is prevented, and the concentration of excitons in the emission layer 130 is appropriately controlled to prevent exciton-exciton quenching. As a result, the lifespan characteristics of the organic light-emitting device 10 may be significantly improved.

The first emission layer 131 and the second emission layer 132 emit light of the same color.

The first electrode 110 may be formed by depositing or sputtering a material for forming the first electrode 110 on a substrate. The material for forming the first electrode 110 may be selected from materials with a high work function to facilitate hole injection.

The first electrode 110 may be a reflective electrode, a semi-transmissive electrode, or a transmissive electrode. To form a transmissive electrode, a material for forming a first electrode 110 may be selected from an indium tin oxide (ITO), an indium zinc oxide (IZO), a tin oxide ($SnO_2$), a zinc oxide (ZnO), and any combinations thereof, but embodiments are not limited thereto. In one or more embodiments, to form a semi-transmissive electrode or a reflective electrode, a material for forming a first electrode 110 may be selected from magnesium (Mg), silver (Ag), aluminium (Al), aluminium-lithium (Al-Li), calcium (Ca), magnesium-indium (Mg-In), magnesium-silver (Mg-Ag), and any combinations thereof, but the embodiments are not limited thereto.

The first electrode 110 may have a single-layered structure, or a multi-layered structure including two or more layers. For example, the first electrode 110 may have a three-layered structure of an ITO/Ag/ITO, but the structure of the first electrode 110 is not limited thereto.

The organic layer 150 is located on the first electrode 110. As described above, the organic layer 150 includes the emission layer 130, and the emission layer 130 includes the first emission layer 131 and the second emission layer 132. The organic layer 150 may further include a hole transport region between the first electrode 110 and the first emission layer 131 and an electron transport region between the second emission layer 132 and the second electrode 190.

The hole transport region may have i) a single-layered structure including a single layer including a single material, ii) a single-layered structure including a single layer including a plurality of different materials, or iii) a multi-layered structure having a plurality of layers including a plurality of different materials.

For example, the hole transport region may have a single-layered structure including a single layer including a plurality of different materials, or a multi-layered structure having a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein for each structure, constituting layers are sequentially stacked from the first electrode

110 in this stated order, but the structure of the hole transport region is not limited thereto.

The hole transport region may include at least one compound selected from 4,4',4"-tris[phenyl(m-tolyl)amino]triphenylamine (m-MTDATA), 1-N,1-N-bis[4-(diphenylamino)phenyl]-4-N,4-N-diphenylbenzene-1,4-diamine (TDATA), 4,4',4"-tris[2-naphthyl(phenyl)amino]triphenylamine (2-TNATA), N,N'-di(naphthalene-1-yl)-N,N'-diphenyl-benzidine (NPB or NPD), N4,N4'-di(naphthalen-2-yl)-N4,N4'-diphenyl-[1,1'-biphenyl]-4,4'-diamine (β-NPB), N,N'-bis(3-methylphenyl)-N,N'-diphenyl-[1,1-biphenyl]-4,4'-diamine (TPD), (N,N'-bis(3-methylphenyl)-N,N'-diphenyl-9,9-spirobifluorene-2,7-diamine (spiro-TPD), 2,7-bis[N-(1-naphthyl)anilino]-9,9'-spirobi[9H-fluorene] (spiro-NPB), 2,2'-dimethyl-N,N'-di-[(1-naphthyl)-N,N'-diphenyl]-1,1'-biphenyl-4,4'-diamine (methylated-NPB), 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), 9-(4-tert-butylphenyl)-3,6-bis(triphenylsilyl)-9H-carbazole (CzSi), triphenylamine-based compounds such as 4,4',4"-tris(carbazol-9-yl)triphenylamine (TCTA), a compound represented by Formula 201, and a compound represented by Formula 202:

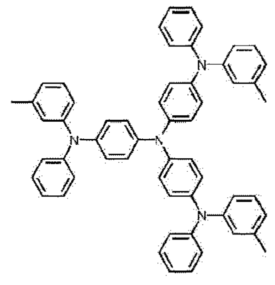

m-MTDATA

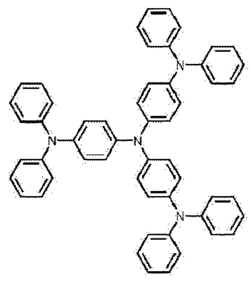

TDATA

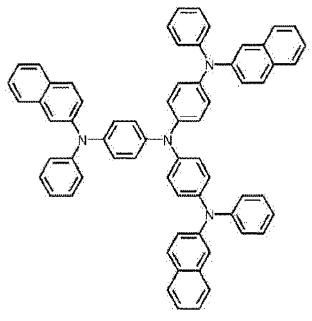

2-TNATA

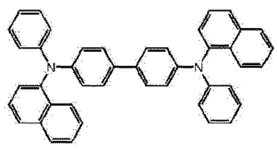

NPB

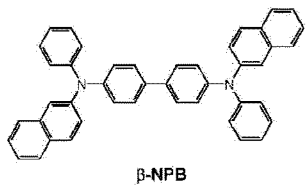

β-NPB

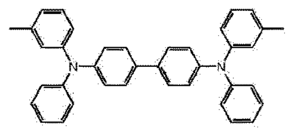

TPD

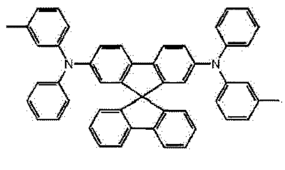

Spiro-TPD

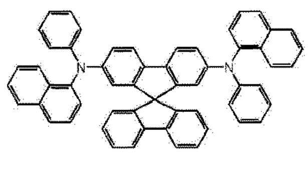

Spiro-NPB

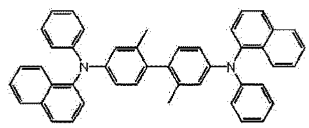

methylated NPB

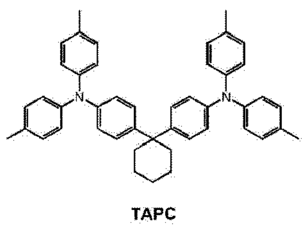

TAPC

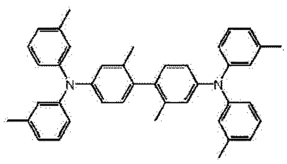

HMTPD

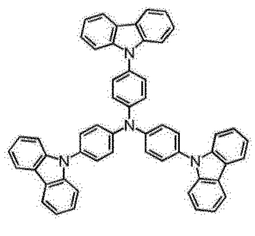

TCTA

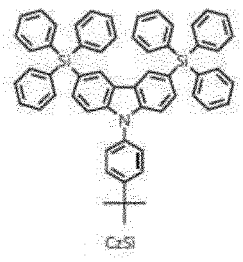

CzSi

<Formula 201>

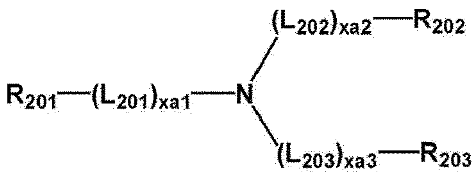

<Formula 202>

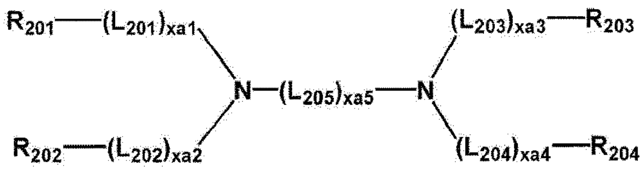

In Formulae 201 and 202,

$L_{201}$ to $L_{204}$ may each independently be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted C6-C60 (*e.g.* $C_6$-$C_{32}$) arylene group, a substituted or unsubstituted $C_1$-$C_{60}$ (*e.g.* $C_1$-$C_{20}$) heteroarylene group, a substituted or unsubstituted divalent non-aromatic condensed polycyclic group (or referred as divalent non-aromatic fused polycyclic group), and a substituted or unsubstituted divalent non-aromatic condensed heteropolycyclic group (or referred as divalent non-aromatic fused heteropolycyclic group),

$L_{205}$ may be selected from *-O-*', *-S-*', *-N($Q_{201}$)-*', a substituted or unsubstituted $C_1$-$C_{20}$ alkylene group, a substituted or unsubstituted $C_2$-$C_{20}$ alkenylene group, a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted C6-C60 (*e.g.* $C_6$-$C_{32}$) arylene group, a substituted or unsubstituted $C_1$-$C_{60}$ (*e.g.* $C_1$-$C_{20}$) heteroarylene group, a substituted or unsubstituted divalent non-aromatic condensed polycyclic group, and a substituted or unsubstituted divalent non-aromatic condensed heteropolycyclic group,

xa1 to xa4 may each independently be an integer from 0 to 3,

xa5 may be an integer from 1 to 10, and

$R_{201}$ to $R_{204}$ and $Q_{201}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{32}$) aryl group, a substituted or unsubstituted $C_6$-$C_{60}$ (*e.g.* $C_6$-$C_{32}$) aryloxy group, a substituted or unsubstituted $C_6$-$C_{60}$ (*e.g.* $C_6$-$C_{32}$) arylthio group, a substituted or unsubstituted $C_1$-$C_{60}$ (*e.g.* $C_1$-$C_{20}$) heteroaryl group, a substituted or unsubstituted monovalent non-aromatic condensed polycyclic group (or referred as monovalent non-aromatic fused polycyclic group), and a substituted or unsubstituted monovalent non-aromatic condensed heteropolycyclic group (or referred as monovalent non-aromatic fused heteropolycyclic group).

In one embodiment, in Formula 202, $R_{201}$ and $R_{202}$ may optionally be linked to each other via a single bond, a dimethyl-methylene group, or a diphenyl-methylene group, and $R_{203}$ and $R_{204}$ may optionally be linked to each other via a single bond, a dimethyl-methylene group, or a diphenyl-methylene group.

In one embodiment, in Formulae 201 and 202,

$L_{201}$ to $L_{205}$ may each independently be selected from:

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and

a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, $-Si(Q_{31})(Q_{32})(Q_{33})$, and $-N(Q_{31})(Q_{32})$,
wherein $Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, $R_{201}$ to $R_{204}$ and $Q_{201}$ may each independently be selected from: a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group,

a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, $-Si(Q_{31})(Q_{32})(Q_{33})$, and $-N(Q_{31})(Q_{32})$,

$Q_{31}$ to $Q_{33}$ are the same as described above.

In one or more embodiments, at least one selected from $R_{201}$ to $R_{203}$ in Formula 201 may each independently be selected from:

a fluorenyl group, a spiro-bifluorenyl group, a carbazolyl group, a dibenzofuranyl group, and a dibenzothiophenyl group; and

a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a carbazolyl group, a dibenzofuranyl group, and a dibenzothiophenyl group, but the embodiments are not limited thereto.

In one or more embodiments, in Formula 202, i) $R_{201}$ and $R_{202}$ may be linked to each other via a single bond, and/or ii) $R_{203}$ and $R_{204}$ may be linked to each other via a single bond.

In one or more embodiments, $R_{201}$ to $R_{204}$ in Formula 202 may each independently be selected from:

a carbazolyl group; and

a carbazolyl group substituted with at least one selected from deuterium, -F, -Cl, - Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a carbazolyl group, a dibenzofuranyl group, and a dibenzothiophenyl group,

but the embodiments are not limited thereto.

The compound represented by Formula 201 may be represented by Formula 201A below:

<Formula 201A>

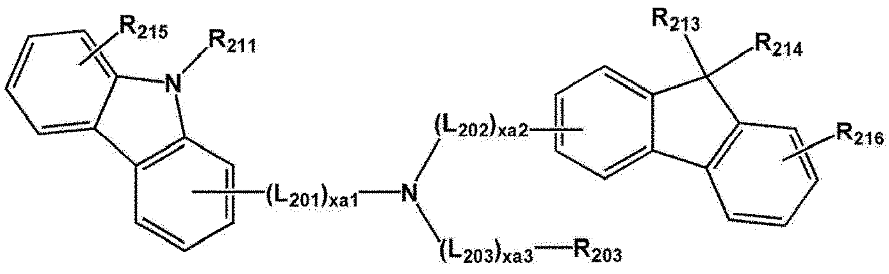

In one embodiment, the compound represented by Formula 201 may be represented by Formula 201A(1) below, but the embodiments are not limited thereto:

<Formula 201A(1)>

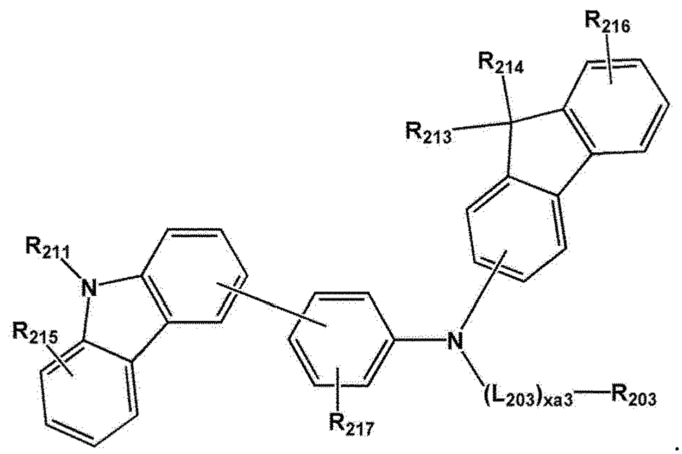

.

In one or more embodiments, the compound represented by Formula 201 may be represented by Formula 201A-1 below, but the embodiments are not limited thereto:

<Formula 201A-1>

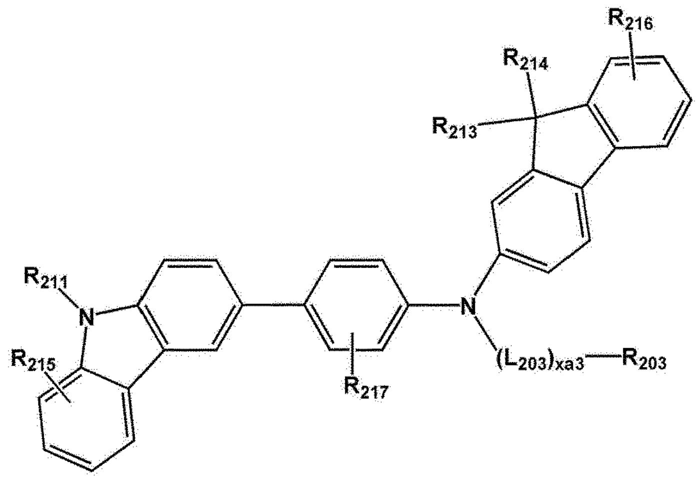

.

In one embodiment, the compound represented by Formula 202 may be represented by Formula 202A below:

<Formula 202A>

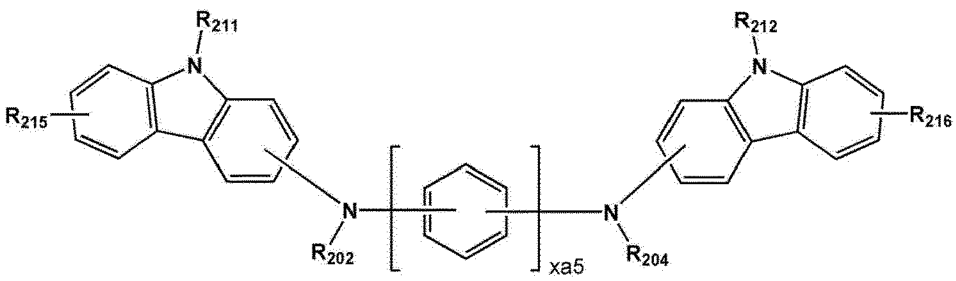

.

In one or more embodiments, the compound represented by Formula 202 may be represented by Formula 202A-1 below:

<Formula 202A-1>

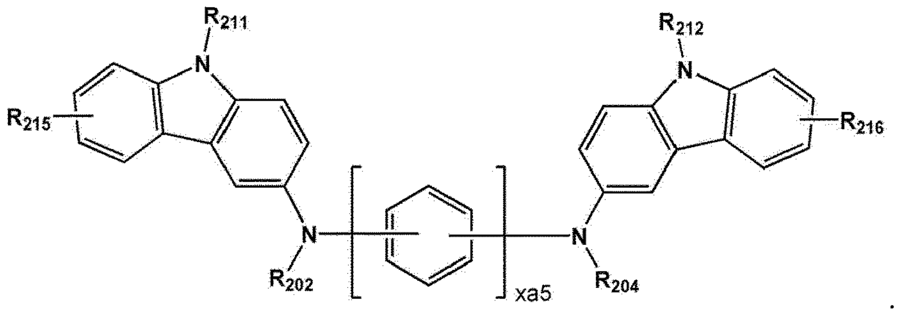

In Formulae 201A, 201A(1), 201A-1, 202A, and 202A-1,
$L_{201}$ to $L_{203}$, xa1 to xa3, xa5, and $R_{202}$ to $R_{204}$ may each be understood by referring to the corresponding descriptions thereof presented herein,
$R_{211}$ and $R_{212}$ may each be understood by referring to the descriptions provided in connection with $R_{203}$ herein, and
$R_{213}$ to $R_{217}$ may each independently be selected from hydrogen, deuterium, -F, - Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT39 below, but the embodiments are not limited thereto:

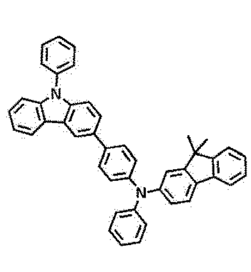

HT1

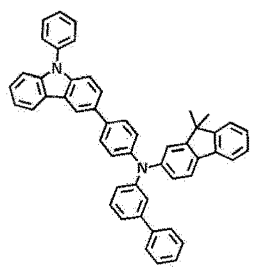

HT2

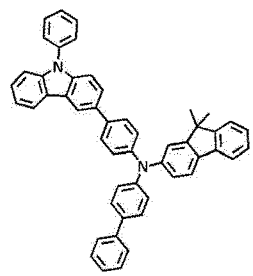

HT3

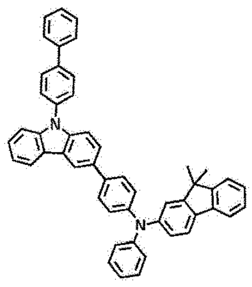

HT4

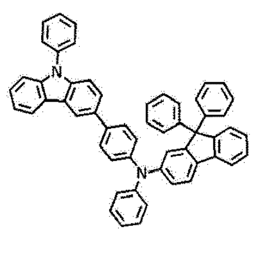

HT5

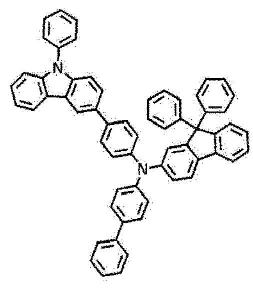

HT6

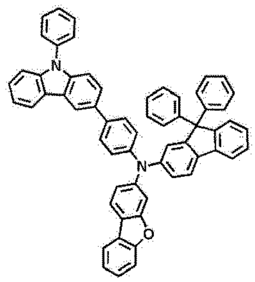
HT7

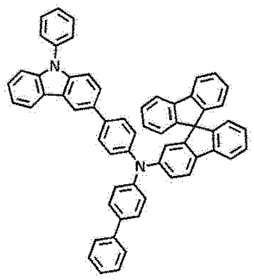
HT8

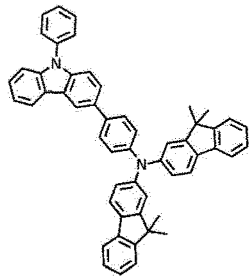
HT9

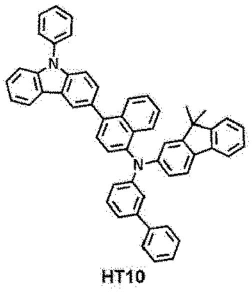
HT10

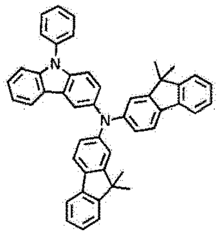
HT11

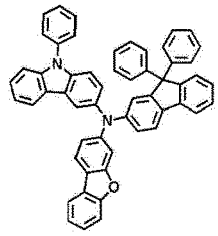
HT12

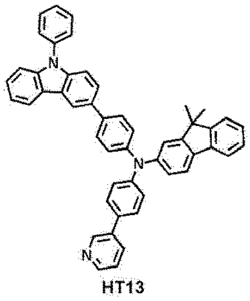
HT13

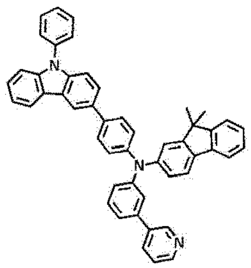
HT14

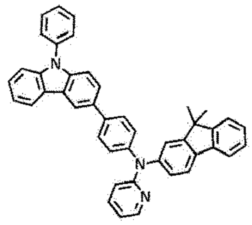
HT15

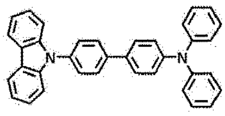
HT16

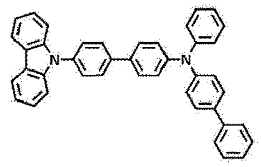
HT17

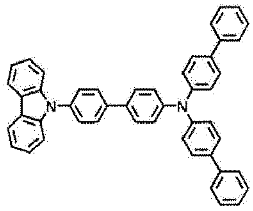
HT18

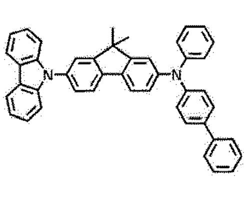
HT19

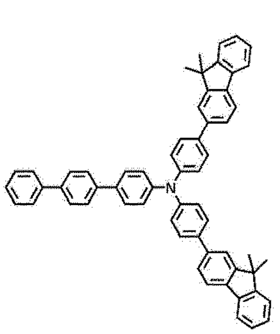
HT20

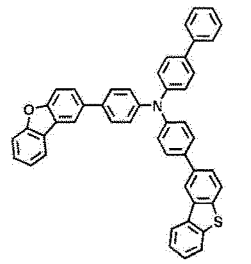
HT21

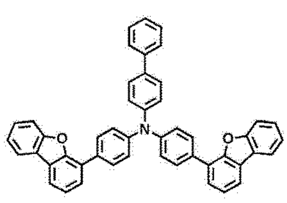

HT22

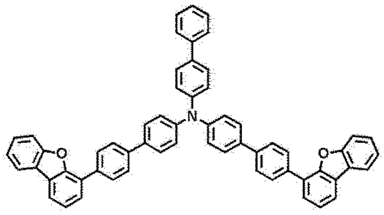

HT23

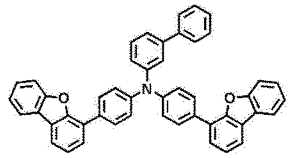

HT24

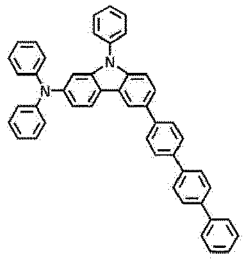

HT25

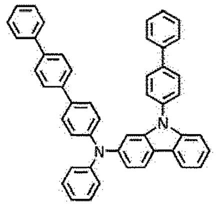

HT26

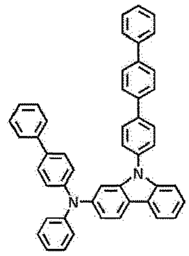

HT27

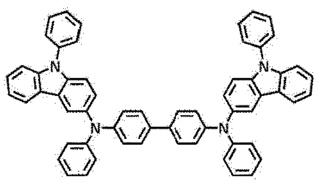

HT28

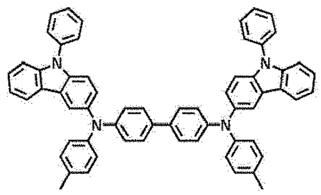

HT29

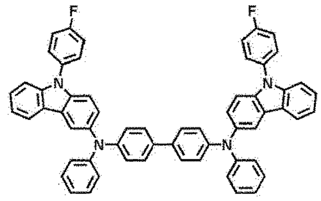

HT30

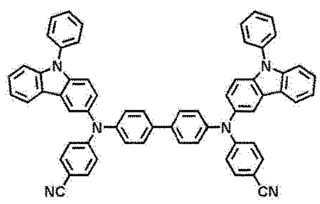

HT31

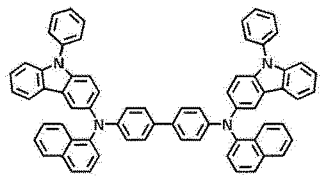

HT32

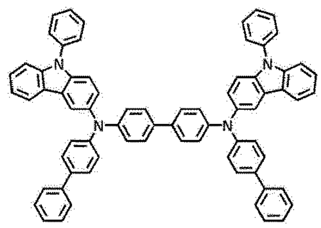

HT33

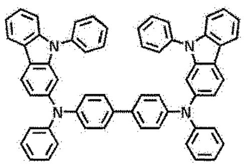

HT34

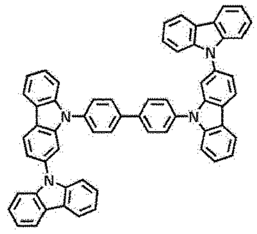

HT35

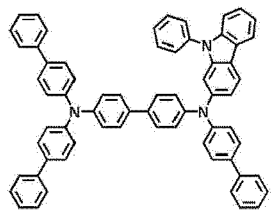

HT36

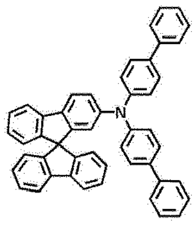

HT37

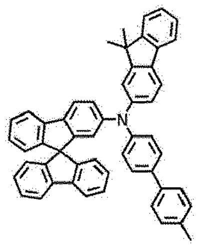

HT38

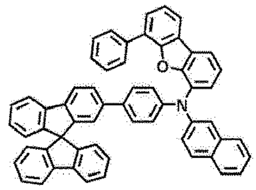

HT39 .

The thickness of the hole transport region may be from about 100 Å to about 10,000 Å, for example, about 100 Å to about 7,000 Å, about 100 Å to about 5,000 Å, about 100 Å to about 3,000 Å or about 100 Å to about 1,000 Å. When the hole transport region includes at least one selected from a hole injection layer and a hole transport layer, the thickness of the hole injection layer may be in a range of about 100 Å to about 9,000 Å, for example, about 100 Å to about 7,000 Å, about 100 Å to about 5,000 Å, about 100 Å to about 3,000 Å, about 100 Å to about 2,000 Å, about 100 Å to about 1,000 Å, or about 100 Å to about 200 Å, and the thickness of the hole transport layer may be in a range of about 50 Å to about 2,000 Å, for example about 100 Å to about 1,500 Å, or about 600 Å to about 800 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant.

In one embodiment, the p-dopant may have a lowest unoccupied molecular orbital (LUMO) energy level of about -3.5 eV or less.

The p-dopant may include at least one selected from a quinone derivative, a metal oxide, and a cyano group-containing compound, but the embodiments are not limited thereto.

For example, the p-dopant may include at least one selected from: a quinone derivative, such as tetracyanoquinodimethane (TCNQ) or 2,3,5,6-tetrafluoro-7,7,8,8-tetracyanoquinodimethane (F4-TCNQ);
a metal oxide, such as tungsten oxide or molybdenum oxide;
1,4,5,8,9,12-hexaazatriphenylene-hexacarbonitrile (HAT-CN); and
a compound represented by Formula 221 below,
but the embodiments are not limited thereto:

<HAT-CN>

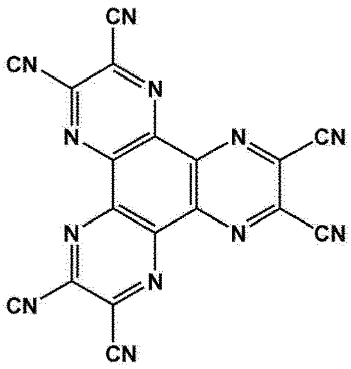

<F4-TCNQ>

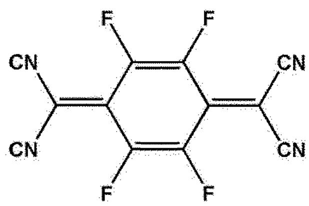

<Formula 221>

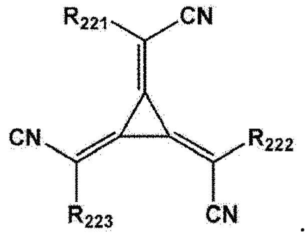

In Formula 221,

$R_{221}$ to $R_{223}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{32}$) aryl group, a substituted or unsubstituted $C_1$-$C_{60}$ (*e.g.* $C_1$-$C_{20}$) heteroaryl group, a substituted or unsubstituted monovalent non-aromatic condensed polycyclic group, and a substituted or unsubstituted monovalent non-aromatic condensed heteropolycyclic group, wherein at least one selected from $R_{221}$ to $R_{223}$ may have at least one substituent selected from a cyano group, -F, -Cl, -Br, -I, a $C_1$-C20 alkyl group substituted with -F, a $C_1$-$C_{20}$ alkyl group substituted with -Cl, a $C_1$-$C_{20}$ alkyl group substituted with -Br, and a $C_1$-$C_{20}$ alkyl group substituted with -I.

First emission layer 131 and second emission layer 132 are included in organic layer 150.

The first emission layer 131 includes a first hole transport host, a first electron transport host, and a first phosphorescent dopant, and, in the first emission layer 131, the amount of the first hole transport host is greater than the amount of the first electron transport host.

In the first emission layer 131, the amount of the first hole transport host is greater than the amount of the first electron transport host, and in the second emission layer 132, the amount of the second electron transport host is greater than the amount of the second hole transport host.

An emission layer 130 of the organic light-emitting device 10 includes the first emission layer 131 and the second emission layer 132, and each of the first emission layer 131 and the second emission layer 132 includes a phosphorescent dopant, a hole transport host and an electron transport host, wherein the ratio of the hole transport host and the electron transport host is controlled as described above. Accordingly, in the emission layer 130 of the organic light-emitting device 10, the balance between holes and electrons is controlled, and thus, the hole-electron recombination region is maintained within the emission layer 130. Therefore, exciton-polaron quenching is prevented, and the concentration of excitons in the emission layer 130 is appropriately controlled to prevent exciton-exciton quenching. As a result, the lifespan characteristics of the organic light-emitting device 10 may be significantly improved.

The first emission layer 131 and the second emission layer 132 emit light of the same color.

According to one embodiment, each of the first emission layer 131 and the second emission layer 132 may emit blue light. For example, the first emission layer 131 and the second emission layer 132 may each emit blue light having a maximum emission wavelength of about 400 nm to about 500 nm.

According to one embodiment, each of the first emission layer 131 and the second emission layer 132 may emit green light. For example, the first emission layer 131 and the second emission layer 132 may each emit green light having a maximum emission wavelength of about 500 nm to about 650 nm.

According to one embodiment, each of the first emission layer 131 and the second emission layer 132 may emit red light. For example, the first emission layer 131 and the second emission layer 132 may each emit red light having a maximum emission wavelength of about 650 nm to about 750 nm.

The amount of the first phosphorescent dopant in the first emission layer 131 is typically from about 0.01 parts by weight to about 50 parts by weight, for example, 0.1 parts by weight to 30 parts by weight, or 5 parts by weight to 10 parts by weight, based on the total weight of 100 parts by weight of the first hole transport host and the first electron transport host, but the embodiments are not limited thereto. The amount of the second phosphorescent dopant in the second emission layer 132 is typically from about 0.01 parts by weight to about 50 parts by weight, for example, 0.1 parts by weight to 30 parts by weight, based on the total weight of about 100 parts by weight of the second hole transport host and the second electron transport host, but the embodiments are not limited thereto.

The thickness of the first emission layer 131 and the thickness of the second emission layer 132 may each be about 5 nm to about 100 nm, for example about 10 nm to about 60 nm. When the thickness of each of the first emission layer 131 and the second emission layer 132 is within theses ranges, excellent light-emission characteristics may be obtained without a substantial increase in driving voltage.

According to one embodiment, the first hole transport host and the second hole transport host may each be a compound including a hole transport moiety. For example, the hole transport moiety may include a carbazole group, a

dibenzofuran group, a dibenzothiophene group, an indolocarbazole group, a bis-carbazole group, or an amine group.

According to one embodiment, the first hole transport host and the second hole transport host may each be a compound that does not include an electron transport moiety.

According to one embodiment, the first hole transport host and the second hole transport host may each be a compound including a hole transport moiety. For example, the electron transport moiety may include -CN; -F; an alkyl group substituted with -CN or -F; an aryl group substituted with -F or -CN; or a $C_1$-$C_{60}$ heterocyclic group including *=N-*' moiety. For example, the electron transport moiety may include a pyridine group, a pyrimidine group, a triazine group, a quinoline group, an isoquinoline group, or the like.

According to one embodiment, the first hole transport host and the second hole transport host may each independently be a compound represented by Formula 1:

<Formula 1>

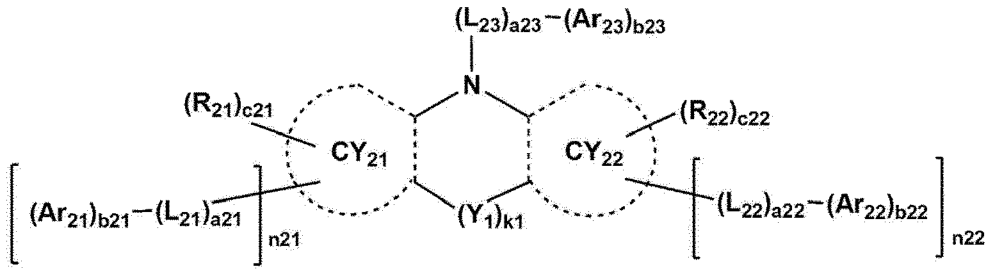

According to one embodiment, the first electron transport host and the second electron transport host may each independently be a compound represented by Formula 2:

<Formula 2>

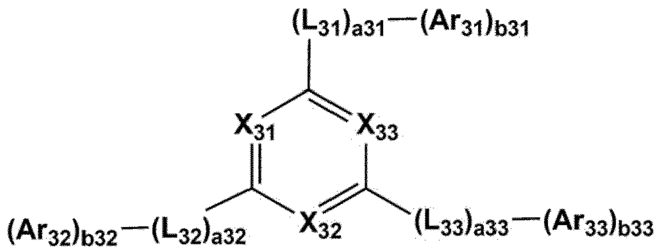

wherein, in Formula 1 and Formula 2,

$Y_1$ is selected from a single bond, -O-, -S-, -C($R_{23}$)($R_{24}$)-, -N($R_{23}$)-, -Si($R_{23}$)($R_{24}$)-, -C(=O)-, -S(=O)$_2$-, -B($R_{23}$)-, -P($R_{24}$)-, and -P(=O)($R_{23}$)($R_{24}$)-,

k1 is 0 or 1,

$CY_{21}$ and CY22 are each independently a $C_5$-$C_{60}$ (*e.g.* $C_5$-$C_{30}$) carbocyclic group or a $C_1$-$C_{60}$ (*e.g.* $C_1$-$C_{20}$) heterocyclic group,

$X_{31}$ is N or C[($L_{34}$)$_{a34}$-($R_{31}$)], $X_{32}$ is N or C[($L_{35}$)$_{a35}$-($R_{32}$)], $X_{33}$ is N or C[($L_{36}$)$_{a36}$-($R_{33}$)],

$L_{21}$ to $L_{23}$ and $L_{31}$ to $L_{36}$ are each independently selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ (*e.g.* $C_6$-$C_{30}$) arylene group, a substituted or unsubstituted $C_1$-$C_{60}$ (*e.g.* $C_1$-$C_{20}$) heteroarylene group, a substituted or unsubstituted divalent non-aromatic condensed polycyclic group, and a substituted or unsubstituted divalent non-aromatic condensed heteropolycyclic group,

a21 to a23 and a31 to a36 are each independently an integer from 0 to 5,

$Ar_{21}$ to $Ar_{23}$ and $Ar_{31}$ to $Ar_{33}$ are each independently selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_1$-$C_{60}$ (*e.g.* $C_1$-$C_{20}$) heteroaryl group, a substituted or

unsubstituted monovalent non-aromatic condensed polycyclic group, and a substituted or unsubstituted monovalent non-aromatic condensed heteropolycyclic group,

b21 to b23 and b31 to b33 are each independently an integer from 1 to 8,

$R_{21}$ to $R_{24}$, and $R_{31}$ to $R_{33}$ are each independently selected from hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ (*e.g.* $C_1$-$C_{20}$) alkyl group, a substituted or unsubstituted $C_2$-$C_{60}$ (*e.g.* $C_2$-$C_{20}$) alkenyl group, a substituted or unsubstituted $C_2$-$C_{60}$ (*e.g.* $C_2$-$C_{20}$) alkynyl group, a substituted or unsubstituted $C_1$-$C_{60}$ (*e.g.* $C_1$-C20) alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* $C_6$-$C_{30}$) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted $C_1$-$C_{60}$ (*e.g.* $C_1$-$C_{20}$) heteroaryloxy group, a substituted or unsubstituted $C_1$-$C_{60}$ (*e.g.* $C_1$-$C_{20}$) heteroarylthio group, a substituted or unsubstituted monovalent non-aromatic condensed polycyclic group, a substituted or unsubstituted monovalent non-aromatic condensed heteropolycyclic group, - $Si(Q_1)(Q_2)(Q_3)$, $-N(Q_1)(Q_2)$, $-B(Q_1)(Q_2)$, $-C(=O)(Q_1)$, $-S(=O)_2(Q_1)$, and $-P(=O)(Q_1)(Q_2)$,

c21 and c22 are each independently an integer from 1 to 8,

n21 and n22 are each independently an integer from 1 to 8,

at least two selected from $Ar_{21}$ to $Ar_{23}$, $R_{21}$ and $R_{22}$ are optionally linked to each other to form a substituted or unsubstituted $C_5$-$C_{60}$ (*e.g.* $C_5$-$C_{30}$) carbocyclic group or a substituted or unsubstituted $C_1$-$C_{60}$ (*e.g.* $C_1$-$C_{20}$) heterocyclic group,

at least two selected from $Ar_{31}$ to $Ar_{33}$ and $R_{31}$ to $R_{33}$ are optionally linked to each other to form a substituted or unsubstituted $C_5$-$C_{60}$ (*e.g.* $C_5$-$C_{30}$) carbocyclic group or a substituted or unsubstituted $C_1$-$C_{60}$ (*e.g.* $C_1$-$C_{20}$) heterocyclic group,

at least one substituent of the substituted $C_5$-$C_{60}$ (*e.g.* $C_5$-$C_{30}$) carbocyclic group, the substituted $C_1$-$C_{60}$ (*e.g.* $C_1$-$C_{20}$) heterocyclic group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ (*e.g.* $C_6$-$C_{30}$) arylene group, the substituted $C_1$-$C_{60}$ (*e.g.* $C_1$-$C_{20}$) heteroarylene group, the substituted divalent non-aromatic condensed polycyclic group, the substituted divalent non-aromatic condensed heteropolycyclic group, the substituted $C_1$-$C_{60}$ (*e.g.* $C_1$-$C_{20}$) alkyl group, the substituted $C_2$-$C_{60}$ (*e.g.* $C_2$-$C_{20}$) alkenyl group, the substituted $C_2$-$C_{60}$ (*e.g.* $C_2$-$C_{20}$) alkynyl group, the substituted $C_1$-$C_{60}$ (*e.g.* $C_1$-$C_{20}$) alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ (*e.g.* $C_6$-$C_{30}$) aryl group, the substituted $C_6$-$C_{60}$ (*e.g.* $C_6$-$C_{30}$) aryloxy group, the substituted $C_6$-$C_{60}$ (*e.g.* $C_6$-$C_{30}$) arylthio group, the substituted $C_1$-$C_{60}$ (*e.g.* $C_1$-$C_{20}$) heteroaryl group, the substituted $C_1$-$C_{60}$ (*e.g.* $C_1$-$C_{20}$) heteroaryloxy group, the substituted $C_1$-$C_{60}$ (*e.g.* $C_1$-$C_{20}$) heteroarylthio group, the substituted monovalent non-aromatic condensed polycyclic group, and the substituted monovalent non-aromatic condensed heteropolycyclic group is selected from:

deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a C2-C60 (*e.g.* $C_2$-$C_{20}$) alkenyl group, a $C_2$-$C_{60}$ (*e.g.* $C_2$-$C_{20}$) alkynyl group, and a $C_1$-$C_{60}$ (*e.g.* $C_1$-$C_{20}$) alkoxy group;

a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, and a $C_1$-$C_{60}$ (*e.g.* $C_1$-$C_{20}$) alkoxy group, each substituted with at least one selected from deuterium, -F, -Cl, -Br, -I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a monovalent non-aromatic condensed polycyclic group, a monovalent non-aromatic condensed heteropolycyclic group, - $Si(Q_{11})(Q_{12})(Q_{13})$, $-N(Q_{11})(Q_{12})$, $-B(Q_{11})(Q_{12})$, $-C(=O)(Q_{11})$, $-S(=O)_2(Q_{11})$, and $-P(=O)(Q_{11})(Q_{12})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino

group, a hydrazono group, a $C_1$-$C_{60}$ *(e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a C3-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a monovalent non-aromatic condensed polycyclic group, a monovalent non-aromatic condensed heteropolycyclic group, -Si($Q_{21}$)($Q_{22}$)($Q_{23}$), -N($Q_{21}$)($Q_{22}$), -B($Q_{21}$)($Q_{22}$), -C(=O)($Q_{21}$), -S(=O)$_2$($Q_{21}$), and - P(=O)($Q_{21}$)($Q_{22}$); and

-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), and - P(=O)($Q_{31}$)($Q_{32}$),

wherein $Q_1$ to $Q_3$, $Q_{11}$ to $Q_{13}$, $Q_{21}$ to $Q_{23}$, and $Q_{31}$ to $Q_{33}$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_1$-$C_{60}$ (*e.g.* $C_1$-$C_{20}$) heteroaryl group, a monovalent non-aromatic condensed polycyclic group, a monovalent non-aromatic condensed heteropolycyclic group, a biphenyl group, and a terphenyl group.

According to one embodiment, at least one selected from $X_{31}$ to $X_{33}$ in Formula 2 may be N.

According to one embodiment, the first hole transport host and the second hole transport host may be substantially identical to each other.

According to one embodiment, the first electron transport host and the second electron transport host may be substantially identical to each other.

In one or more embodiments, the first emission layer 131 and the second emission layer 132 may each independently include a compound represented by Formula 301.

<Formula 301> $[Ar_{301}]_{xb11}$-$[(L_{301})_{xb1}$-$R_{301}]_{xb21}$

In Formula 301,

$Ar_{301}$ may be a substituted or unsubstituted $C_5$-$C_{60}$ carbocyclic group or a substituted or unsubstituted $C_1$-$C_{60}$ heterocyclic group,

xb11 may be 1, 2, or 3,

$L_{301}$ may be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60.}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group,

xb1 may be an integer from 0 to 5,

$R_{301}$ may be selected from deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted C6-C60 aryl group, a substituted or unsubstituted $C_6$-$C_{60}$ aryloxy group, a substituted or unsubstituted C6-C60 arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -Si($Q_{301}$)($Q_{302}$)($Q_{303}$), -N($Q_{301}$)($Q_{302}$), -B($Q_{301}$)($Q_{302}$), -C(=O)($Q_{301}$), -S(=O)$_2$($Q_{301}$), and -P(=O)($Q_{301}$)($Q_{302}$),

xb21 may be an integer from 1 to 5, and

$Q_{301}$ to $Q_{303}$ may each independently be selected from a $C_1$-$C_{10}$ alkyl group, a $C_1$-$C_{10}$ alkoxy group, a phenyl group, a biphenyl group, a terphenyl group, and a naphthyl group, but the embodiments are not limited thereto.

For example, $Ar_{301}$ may be a substituted or unsubstituted $C_6$-$C_{32}$ carbocyclic group or a substituted or unsubstituted $C_1$-$C_{12}$ heterocyclic group, but embodiments are not limited thereto.

In one embodiment, $Ar_{301}$ in Formula 301 may be selected from:

a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and

a naphthalene group, a fluorene group, a spiro-bifluorene group, a benzofluorene group, a dibenzofluorene group,

a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, -Si($Q_{31}$)($Q_{32}$)($Q_{33}$), - N($Q_{31}$)($Q_{32}$), -B($Q_{31}$)($Q_{32}$), -C(=O)($Q_{31}$), -S(=O)$_2$($Q_{31}$), and -P(=O)($Q_{31}$)($Q_{32}$),

wherein $Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group, but the embodiments are not limited thereto.

When xb11 in Formula 301 is 2 or more, two or more $Ar_{301}$(s) may be linked to each other via a single bond.

In one or more embodiments, the compound represented by Formula 301 may be represented by Formula 301-1 or 301-2 below:

<Formula 301-1>

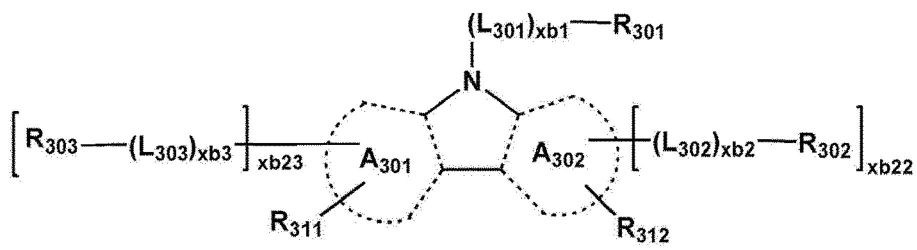

<Formula 301-2>

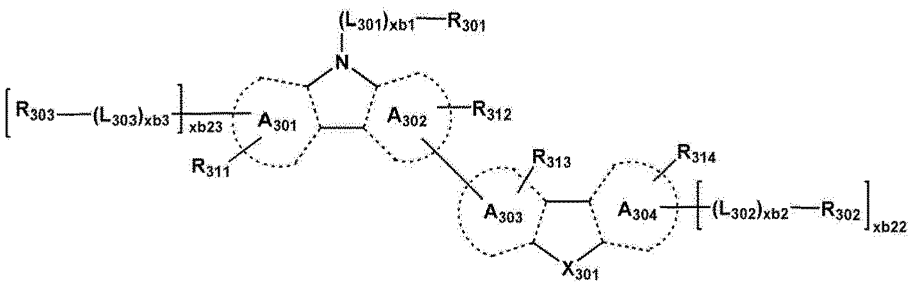

In Formulae 301-1 and 301-2,

$A_{301}$ to $A_{304}$ may each independently be selected from benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, and a dinaphthothiophene group;

$X_{301}$ may be O, S, or N-[(L304)xb4-R304],

$R_{311}$ to $R_{314}$ may each independently be selected from hydrogen, deuterium, -F, - Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, -Si($Q_{31}$)($Q_{32}$)($Q_{33}$), -N($Q_{31}$)($Q_{32}$), -B($Q_{31}$)($Q_{32}$), - C(=O)($Q_{31}$), -S(=O)$_2$($Q_{31}$), and -P(=O)($Q_{31}$)($Q_{32}$),

xb22 and xb23 may each independently be 0, 1, or 2,

$L_{301}$, xbl, $R_{301}$, and $Q_{31}$ to $Q_{33}$ may each be understood by referring to the corresponding descriptions presented herein,

$L_{302}$ to $L_{304}$ may each be understood by referring to the description presented in connection with $L_{301}$,

xb2 to xb4 may each be understood by referring to the description presented in connection with xb1, and

$R_{302}$ to $R_{304}$ may each be understood by referring to the description presented in connection with $R_{301}$.

For example, $L_{301}$ to $L_{304}$ in Formulae 301, 301-1, and 301-2 may each independently be selected from:

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and - $P(=O)(Q_{31})(Q_{32})$,

wherein $Q_{31}$ to $Q_{33}$ are the same as described above.

As another example, $R_{301}$ to $R_{304}$ in Formulae 301, 301-1, and 301-2 may each independently be selected from: deuterium, -F, -Cl, -Br, -I, a hydroxyl group, a cyano group, a nitro group, an amidino group, a hydrazino group, a hydrazono group, a substituted or unsubstituted $C_1$-$C_{60}$ (*e.g.* $C_1$-$C_{10}$) alkyl group, a substituted or unsubstituted $C_2$-$C_{60}$ (*e.g.* $C_2$-$C_{10}$) alkenyl group, a substituted or unsubstituted $C_2$-$C_{60}$ (*e.g.* $C_2$-$C_{10}$) alkynyl group, a substituted or unsubstituted $C_1$-$C_{60}$ (*e.g.* $C_1$-$C_{10}$) alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_1$-$C_{20}$ heteroaryl group, a substituted or unsubstituted monovalent non-aromatic condensed polycyclic group, a substituted or unsubstituted monovalent non-aromatic condensed heteropolycyclic group, $-Si(Q_{301})(Q_{302})(Q_{303})$, $-N(Q_{301})(Q_{302})$, - $B(Q_{301})(Q_{302})$, $-C(=O)(Q_{301})$, $-S(=O)_2(Q_{301})$, and $-P(=O)(Q_{301})(Q_{302})$, but embodiments are not limited thereto.

In one embodiment, $R_{301}$ to $R_{304}$ in Formulae 301, 301-1, and 301-2 may each independently be selected from:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, - F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, - $Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and $-P(=O)(Q_{31})(Q_{32})$, wherein $Q_{31}$ to $Q_{33}$ are the same as described above.

In one embodiment, the emission layer 130 may include an alkaline earth-metal complex as a host. For example, the host may include a complex selected from a Be complex (for example, Compound H55), a Mg complex, and a Zn complex. For example, the host may be selected from a Be complex (for example, Compound H55), a Mg complex, and a Zn complex.

According to one embodiment, the emission layer 130 may include, as a host, a compound represented by Formula 301-3.

<Formula 301-3>

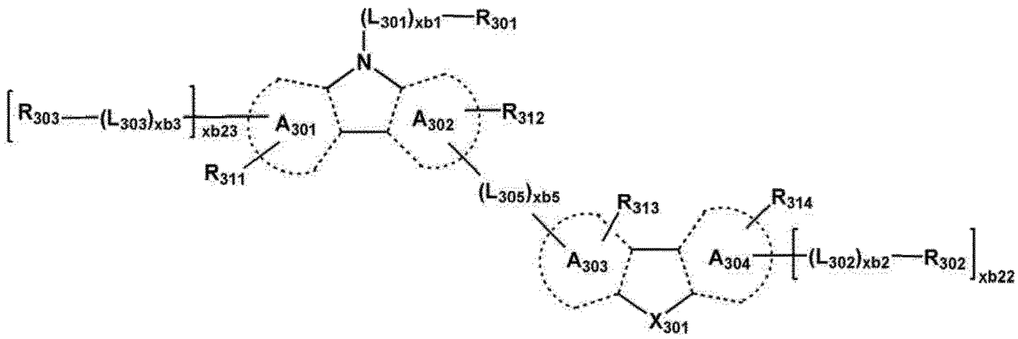

In Formula 301-3,

$A_{301}$ to $A_{304}$ may each independently be selected from a benzene ring, a naphthalene ring, a phenanthrene ring, a fluoranthene ring, a triphenylene ring, a pyrene ring, a chrysene ring, a pyridine ring, a pyrimidine ring, an indene ring, a fluorene ring, a spiro-bifluorene ring, a benzofluorene ring, a dibenzofluorene ring, an indole ring, a carbazole ring, a benzocarbazole ring, a dibenzocarbazole ring, a furan ring, a benzofuran ring, a dibenzofuran ring, a naphthofuran ring, a benzonaphthofuran ring, a dinaphthofuran ring, a thiophene ring, a benzothiophene ring, a dibenzothiophene ring, a naphthothiophene ring, a benzonaphthothiophene ring, and a dinaphthothiophene ring,

$X_{301}$ may be O, S, or N-[(L304)xb4-R304],

$R_{311}$ to $R_{314}$ may each independently be selected from hydrogen, deuterium, -F, - Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, $-Si(Q_{31})(Q_{32})(Q_{33})$, $-N(Q_{31})(Q_{32})$, $-B(Q_{31})(Q_{32})$, - $C(=O)(Q_{31})$, $-S(=O)_2(Q_{31})$, and $-P(=O)(Q_{31})(Q_{32})$,

xb22 and xb23 may each independently be 0, 1, or 2,

$L_{301}$ to $L_{305}$ may each independently be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ (*e.g.* $C_6$-$C_{30}$) arylene group, a substituted or unsubstituted $C_1$-$C_{60}$ (*e.g.* $C_1$-$C_{20}$) heteroarylene group, a substituted or unsubstituted divalent non-aromatic condensed polycyclic group, and a substituted or unsubstituted divalent non-aromatic condensed heteropolycyclic group,

xb1 to xb4 may each independently be an integer from 1 to 5,

xb5 may be an integer from 0 to 5,

$R_{301}$ to $R_{304}$ may each independently be selected from hydrogen, deuterium, -F, - Cl, -Br, -I, a hydroxyl group, a cyano group, a nitro group, an amidino group, a hydrazine group, a hydrazone group, a substituted or unsubstituted $C_1$-$C_{60}$ (*e.g.* $C_1$-$C_{20}$) alkyl group, a substituted or unsubstituted $C_2$-$C_{60}$ (*e.g.* $C_2$-$C_{20}$) alkenyl group, a substituted or unsubstituted $C_2$-$C_{60}$ (*e.g.* $C_2$-$C_{20}$) alkynyl group, a substituted or unsubstituted $C_1$-$C_{60}$ (*e.g.* $C_1$-$C_{20}$) alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-C30) aryl group, a substituted or unsubstituted $C_6$-$C_{60}$ (*e.g.* $C_6$-$C_{30}$) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-C20) heteroaryl group, a substituted or unsubstituted monovalent non-aromatic condensed polycyclic group, a substituted or unsubstituted monovalent non-aromatic condensed heteropolycyclic group, $-Si(Q_{301})(Q_{302})(Q_{303})$, $-N(Q_{301})(Q_{302})$, $-B(Q_{301})(Q_{302})$, $-C(=O)(Q_{301})$, - $S(=O)_2(Q_{301})$, and $-P(=O)(Q_{301})(Q_{302})$,

wherein $Q_{31}$ to $Q_{33}$ and $Q_{301}$ to $Q_{303}$ may each independently be selected from a $C_1$-$C_{10}$ alkyl group, a $C_1$-$C_{10}$ alkoxy group, a phenyl group, a biphenyl group, a terphenyl group, and a naphthyl group.

For example, the first emission layer 131 and the second emission layer 132 may each independently include 9,10-di(2-naphthyl)anthracene (ADN), 2-methyl-9,10-bis(naphthalen-2-yl)anthracene (MADN), 9,10-di(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and compounds H1 to H55, as the hole transport host or the electron transport host:

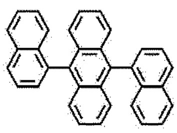
H1

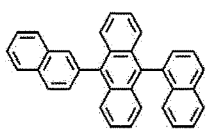
H2

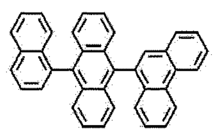
H3

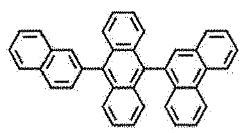
H4

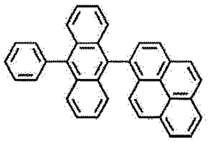

H5

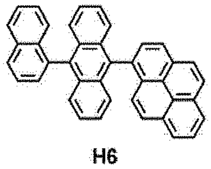

H6

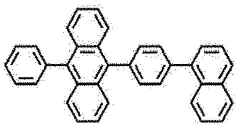

H7

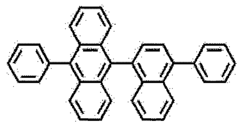

H8

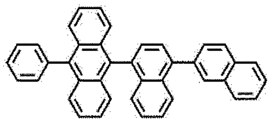

H9

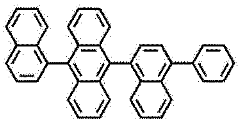

H10

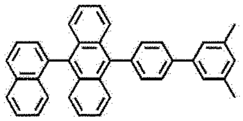

H11

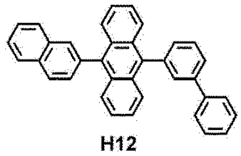

H12

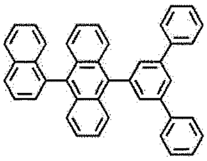

H13

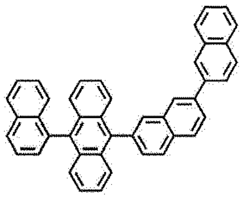

H14

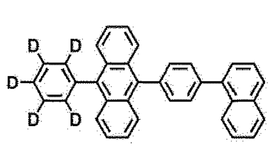

H15

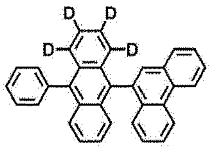

H16

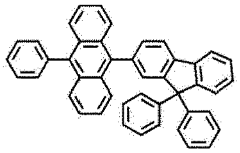

H17

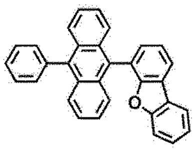

H18

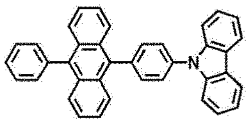

H19

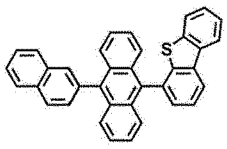

H20

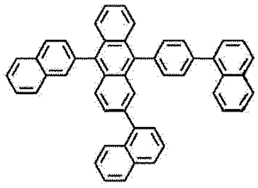

H21

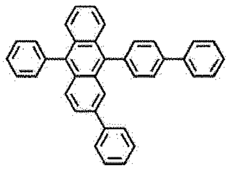

H22

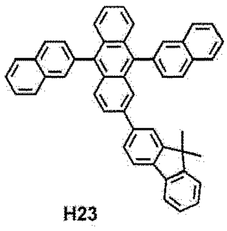

H23

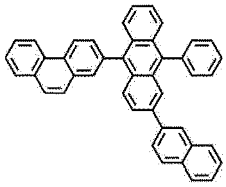

H24

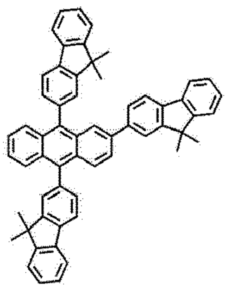

H25

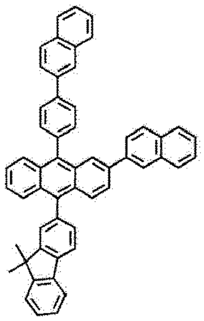

H26

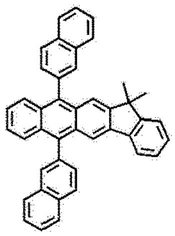

H27

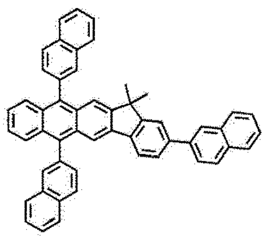

H28

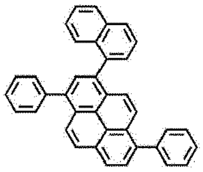
H29

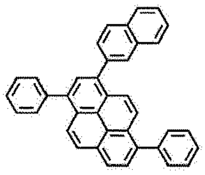
H30

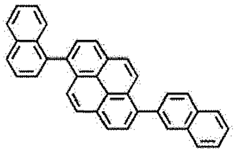
H31

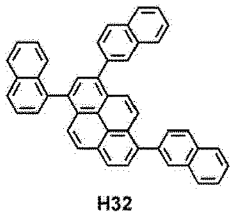
H32

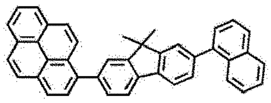
H33

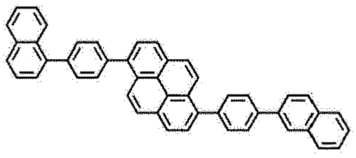
H34

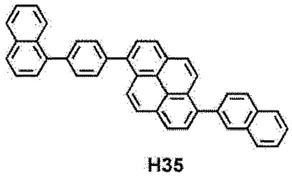
H35

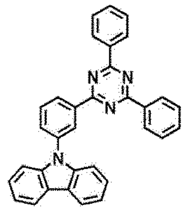
H36

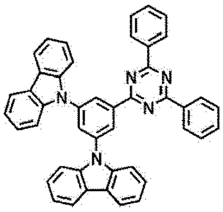
H37

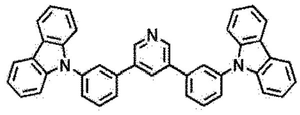
H38

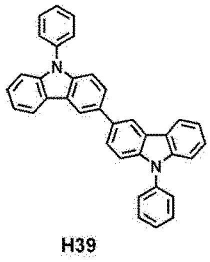
H39

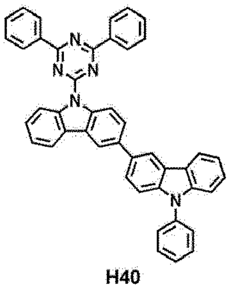
H40

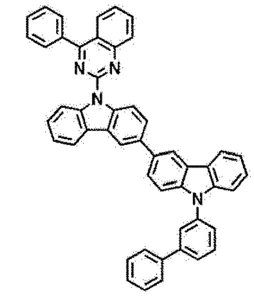
H41

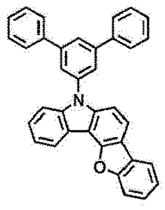
H42

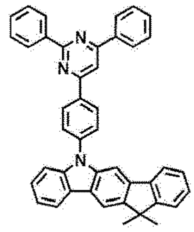
H43

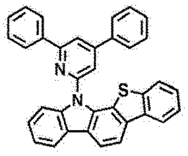
H44

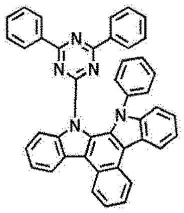
H45

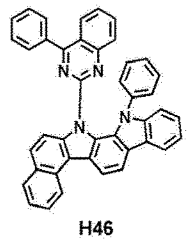
H46

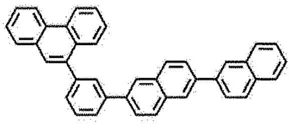
H47

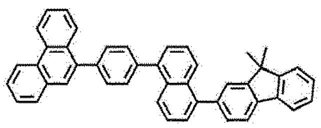
H48

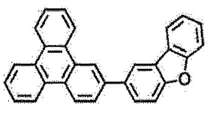
H49

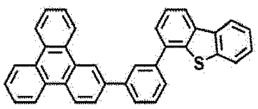
H50

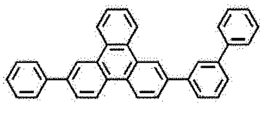 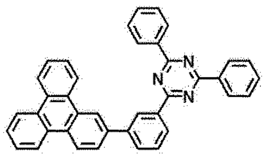 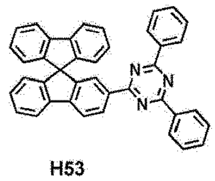 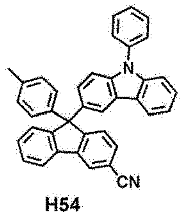

H51 H52 H53 H54

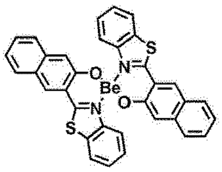

H55

.

First phosphorescent dopant and second phosphorescent dopant

According to one embodiment, the first phosphorescent dopant and the second phosphorescent dopant may each be an organometallic compound represented by Formula 401:

<Formula 401> $M(L_{401})_{xc1}(L_{402})_{xc2}$

<Formula 402>

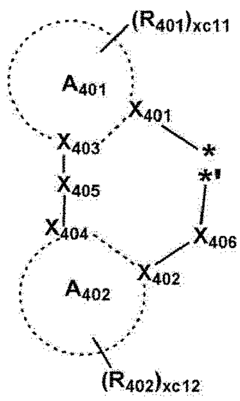

In Formulae 401 and 402,

M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),

$L_{401}$ may be selected from ligands represented by Formula 402, and xc1 may be 1, 2, or 3, wherein, when xc1 is 2 or more, two or more $L_{401}$(s) may be identical to or different from each other,

$L_{402}$ may be an organic ligand, and xc2 may be an integer from 0 to 4, wherein, when xc2 is 2 or more, two or more $L_{402}$(s) may be identical to or different from each other,

$X_{401}$ to $X_{404}$ may each independently be nitrogen or carbon,

$X_{401}$ and $X_{403}$ may be linked to each other via a single bond or a double bond, and $X_{402}$ and $X_{404}$ may be linked to each other via a single bond or a double bond,

$A_{401}$ and $A_{402}$ may each independently be selected from a $C_5$-$C_{60}$ (*e.g.* $C_5$-$C_{30}$) carbocyclic group or a $C_1$-$C_{60}$ (*e.g.* $C_1$-$C_{20}$) heterocyclic group,

$X_{405}$ may be a single bond, *-O-*', *-S-*', *-C(=O)-*', *-N($Q_{411}$)-*', *-C($Q_{411}$)($Q_{412}$)-*', *-C($Q_{411}$)=C($Q_{412}$)-*', *-C($Q_{411}$)=*', or *=C=*', wherein $Q_{411}$ and $Q_{412}$ may be hydrogen, deuterium, a $C_1$-$C_{20}$ alkyl group, a $C_1$-$C_{20}$ alkoxy group, a phenyl group, a biphenyl group, a terphenyl group, or a naphthyl group,

$X_{406}$ may be a single bond, O, or S,

$R_{401}$ and $R_{402}$ may each independently be selected from hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{20}$

alkyl group, a substituted or unsubstituted $C_1$-$C_{20}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* $C_6$-C30) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted monovalent non-aromatic condensed polycyclic group, a substituted or unsubstituted monovalent non-aromatic condensed heteropolycyclic group, -Si($Q_{401}$)($Q_{402}$)($Q_{403}$), -N($Q_{401}$)($Q_{402}$), - B($Q_{401}$)($Q_{402}$), -C(=O)($Q_{401}$), -S(=O)$_2$($Q_{401}$), and -P(=O)($Q_{401}$)($Q_{402}$), and $Q_{401}$ to $Q_{403}$ may each independently be selected from a $C_1$-$C_{10}$ alkyl group, a $C_1$-$C_{10}$ alkoxy group, a $C_6$-$C_{20}$ aryl group, and a $C_1$-$C_{20}$ heteroaryl group,

xc11 and xc12 may each independently be an integer from 0 to 10, and

* and *' in Formula 402 each indicate a binding site to M in Formula 401.

In one embodiment, $A_{401}$ and $A_{402}$ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) $X_{401}$ may be nitrogen, and $X_{402}$ may be carbon, or ii) $X_{401}$ and $X_{402}$ may each be nitrogen at the same time.

In one or more embodiments, $R_{401}$ and $R_{402}$ in Formula 402 may each independently be selected from:

hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, and a $C_1$-C20 alkoxy group;

a $C_1$-$C_{20}$ alkyl group, and a $C_1$-$C_{20}$ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;

a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;

a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and

-Si($Q_{401}$)($Q_{402}$)($Q_{403}$), -N($Q_{401}$)($Q_{402}$), -B($Q_{401}$)($Q_{402}$), -C(=O)($Q_{401}$), - S(=O)$_2$($Q_{401}$), and -P(=O)($Q_{401}$)($Q_{402}$), wherein $Q_{401}$ to $Q_{403}$ may each independently be selected from a $C_1$-$C_{10}$ alkyl group, a $C_1$-$C_{10}$ alkoxy group, a phenyl group, a biphenyl group, and a naphthyl group, but the embodiments are not limited thereto.

In one or more embodiments, when xc1 in Formula 401 is 2 or more, two $A_{401}$(s) in two or more $L_{401}$(s) may optionally be linked to each other via $X_{407}$, which is a linking group, or two $A_{402}$(s) in two or more $L_{401}$(s) may optionally be linked to each other via $X_{408}$, which is a linking group (see Compounds PD1 to PD4 and PD7). $X_{407}$ and $X_{408}$ may each independently be a single bond, *-O-*', *-S-*', *-C(=O)-*', *-N($Q_{413}$)-*', *-C($Q_{413}$)($Q_{414}$)-*', or *-C($Q_{413}$)=C($Q_{414}$)-*' (wherein $Q_{413}$ and $Q_{414}$ may each independently be hydrogen, deuterium, a $C_1$-$C_{20}$ alkyl group, a $C_1$-$C_{20}$ alkoxy group, a phenyl group, a biphenyl group, a terphenyl group, or a naphthyl group), but the embodiments are not limited thereto.

$L_{402}$ in Formula 401 may be a monovalent, divalent, or trivalent organic ligand. For example, $L_{402}$ may be selected from halogen, diketone (for example, acetylacetonate), carboxylic acid (for example, picolinate), -C(=O), isonitrile, -CN, and phosphorus (for example, phosphine or phosphite), but the embodiments are not limited thereto.

In one or more embodiments, the first and second phosphorescent dopants may be selected from, for example, Compounds PD1 to PD26, but the embodiments are not limited thereto:

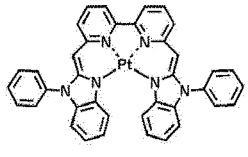
PD1

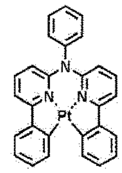
PD2

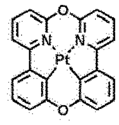
PD3

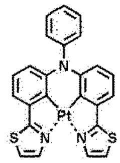
PD4

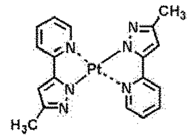
PD5

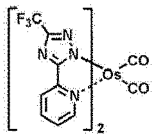
PD6

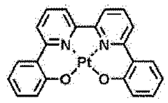
PD7

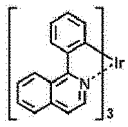
PD8

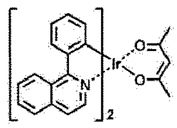
PD9

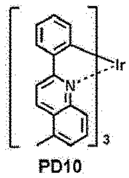
PD10

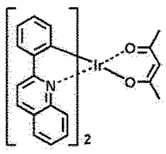
PD11

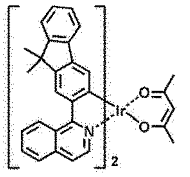
PD12

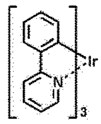
PD13

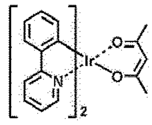
PD14

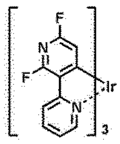
PD15

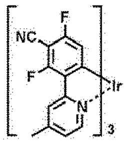
PD16

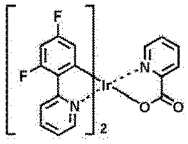
PD17

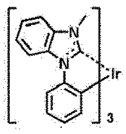
PD18

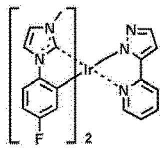
PD19

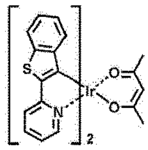
PD20

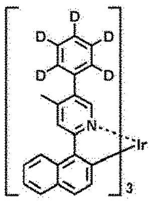
PD21

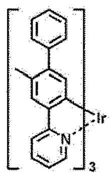
PD22

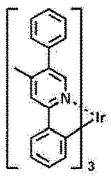
PD23

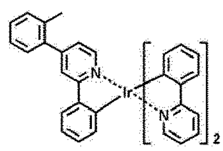
PD24

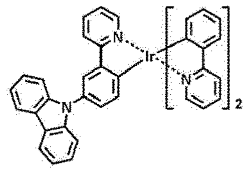
PD25

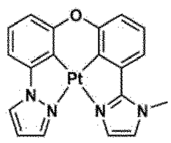
PD26 .

According to one embodiment, the first phosphorescent dopant and the second phosphorescent dopant may each be an organometallic compound represented by Formula 4 or 5:

<Formula 4>

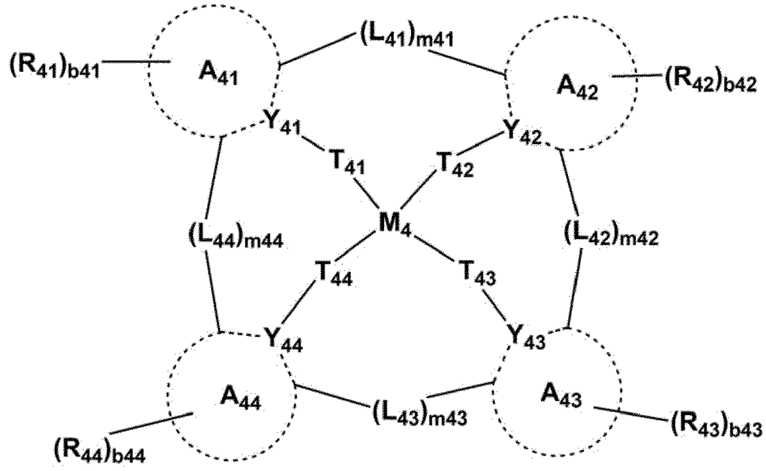

<Formula 5>

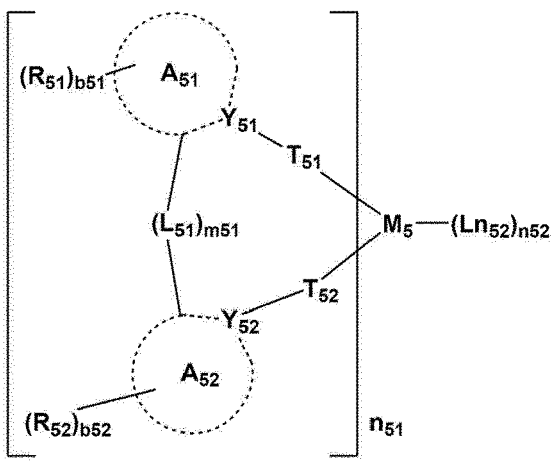

In Formulae 4 and 5,

$M_4$ and $M_5$ are each independently selected from platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), and thulium (Tm),

n51 is an integer from 1 to 3,

$Ln_{52}$ is an organic ligand, n52 is an integer from 0 to 2,

$Y_{41}$ to $Y_{44}$, $Y_{51}$ and $Y_{52}$ are each independently N or C;

$A_{41}$ to $A_{44}$, $A_{51}$ and $A_{52}$ are each independently selected from a $C_5$-$C_{60}$ (*e.g.* $C_5$-C30) carbocyclic group, and a $C_1$-$C_{60}$ (*e.g.* $C_1$-$C_{20}$) heterocyclic group,

at least one of $A_{41}$ to $A_{44}$ is a carbene ring, and at least one of $A_{51}$ and $A_{52}$ is a carbene ring,

$T_{41}$ to $T_{44}$, $T_{51}$, and $T_{52}$ are each independently a single bond, *-O-*', and *-S-*';

$L_{41}$ to $L_{44}$ and $L_{51}$ are each independently selected from a single bond, *-O-*', *-S-*', *-C($R_{45}$)($R_{46}$)-*', *-C($R_{45}$)=*', *=C($R_{45}$)-*', *-C($R_{45}$)=C($R_{46}$)-*', *-C(=O)-*', *-C(=S)-*', *-C≡C-*', *-B($R_{45}$)-*', *-N($R_{45}$)-*', *-P($R_{45}$)-*', *-Si($R_{45}$)($R_{46}$)-*', *-P(=O)($R_{45}$)-*', and *-Ge($R_{45}$)($R_{46}$)-*';

m41 to m44 and m51 are each independently an integer from 0 to 3,

$R_{41}$ to $R_{46}$, $R_{51}$, and $R_{52}$ are each independently selected from hydrogen, deuterium, -F, -Cl, -Br, -I, a hydroxyl group, a cyano group, a nitro group, an amidino group, a hydrazine group, a hydrazone group, a substituted or unsubstituted $C_1$-$C_{60}$ (*e.g.* $C_1$-$C_{20}$) alkyl group, a substituted or unsubstituted $C_2$-$C_{60}$ (*e.g.* $C_2$-$C_{20}$) alkenyl group, a substituted or unsubstituted $C_2$-$C_{60}$ (*e.g.* $C_2$-$C_{20}$) alkynyl group, a substituted or unsubstituted $C_1$-$C_{60}$ (*e.g.* $C_1$-C20) alkoxy group, a substituted or unsubstituted $C_3$-$C_{10}$ cycloalkyl group, a substituted or unsubstituted $C_1$-$C_{10}$ heterocycloalkyl group, a

substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* $C_6$-$C_{30}$) aryloxy group, a substituted or unsubstituted $C_6$-$C_{60}$ (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted monovalent non-aromatic condensed polycyclic group, a substituted or unsubstituted monovalent non-aromatic condensed heteropolycyclic group, -Si($Q_{41}$)($Q_{42}$)($Q_{43}$), -N($Q_{41}$)($Q_{42}$), -B($Q_{41}$)($Q_{42}$), - C(=O)($Q_{41}$), -S(=O)$_2$($Q_{41}$), and -P(=O)($Q_{41}$)($Q_{42}$),

regarding a pair of $R_{45}$ and $R_{41}$, a pair of $R_{45}$ and $R_{42}$, a pair of $R_{45}$ and $R_{43}$, or a pair of $R_{45}$ and $R_{44}$, components of each pair are optionally linked to form a substituted or unsubstituted $C_5$-$C_{60}$ (*e.g.* $C_5$-$C_{30}$) carbocyclic group or a substituted or unsubstituted $C_1$-$C_{60}$ (*e.g.* $C_1$-$C_{20}$) heterocyclic group,

b41 to b44, b51 and b52 are each independently an integer from 1 to 8,

* and *' each indicate a binding site to a neighboring atom,

at least one substituent of the substituted $C_5$-$C_{60}$ (*e.g.* $C_5$-$C_{30}$) carbocyclic group, the substituted $C_1$-$C_{60}$ (*e.g.* $C_1$-$C_{20}$) heterocyclic group, the substituted $C_1$-$C_{60}$ (*e.g.* $C_1$-$C_{20}$) alkyl group, the substituted $C_2$-$C_{60}$ (*e.g.* $C_2$-$C_{20}$) alkenyl group, the substituted $C_2$-$C_{60}$ (*e.g.* $C_2$-$C_{20}$) alkynyl group, the substituted $C_1$-$C_{60}$ (*e.g.* $C_1$-$C_{20}$) alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ (*e.g.* $C_6$-$C_{30}$) aryl group, the substituted $C_6$-$C_{60}$ (*e.g.* $C_6$-$C_{30}$) aryloxy group, the substituted $C_6$-$C_{60}$ (*e.g.* $C_6$-$C_{30}$) arylthio group, the substituted $C_1$-$C_{60}$ (*e.g.* $C_1$-$C_{20}$) heteroaryl group, the substituted monovalent non-aromatic condensed polycyclic group, and the substituted monovalent non-aromatic condensed heteropolycyclic group is selected from:

deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, and a $C_1$-$C_{60}$ (*e.g.* $C_1$-$C_{20}$) alkoxy group;

a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, and a $C_1$-$C_{60}$ (*e.g.* $C_1$-$C_{20}$) alkoxy group, each substituted with at least one selected from deuterium, -F, -Cl, -Br, -I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a monovalent non-aromatic condensed polycyclic group, a monovalent non-aromatic condensed heteropolycyclic group, - Si($Q_{51}$)($Q_{52}$)($Q_{53}$), -N($Q_{51}$)($Q_{52}$), -B($Q_{51}$)($Q_{52}$), -C(=O)($Q_{51}$), -S(=O)$_2$($Q_{51}$), and -P(=O)($Q_{51}$)($Q_{52}$);

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-C60 (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a monovalent non-aromatic condensed polycyclic group, a monovalent non-aromatic condensed heteropolycyclic group, -Si($Q_{61}$)($Q_{62}$)($Q_{63}$), -N($Q_{61}$)($Q_{62}$), -B($Q_{61}$)($Q_{62}$), -C(=O)($Q_{61}$), -S(=O)$_2$($Q_{61}$), and - P(=O)($Q_{61}$)($Q_{62}$); and

-Si($Q_{71}$)($Q_{72}$)($Q_{73}$), -N($Q_{71}$)($Q_{72}$), -B($Q_{71}$)($Q_{72}$), -C(=O)($Q_{71}$), -S(=O)$_2$($Q_{71}$), and - P(=O)($Q_{71}$)($Q_{72}$),

wherein $Q_{41}$ to $Q_{43}$, $Q_{51}$ to $Q_{53}$, $Q_{61}$ to $Q_{63}$, and $Q_{71}$ to $Q_{73}$ are each independently selected from hydrogen, deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, monovalent non-aromatic condensed polycyclic group, monovalent non-aromatic condensed heteropolycyclic group; a $C_1$-$C_{60}$ (*e.g.* $C_1$-$C_{20}$) alkyl group substituted with at least one selected from deuterium, -F, and a cyano group; a $C_6$-$C_{60}$ (*e.g.* $C_6$-$C_{30}$) aryl group substituted with at least one selected from deuterium, -F, and a cyano group; a biphenyl group, and a terphenyl group.

For example, $Ln_{52}$ may be a monovalent, divalent, or trivalent organic ligand. For example, Lns2 may be selected from halogen, diketone (for example, acetylacetonate), carboxylic acid (for example, picolinate), -C(=O), isonitrile, -CN, and phosphorus (for example, phosphine or phosphite), but embodiments of the present disclosure are not limited thereto.

At least one of $A_{41}$ to $A_{44}$ and at least one of $A_{51}$ and $A_{52}$ in Formulae 4 and 5 is a carbene ring.

For example, at least one of $A_{41}$ to $A_{44}$ and at least one of $A_{51}$ and $A_{52}$ may be a group represented by one of Formulae 6-1 to 6-16:

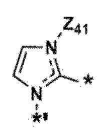
6-1
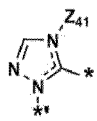
6-2
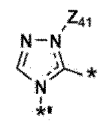
6-3
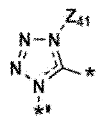
6-4
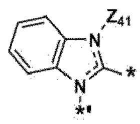
6-5

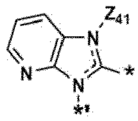
6-6
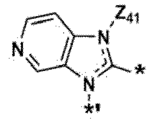
6-7
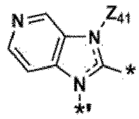
6-8
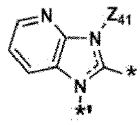
6-9

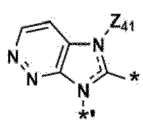
6-10
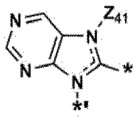
6-11
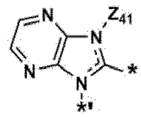
6-12
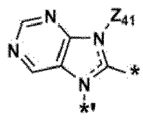
6-13

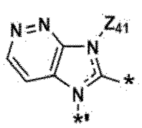
6-14
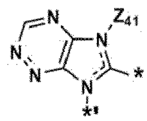
6-15
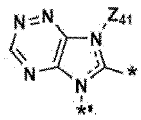
6-16

In Formulae 6-1 to 6-16,

$Z_{41}$ is selected from hydrogen, deuterium, -F, -Cl, -Br, -I, a hydroxyl group, a cyano group, a nitro group, an amidino group, a hydrazino group, a hydrazono group, a $C_1$-$C_{20}$ (*e.g.* $C_1$-$C_{10}$) alkyl group, a $C_2$-$C_{20}$ (*e.g.* $C_2$-$C_{10}$) alkenyl group, a $C_2$-$C_{20}$ (*e.g.* $C_2$-$C_{10}$) alkynyl group, a $C_1$-$C_{20}$ (*e.g.* $C_1$-$C_{10}$) alkoxy group, a phenyl group, a biphenyl group, a terphenyl group, a naphthyl group, a fluorenyl group, a spiro-bifluorenyl group, a phenanthrenyl group, an anthracenyl group, a triphenylenyl group, a pyridinyl group, a pyrimidinyl group, a carbazolyl group, and a triazinyl group,

* and *' each indicate a binding site to a neighboring atom.

According to one embodiment, one of $A_{41}$ to $A_{44}$ and one of $A_{51}$ and $A_{52}$ in Formulae 4 and 5 may be a carbene ring.

According to one embodiment, the first phosphorescent dopant and the second phosphorescent dopant may be substantially identical to each other.

According to one embodiment, at least one of the first emission layer 131 and the second emission layer 132 may further include at least one selected from a fluorescence dopant and a delayed fluorescence dopant.

According to one embodiment, the fluorescent dopant may further include a compound represented by Formula 501:

<Formula 501>

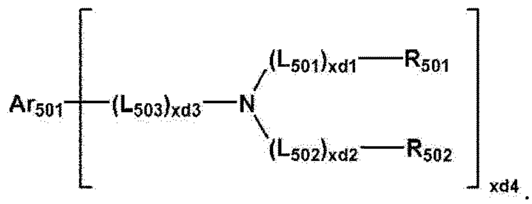

In Formula 501,
$Ar_{501}$ may be a substituted or unsubstituted $C_5$-$C_{60}$ carbocyclic group or a substituted or unsubstituted $C_1$-$C_{60}$ heterocyclic group,
$L_{501}$ to $L_{503}$ may each independently be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted C6-C60 *(e.g.* C6-C30) arylene group, a substituted or unsubstituted $C_1$-$C_{60}$ (*e.g.* $C_1$-$C_{20}$) heteroarylene group, a substituted or unsubstituted divalent non-aromatic condensed polycyclic group, and a substituted or unsubstituted divalent non-aromatic condensed heteropolycyclic group,
xd1 to xd3 may each independently be an integer from 0 to 3,
$R_{501}$ and $R_{502}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ (*e.g.* $C_6$-$C_{30}$) aryl group, a substituted or unsubstituted $C_6$-$C_{60}$ (*e.g.* $C_6$-$C_{30}$) aryloxy group, a substituted or unsubstituted C6-C60 (*e.g.* $C_6$-$C_{30}$) arylthio group, a substituted or unsubstituted $C_1$-$C_{60}$ (*e.g.* $C_1$-$C_{20}$) heteroaryl group, a substituted or unsubstituted monovalent non-aromatic condensed polycyclic group, and a substituted or unsubstituted monovalent non-aromatic condensed heteropolycyclic group, and
xd4 may be an integer from 1 to 6.
For example, $Ar_{501}$ may be a substituted or unsubstituted $C_5$-$C_{30}$ carbocyclic group or a substituted or unsubstituted $C_1$-$C_{20}$ heterocyclic group, but embodiments are not limited thereto.
In one embodiment, $Ar_{501}$ in Formula 501 may be selected from:

a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, and a naphthyl group.

In one or more embodiments, $L_{501}$ to $L_{503}$ in Formula 501 may each independently be selected from:

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, $R_{501}$ and $R_{502}$ in Formula 501 may each independently be selected from:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - $Si(Q_{31})(Q_{32})(Q_{33})$,

wherein $Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

In one or more embodiments, xd4 in Formula 501 may be 2, but the embodiments are not limited thereto.

For example, the fluorescent dopant may be selected from Compounds FD1 to FD23 below:

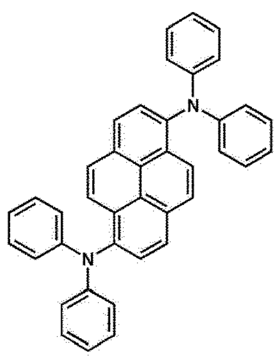

FD1

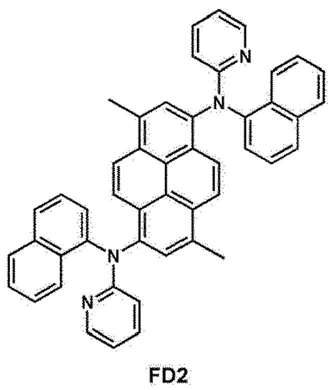

FD2

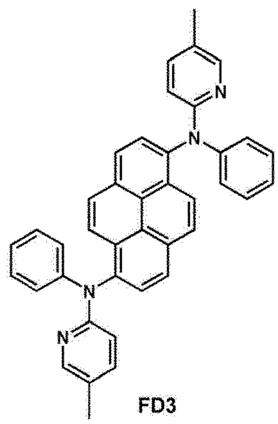

FD3

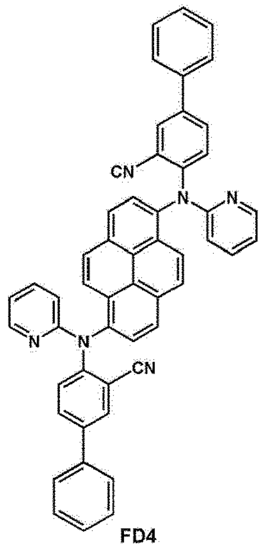

FD4

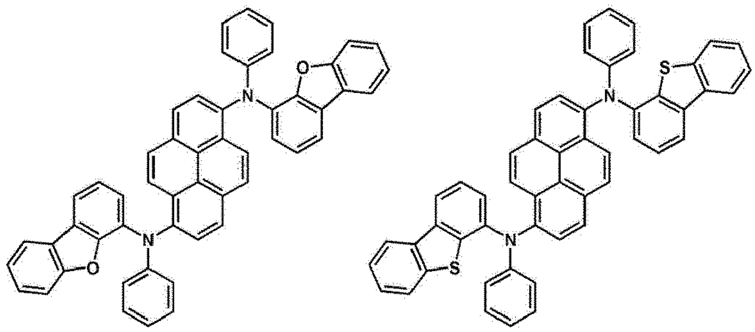

FD5

FD6

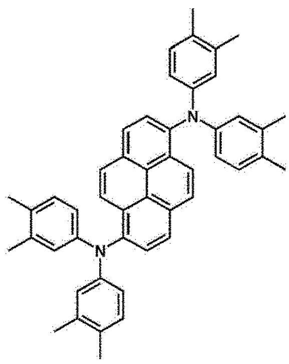

FD7

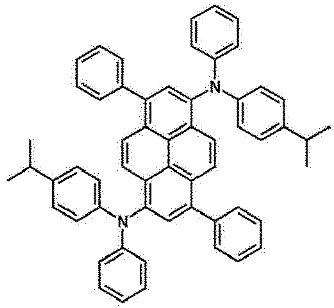

FD8

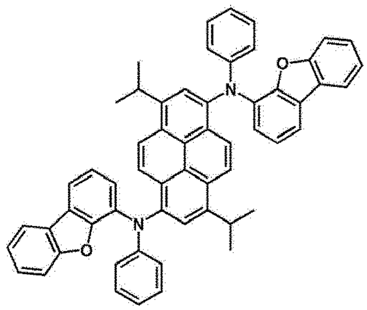

FD9

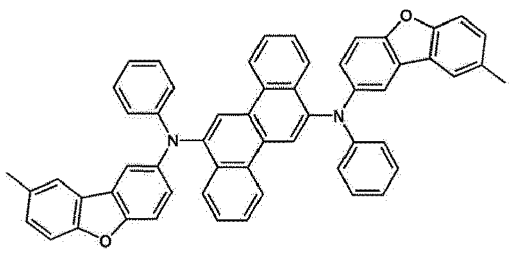

FD10

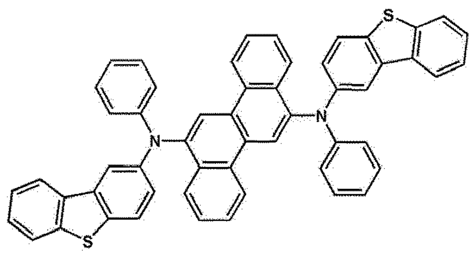

FD11

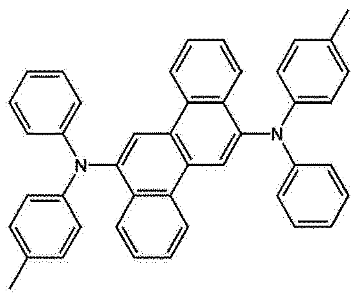

FD12

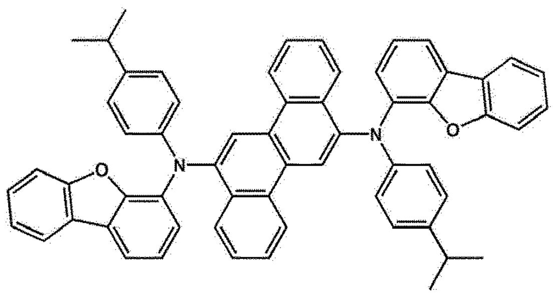

FD13

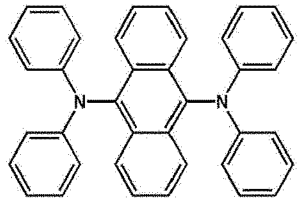

FD14

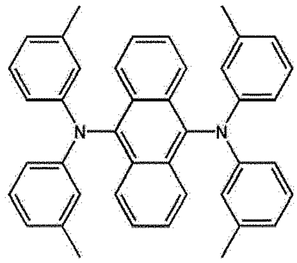

FD15

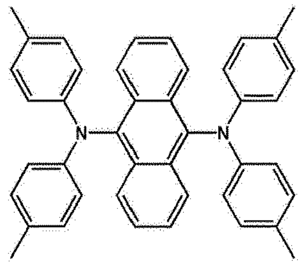

FD16

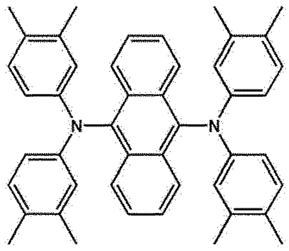

FD17

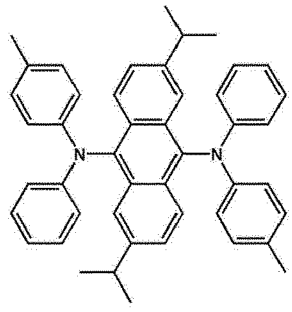

FD18

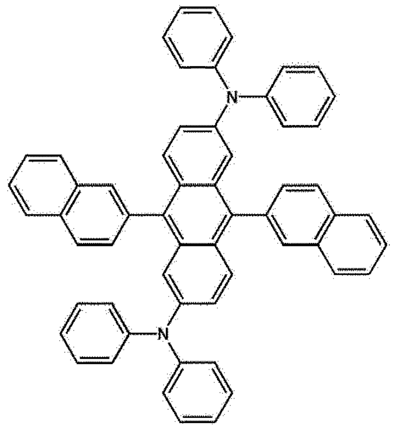

FD19

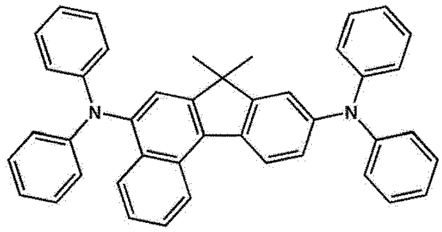

FD20

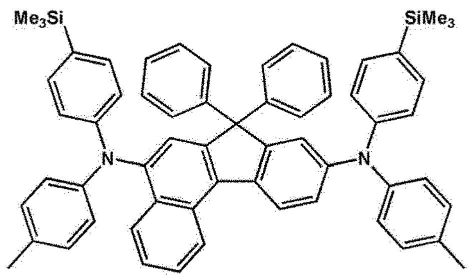

FD21

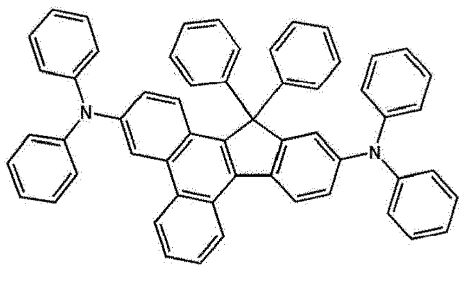

FD22

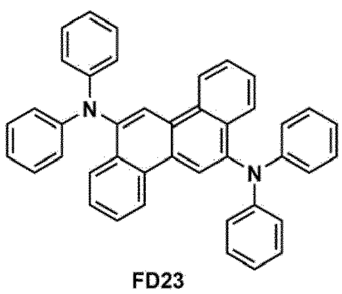

FD23

.

In one or more embodiments, the fluorescent dopant may be selected from the following compounds, but the embodiments are not limited thereto.

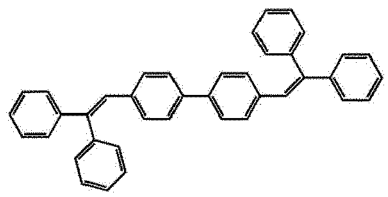

DPVBi

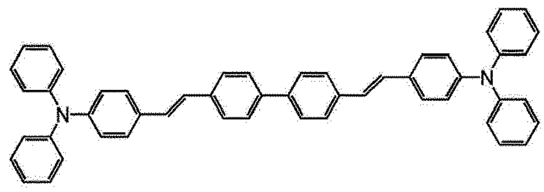

DPAVBi

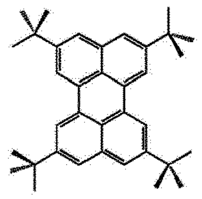

TBPe

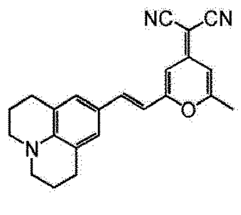

DCM

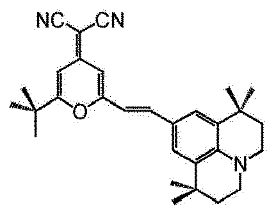

DCJTB

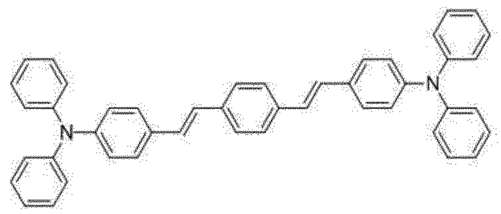

DSA-Ph

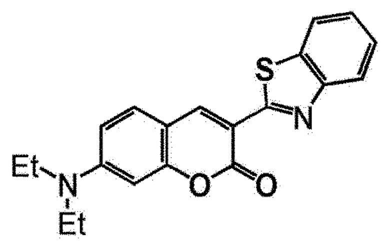

Coumarin 6

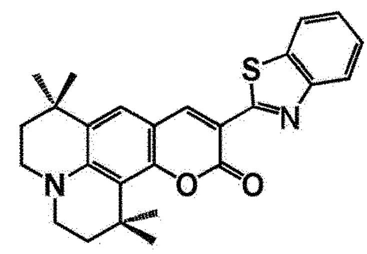

C545T

According to an embodiment, the delayed fluorescence dopant may satisfy Equation 3:

<Equation 3>

$$\left| S1(D) - T1(D) \right| \leq 0.5 \text{ eV}$$

wherein, in Equation 3,

T1(D) is the lowest triplet excitation energy level of the dopant, and
S 1(D) is the lowest singlet excitation energy level of the dopant.

The delayed fluorescence dopant satisfying Equation 3 above may emit thermally activated delayed fluorescence even at room temperature. For example, the delayed fluorescence dopant may satisfy the condition of $|S1(D) - T1(D)| \leq 0.2$ eV, but the embodiments are not limited thereto.

In addition, the delayed fluorescence dopant may not include metal atoms. That is, the delayed fluorescence dopant may be clearly distinguished from phosphorescent dopants containing metal atoms. In one or more embodiments, the delayed fluorescence dopant is distinguished from the phosphorescent dopant in that the delayed fluorescence dopant does not include iridium (Ir), platinum (Pt), palladium (Pd), osmium (Os), titanium (Ti), zirconium (Zr), hafnium

(Hf), europium (Eu), terbium (Tb), rhodium (Rh), and thulium (Tm).

For example, the delayed fluorescence dopant may have a D-A structure including an electron donor group (D) and an electron acceptor group (A). In detail, the delayed fluorescence dopant may be selected from compounds disclosed in Japanese Patent Application Publication No. 2011-140046, Japanese Patent Application Publication No. 2013-034967, Japanese Patent Application Publication No. 2015-530745, Japanese Patent Application Publication No. 2013-034967, Japanese Patent Application Publication No. 2014-512416, Japanese Patent Application Publication No. 2015-525248, Japanese Patent Application Publication No. 2013-524707, Japanese Patent Application Publication No. 2013-547225, Japanese Patent Application Publication No. 2012-274324, Japanese Patent Application Publication No. 2015-504322, the U.S. Patent Application Publication No. 2012-0217869, WO 2015-118035, WO 2016-091887, WO 2016-096851, Korean Patent Application Publication No. 2017-7005332, Japanese Patent Application Publication No. 2014-518737, the U.S. Patent Application Publication No. 2016-0197286, the U.S. Patent Application Publication No. 2014-0138627, the U.S. Patent Application Publication No. 2014-0145149, the U.S. Patent Application Publication No. 2014-0158992, the U.S. Patent Application Publication No. 2014-0145151, the U.S. Patent Application Publication No. 2015-0021555, the U.S. Patent Application Publication No. 2014-0332758, Korean Patent Application Publication No. 2014-0154391, Japanese Patent Application Publication No. 2015-148588, Japanese Patent Application Publication No. 2016-506442, Japanese Patent Application Publication No. 2015-531748, Japanese Patent Application Publication No. 2016-538300, Japanese Patent Application Publication No. 2016-538393, Japanese Patent Application Publication No. 2015-095814, Japanese Patent Application Publication No. 2012-538639, Japanese Patent Application Publication No. 2014-525803, Japanese Patent Application Publication No. 2012-546858, Japanese Patent Application Publication No. 2016-538300, and Japanese Patent Application Publication No. 2014-538540, but the embodiments are not limited thereto.

In one or more embodiments, the delayed fluorescence dopant may have a structure of D-A-D or A-D-A. In one embodiment, the delayed fluorescence dopant may be selected from the compounds disclosed in WO 2015-158692, Japanese Patent Application Publication No. 2016-538435, Japanese Patent Application Publication No. 2016-538426, Japanese Patent Application Publication No. 2015-500308, and Japanese Patent Application Publication No. 2015-527231, but the embodiments are not limited thereto.

In one embodiment, the delayed fluorescence dopant may be a transition metal complex. In one embodiment, the delayed fluorescence dopant may be may be a Cu complex or a Pt complex, or a compound selected from compounds disclosed in Korean Patent Application Publication No. 2012-7017497, Korean Patent Application Publication No. 2013-7001396, Korean Patent Application Publication No. 2014-0068027, Korean Patent Application Publication No. 2014-7003327, and the U.S. Patent Application Publication No. 2011-0304262, etc., but the embodiments are not limited thereto.

In one embodiment, the delayed fluorescence dopant may be a compound having a B-N structure, or a compound disclosed in the U.S. Patent Application Publication No. 2014-0027734, etc., or DABNA, but the embodiments are not limited thereto.

<DABNA>

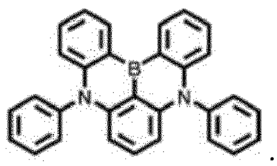

In one embodiment, the delayed fluorescence dopant may be selected from compounds disclosed in Japanese Patent Application Publication No. 2015-508569 and Japanese Patent Application Publication No. 2014-554306, but the embodiments are not limited thereto.

The electron donor group (D) may be, for example, a carbazole group, a dibenzofuran group, a dibenzothiophene group, an indolocarbazole group, a bis-carbazole group, or the like.

The electron acceptor group (A) may be an aryl group substituted with CN and/or F, a π-electron deficient nitrogen-containing cyclic group, or the like.

According to one embodiment, the first emission layer 131 and the second emission layer 132 may be in direct contact with each other. For example, other structures may not be located between the first emission layer 131 and the second emission layer 132.

Embodiment of FIG. 2

FIG. 2 is a schematic cross-sectional diagram of another embodiment of an organic light-emitting device constructed according to principles of the invention.

Referring to FIG. 2, in the organic light-emitting device 10, the organic layer 150 may further include a third emission layer 133 between the first emission layer 131 and the second emission layer 132.

According to one embodiment, the third emission layer 133 may include a third hole transport host, a third electron transport host, and a third phosphorescent dopant.

The third emission layer 133 may be understood by referring to the description of the first emission layer 131 and the second emission layer 132, as described herein.

According to one embodiment, the amount of the first hole transport host of the first emission layer 131 may be greater than the amount of the third hole transport host of the third emission layer 133, and the amount of the third hole transport host of the third emission layer 133 may be greater than the amount of the second hole transport host of the second emission layer 132.

For example, the amount of hole transport host may be the greatest in the first emission layer 131, the lowest in the second emission layer 132. In addition, for example, the amount of the hole transport host may be gradually reduced in the direction from the first emission layer 131 to the second emission layer 132.

According to one embodiment, the amount of the second electron transport host of the second emission layer 132 may be greater than the amount of the third electron transport host of the third emission layer 133, and the amount of the third electron transport host of the third emission layer 133 may be greater than the amount of the first electron transport host of the first emission layer 131.

For example, the amount of electron transport host may be the greatest in the second emission layer 132, the lowest in the first emission layer 131. In addition, for example, the amount of the electron transport host may be gradually reduced in the direction from the second emission layer 132 to the first emission layer 131.

Due to such a structure in the organic light-emitting device 10, because the balance of holes and electrons in the emission layer 130 is controlled, the hole-electron recombination region is maintained inside the emission layer 130, leading to the prevention of exciton-polaron quenching, and since the concentration of excitons in the emission layer 130 is appropriately controlled, exciton-exciton quenching may be prevented. As a result, the lifespan characteristics of the organic light-emitting device 10 may be significantly improved.

According to one embodiment, the weight ratio of the third hole transport host and the third electron transport host of the third emission layer 133 may be in the range of about 4: 6 to about 6: 4.

According to one embodiment, at least one of the first hole transport host and the second hole transport host may be the same as the third hole transport host. For example, the first hole transport host may be the same as the third hole transport host. For example, the second hole transport host may be the same as the third hole transport host.

According to one embodiment, the first hole transport host, the second hole transport host, and the third hole transport host may be substantially the same or identical.

According to one embodiment, at least one of the first electron transport host and the second electron transport host may be the same as the third electron transport host. For example, the first electron transport host may be the same as the third electron transport host. For example, the second electron transport host may be the same as the third electron transport host.

According to one embodiment, the first electron transport host, the second electron transport host, and the third electron transport host may be substantially the same or identical.

According to one embodiment, at least one of the first phosphorescent dopant and the second phosphorescent dopant may be the same as the third phosphorescent dopant. For example, the first phosphorescent dopant may be the same as the third phosphorescent dopant. For example, the second phosphorescent dopant may be the same as the third phosphorescent dopant.

According to one embodiment, the first phosphorescent dopant, the second phosphorescent dopant, and the third phosphorescent dopant may all be substantially the same or identical.

According to one embodiment, the first emission layer 131 and the third emission layer 133 may be in direct contact with each other. For example, other structures may not be located between the first emission layer 131 and the third emission layer 133.

According to one embodiment, the second emission layer 132 and the third emission layer 133 may be in direct contact with each other. For example, other structures may not be located between the second emission layer 132 and the third emission layer 133.

The term "electron transport moiety" used herein may include a cyano group, a phosphine oxide group, a sulfone oxide group, a sulfonate group and/or a $\pi$-electron deficient nitrogen-containing cyclic group.

The term "$\pi$-electron deficient nitrogen-containing cyclic group" used herein refers to a group including a cyclic group having at least one *-N=*' moiety, and may be, for example, pyridine, pyrimidine, triazine, or the like.

Electron transport region in organic layer 150

The electron transport region may have i) a single-layered structure including a single layer including a single material, ii) a single-layered structure including a single layer including a plurality of different materials, or iii) a multi-layered structure having a plurality of layers including a plurality of different materials.

The electron transport region may include at least one selected from a hole blocking layer, a buffer layer, an electron control layer, an electron transport layer, and an electron injection layer, but the embodiments are not limited thereto.

The electron transport region may include at least one selected from a hole blocking layer, an electron transport layer, and an electron injection layer, but the embodiments are not limited thereto.

For example, the electron transport region may have an electron transport layer/electron injection layer structure, an electron transport layer/electron injection layer structure, an electron control layer/electron transport layer/electron injection layer structure, a buffer layer/electron transport layer/electron injection layer structure, a hole blocking layer/electron transport layer/electron injection layer structure, a hole blocking layer/electron control layer/electron transport layer/electron injection layer structure, or a hole blocking layer/buffer layer/electron transport layer/electron injection layer structure, wherein, in each structure, constituting layers are sequentially stacked from the emission layer 130, but the embodiments are not limited thereto.

The electron transport region (for example, the hole blocking layer, the buffer layer, the electron control layer, or the electron transport layer in the electron transport region) may include a metal-free compound containing at least one $\pi$ electron-depleted nitrogen-containing ring.

The "$\pi$ electron-depleted nitrogen-containing ring" indicates a $C_1$-$C_{60}$ (*e.g.* a $C_1$-C30) heterocyclic group having at least one *-N=*' moiety as a ring-forming moiety.

For example, the "$\pi$ electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are fused with each other, or iii) a heteropolycyclic group in which at least one of 5-membered to 7-membered heteromonocyclic groups, each having at least one *-N=*' moiety, is fused with at least one $C_5$-$C_{60}$ (*e.g.* a $C_5$-$C_{30}$) carbocyclic group.

Examples of the $\pi$ electron-depleted nitrogen-containing ring include an imidazole, a pyrazole, a thiazole, an isothiazole, an oxazole, an isoxazole, a pyridine, a pyrazine, a pyrimidine, a pyridazine, an indazole, a purine, a quinoline, an isoquinoline, a benzoquinoline, a phthalazine, a naphthyridine, a quinoxaline, a quinazoline, a cinnoline, a phenanthridine, an acridine, a phenanthroline, a phenazine, a benzimidazole, an isobenzothiazole, a benzoxazole, an isobenzoxazole, a triazole, a tetrazole, an oxadiazole, a triazine, a thiadiazole, an imidazopyridine, an imidazopyrimidine, and an azacarbazole, but the embodiments are not limited thereto.

For example, the electron transport region may include a compound represented by Formula 601 below:

<Formula 601 > $$[Ar_{601}]_{xe11}\text{-}[(L_{601})_{xe1}\text{-}R_{601}]_{xe21}$$

In Formula 601,

$Ar_{601}$ may be a substituted or unsubstituted $C_5$-$C_{60}$ carbocyclic group or a substituted or unsubstituted $C_1$-$C_{60}$ heterocyclic group,

xe11 may be 1, 2, or 3,

$L_{601}$ may be selected from a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, and a substituted or unsubstituted divalent non-aromatic condensed heteropolycyclic group,

xe1 may be an integer from 0 to 5,

$R_{601}$ may be selected from a substituted or unsubstituted $C_3$-$C_{10}$ cycloalkyl group, a substituted or unsubstituted $C_1$-$C_{10}$ heterocycloalkyl group, a substituted or unsubstituted C3-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-Si(Q_{601})(Q_{602})(Q_{603})$, $-C(=O)(Q_{601})$, $-S(=O)_2(Q_{601})$, and $-P(=O)(Q_{601})(Q_{602})$,

$Q_{601}$ to $Q_{603}$ may each independently be a $C_1$-$C_{10}$ alkyl group, a $C_1$-$C_{10}$ alkoxy group, a phenyl group, a biphenyl group, a terphenyl group, or a naphthyl group, and

xe21 may be an integer from 1 to 5.

In one embodiment, at least one of $Ar_{601}$(s) in the number of xe11 and $R_{601}$(s) in the number of xe21 may include the $\pi$ electron-depleted nitrogen-containing ring.

For example, $Ar_{601}$ may be a substituted or unsubstituted $C_5$-$C_{30}$ carbocyclic group or a substituted or unsubstituted $C_1$-$C_{20}$ heterocyclic group, but embodiments are not limited thereto.

In one embodiment, $Ar_{601}$ in Formula 601 may be selected from:

a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and

a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, $-Si(Q_{31})(Q_{32})(Q_{33})$, $-S(=O)_2(Q_{31})$, and $-P(=O)(Q_{31})(Q_{32})$,

wherein $Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

When xe11 in Formula 601 is 2 or more, two or more $Ar_{601}$(s) may be linked to each other via a single bond.

In one or more embodiments, $Ar_{601}$ in Formula 601 may be an anthracene group.

In one or more embodiments, a compound represented by Formula 601 may be represented by Formula 601-1 below:

<Formula 601-1>

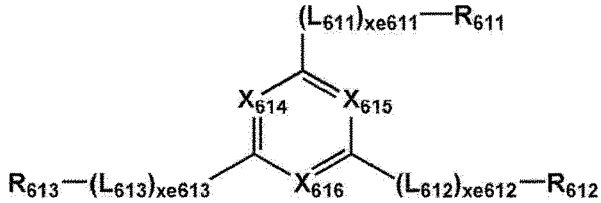

In Formula 601-1,

$X_{614}$ may be N or $C(R_{614})$, $X_{615}$ may be N or $C(R_{615})$, $X_{616}$ may be N or $C(R_{616})$, and at least one selected from $X_{614}$ to $X_{616}$ may be N,

$L_{611}$ to $L_{613}$ may each independently be the same as defined in connection with $L_{601}$,

xe611 to xe613 may each independently be the same as defined in connection with xe1,

$R_{611}$ to $R_{613}$ may each independently be the same as defined in connection with $R_{601}$, and

$R_{614}$ to $R_{616}$ may each independently be selected from hydrogen, deuterium, -F, - Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, and a naphthyl group.

For example, $L_{601}$ and $L_{611}$ to $L_{613}$ in Formulae 601 and 601-1 may each independently be selected from: a substituted or unsubstituted $C_3$-$C_{10}$ cycloalkylene group, a substituted or unsubstituted $C_1$-$C_{10}$ heterocycloalkylene

group, a substituted or unsubstituted C3-$C_{10}$ cycloalkenylene group, a substituted or unsubstituted $C_1$-$C_{10}$ heterocycloalkenylene group, a substituted or unsubstituted $C_6$-$C_{30}$ arylene group, a substituted or unsubstituted $C_1$-$C_{20}$ heteroarylene group, a substituted or unsubstituted divalent non-aromatic condensed polycyclic group, and a substituted or unsubstituted divalent non-aromatic condensed heteropolycyclic group, but embodiments are not limited thereto.

In one embodiment, $L_{601}$ and $L_{611}$ to $L_{613}$ in Formulae 601 and 601-1 may each independently be selected from:

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and

a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group,

but the embodiments are not limited thereto.

In one or more embodiments, xe1 and xe611 to xe613 in Formulae 601 and 601-1 may each independently be 0, 1, or 2.

For example, $R_{601}$ and $R_{611}$ to $R_{613}$ in Formulae 601 and 601-1 may each independently be selected from: a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{30}$ aryl group, a substituted or unsubstituted $C_6$-$C_{30}$ aryloxy group, a substituted or unsubstituted $C_6$-$C_{30}$ arylthio group, a substituted or unsubstituted $C_1$-$C_{20}$ heteroaryl group, a substituted or unsubstituted monovalent non-aromatic condensed polycyclic group, a substituted or unsubstituted monovalent non-aromatic con-

densed heteropolycyclic group, -Si($Q_{601}$)($Q_{602}$)($Q_{603}$), -C(=O)($Q_{601}$), -S(=O)$_2$($Q_{601}$), and -P(=O)($Q_{601}$)($Q_{602}$).

In one or more embodiments, $R_{601}$ and $R_{611}$ to $R_{613}$ in Formula 601 and 601-1 may each independently be selected from:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, - F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and

-S(=O)$_2$($Q_{601}$) and -P(=O)($Q_{601}$)($Q_{602}$),

wherein $Q_{601}$ and $Q_{602}$ are the same as described above.

The electron transport region may include at least one compound selected from Compounds ET1 to ET36 below, but the embodiments are not limited thereto:

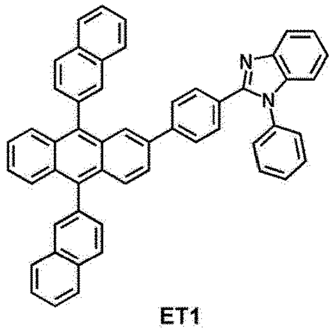

ET1

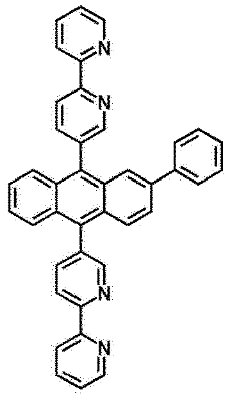

ET2

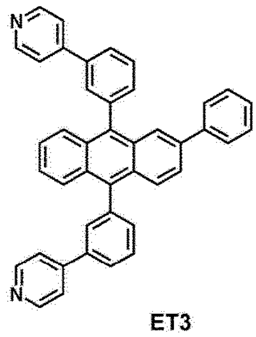

ET3

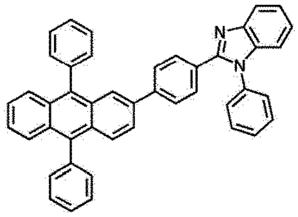

ET4

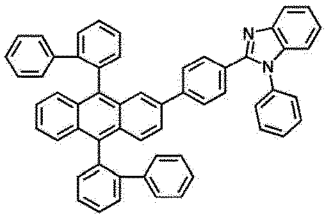

ET5

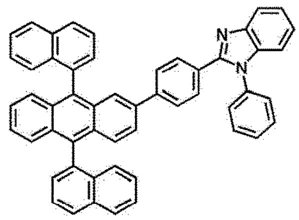

ET6

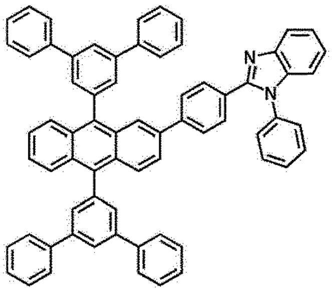

ET7

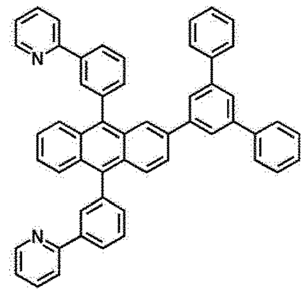

ET8

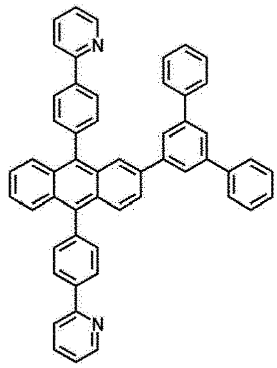

ET9

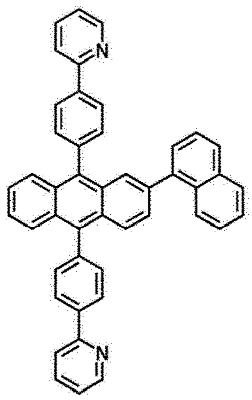

ET10

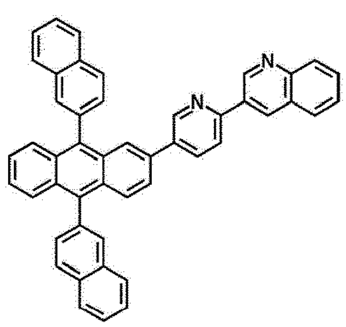

ET11

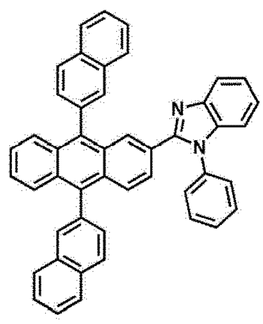

ET12

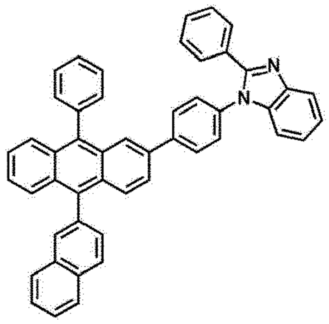

ET13

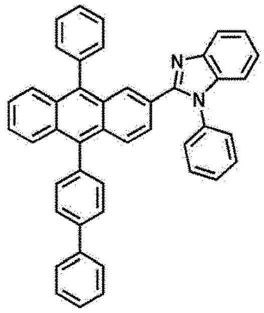

ET14

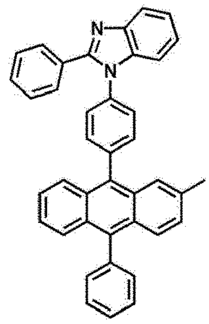

ET15

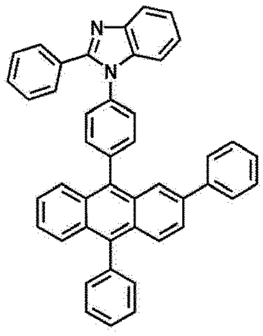

ET16

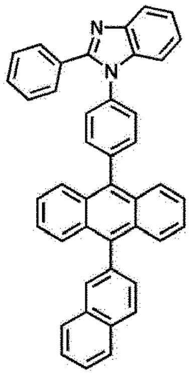

ET17

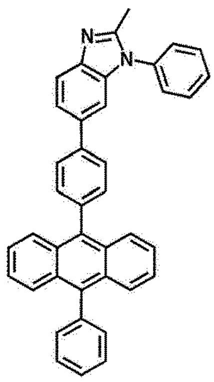

ET18

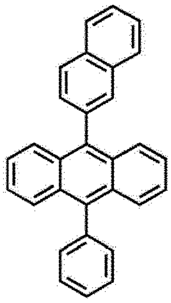

ET19

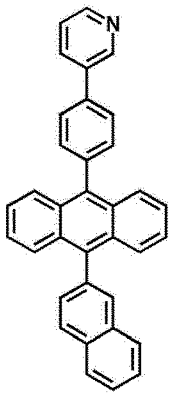

ET20

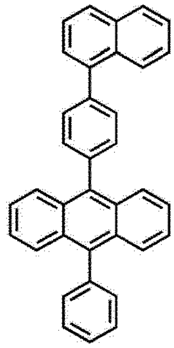

ET21

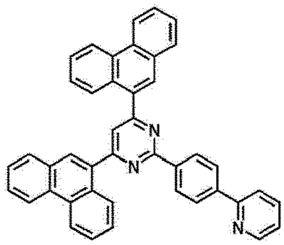

ET22

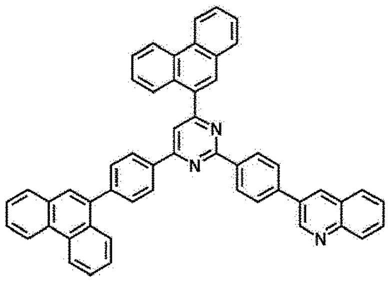

ET23

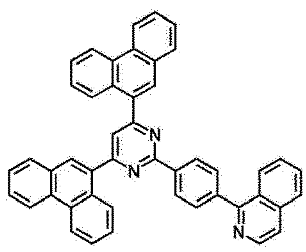

ET24

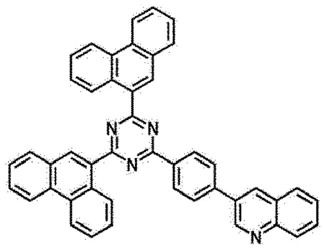
ET25

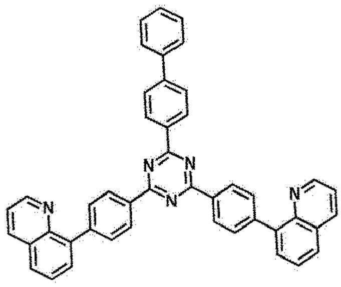
ET26

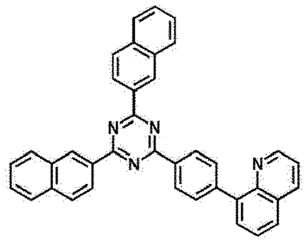
ET27

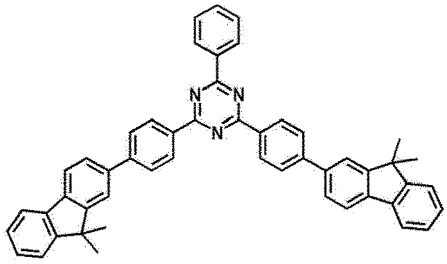
ET28

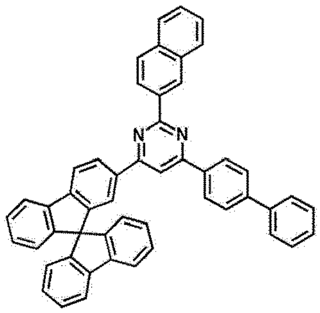
ET29

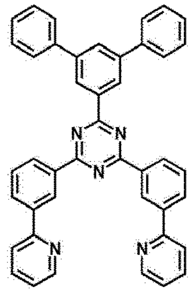
ET30

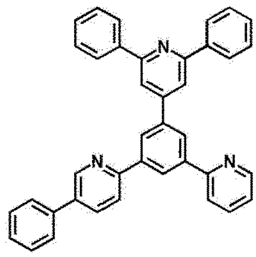
ET31

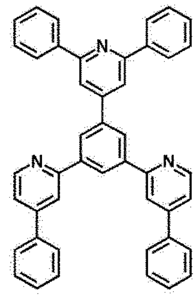
ET32

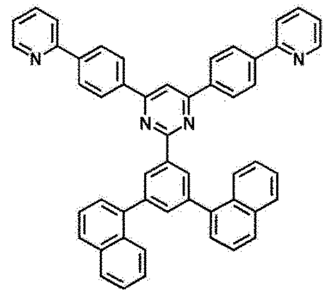
ET33

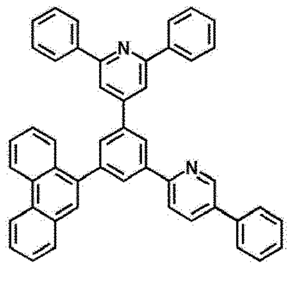
ET34

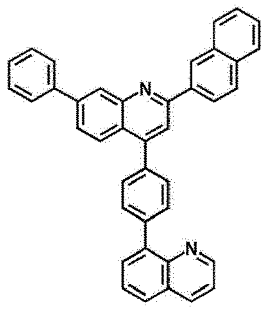
ET35

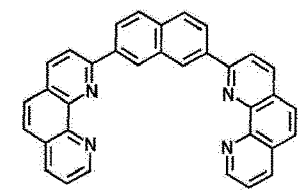
ET36

In one or more embodiments, the electron transport region may include at least one compound selected from 2,9-dimethyl-4,7-diphenyl-1,10-phenanthroline (BCP), 4,7-diphenyl-1,10-phenanthroline (Bphen), tris-(8-hydroxyquinoline)aluminium ($Alq_3$), bis(8-hydroxy-2-methylquinoline)-(4-phenylphenoxy)aluminium (BAlq), 3-(biphenyl-4-yl)-5-(4-tert-butylphenyl)-4-phenyl-4H-1,2,4-triazole (TAZ), 4-(naphthalen-1-yl)-3,5-diphenyl-1,2,4-triazole (NTAZ), TSPO1, TPBI and DPEPO below:

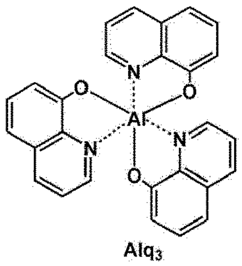
Alq3

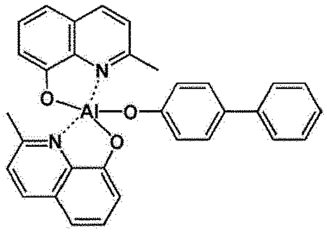
BAlq

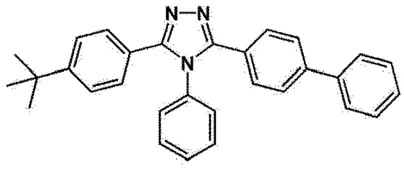
TAZ

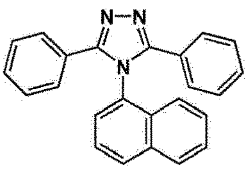
NTAZ

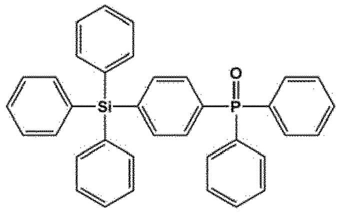
TSPO1

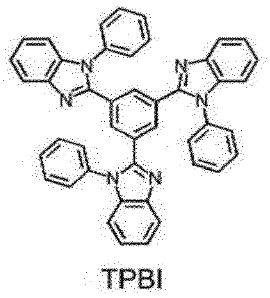
TPBI

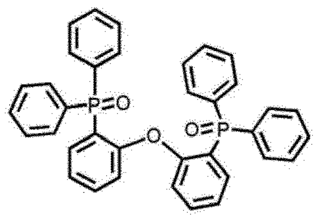
DPEPO

The thickness of the hole blocking layer, the buffer layer, or the electron control layer may be in a range of about 20 Å to about 1,000 Å, for example, about 20 Å to about 700 Å, about 20 Å to about 500 Å, about 20 Å to about 400 Å, about 30 Å to about 400 Å or about 30 Å to about 300 Å. When the thicknesses of the hole blocking layer, the buffer layer, and the electron control layer are within these ranges, the electron transport region may have excellent hole blocking characteristics or electron control characteristics without a substantial increase in driving voltage.

According to one embodiment, the electron transport region includes the hole blocking layer, the hole blocking layer is in direct contact with the second emission layer 132, and the hole blocking material contained in the hole blocking layer is substantially the same or identical as the second electron transport host, and optionally, is substantially identical as the hole transport host.

The thickness of the electron transport layer may be from about 100 Å to about 1,000 Å, for example, about 100 Å to about 700 Å, about 100 Å to about 600 Å, about 150 Å to about 600 Å, about 150 Å to about 500 Å or about 150 Å to about 200 Å. When the thickness of the electron transport layer is within the range described above, the electron transport layer may have satisfactory electron transport characteristics without a substantial increase in driving voltage.

The electron transport region (for example, the electron transport layer in the electron transport region) may further include, in addition to the materials described above, a metal-containing material.

The metal-containing material may include at least one selected from alkali metal complex and alkaline earth-metal complex. The alkali metal complex may include a metal ion selected from a Li ion, a Na ion, a K ion, a Rb ion, and a Cs ion, and the alkaline earth-metal complex may include a metal ion selected from a Be ion, a Mg ion, a Ca ion, a Sr ion, and a Ba ion. A ligand coordinated with the metal ion of the alkali metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but the embodiments are not limited thereto.

For example, the metal-containing material may include a Li complex. The Li complex may include, for example, Compound ET-D1 (lithium quinolate, LiQ) or ET-D2 below:

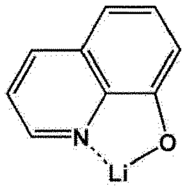

ET-D1

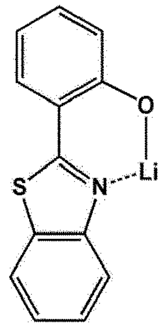

ET-D2

The electron transport region may include an electron injection layer that facilitates electron injection from the second electrode 190. The electron injection layer may directly contact the second electrode 190.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof.

The alkali metal may be selected from Li, Na, K, Rb, and Cs. In one embodiment, the alkali metal may be Li, Na, or Cs. In one or more embodiments, the alkali metal may be Li or Cs, but the embodiments are not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth-metal compound, and the rare earth metal compound may be selected from oxides and halides (for example, fluorides, chlorides, bromides, or iodides) of the alkali metal, the alkaline earth-metal, and the rare earth metal.

The alkali metal compound may be selected from alkali metal oxides, such as $Li_2O$, $Cs_2O$, or $K_2O$, and alkali metal halides, such as LiF, NaF, CsF, KF, LiI, NaI, CsI, KI, or RbI. In one embodiment, the alkali metal compound may be selected from LiF, $Li_2O$, NaF, LiI, NaI, CsI, and KI, but the embodiments are not limited thereto.

The alkaline earth-metal compound may be selected from alkaline earth-metal oxides, such as BaO, SrO, CaO, $Ba_xSr_{1-x}O$ ($0<x<1$), or $Ba_xCa_{1-x}O$ ($0<x<1$). In one embodiment, the alkaline earth-metal compound may be selected from BaO, SrO, and CaO, but the embodiments are not limited thereto.

The rare earth metal compound may be selected from $YbF_3$, $ScF_3$, $Sc_2O_3$, $Y_2O_3$, $Ce_2O_3$, GdF3 and TbF3. In one embodiment, the rare earth metal compound may be selected from $YbF_3$, $ScF_3$, $TbF_3$, $YbI_3$, $ScI_3$, and $TbI_3$, but the embodiments are not limited thereto.

The alkali metal complex, the alkaline earth-metal complex, and the rare earth metal complex may include an ion of alkali metal, alkaline earth-metal, and rare earth metal as described above, and a ligand coordinated with a metal ion of the alkali metal complex, the alkaline earth-metal complex, or the rare earth metal complex may be selected from hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, and cyclopentadiene, but the embodiments are not limited thereto.

The electron injection layer may consist of (or include) an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof, as described above. In one or more embodiments, the electron injection layer may further include an organic material. When the electron injection layer further includes an organic material, an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combinations thereof may be homogeneously or non-homogeneously dispersed in a matrix including the organic material.

The thickness of the electron injection layer may be in a range of about 1 Å to about 200 Å, for example, about 1 Å to about 100 Å, about 3 Å to about 90 Å or about 3 Å to about 20 Å. When the thickness of the electron injection layer is within these ranges, satisfactory electron injection characteristics may be obtained without substantial increase in driving voltage.

The second electrode 190 may be located on the organic layer 150 having such a structure. A material for forming the second electrode 190 may be metal, an alloy, an electrically conductive compound, or a combination thereof,

which have a low work function.

The second electrode 190 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), an ITO, and an IZO, but the embodiments are not limited thereto. The second electrode 190 may be a transmissive electrode, a semi-transmissive electrode, or a reflective electrode.

The second electrode 190 may have a single-layered structure, or a multi-layered structure including two or more layers.

A substrate may be additionally located under the first electrode 110(a surface of the first electrode 110 which does not contact the organic layer) or above the second electrode 190 (a surface of the second electrode 190 which does not contact the organic layer). The substrate may be a glass substrate or a plastic substrate, each having excellent mechanical strength, thermal stability, transparency, surface smoothness, ease of handling, and water resistance.

Embodiment of FIG. 3

FIG. 3 is a schematic cross-sectional diagram of yet another embodiment of an organic light-emitting device constructed according to principles of the invention.

Referring to FIG. 3, the organic light-emitting device 20 includes: a first electrode 210; a second electrode 290 facing the first electrode 210; and an organic layer 250 including an emission layer 230 and located between the first electrode 210 and the second electrode 290, and

The emission layer 230 includes a first emission area 231 and a second emission area 232, wherein the first emission area 231 of the emission layer 230 is closer to the first electrode 210 than the second emission area 232.

Each of the first emission area 231 and the second emission area 232 includes a hole transport host, an electron transport host, and a phosphorescent dopant.

The amount of the hole transport host in the first emission area 231 is greater than the amount of the electron transport host in the first emission area 232, the amount of the electron transport host in the second emission area 232 is greater than the amount of the hole transport host in the second emission area 231, and the phosphorescent dopant is an organometallic compound represented by Formula 4 or 5:

<Formula 4>

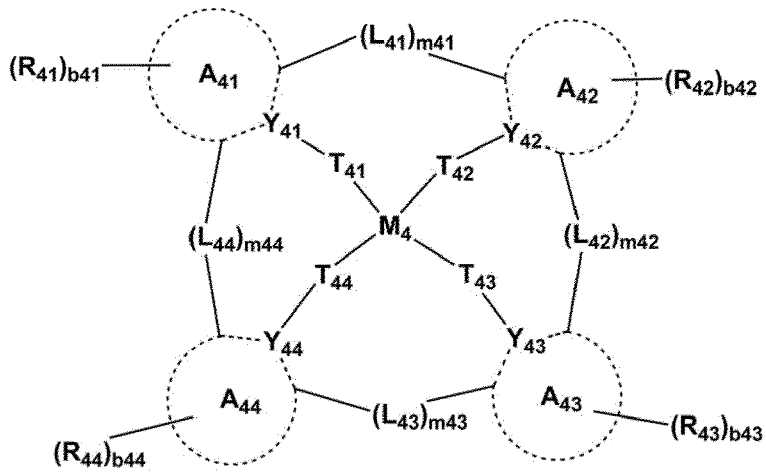

<Formula 5>

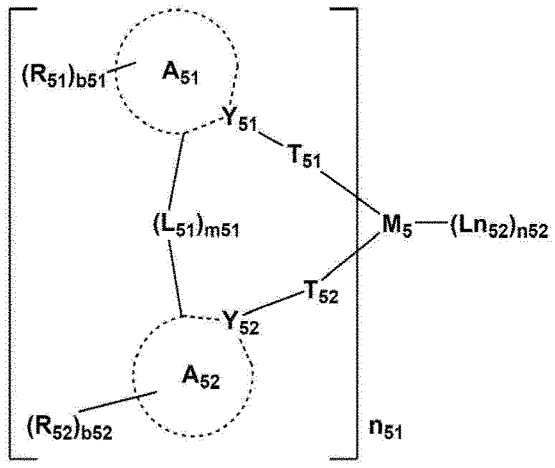

Formulae 4 and 5 are the same as described above.

The organic light-emitting device 20 has an emission layer 230 including the first emission area 231 and the second emission area 232, and the amount of the hole transport host and the amount of the electron transport host are controlled in each of the first emission area 231 and the second emission area, 232, and the phosphorescent dopant necessarily includes a carbene ring in a ligand thereof. Accordingly, in the organic light-emitting device 20, because the balance of holes and electrons in the emission layer 230 is controlled, the hole-electron recombination region is maintained inside the emission layer 230, leading to the prevention of exciton-polaron quenching, and since the concentration of excitons in the emission layer 230 is appropriately controlled, exciton-exciton quenching may be prevented. As a result, the lifespan characteristics of the organic light-emitting device 20 may be significantly improved.

According to one embodiment, the amount of a hole transport host in an emission layer 230 may be gradually decreased from the first emission area 231 to the second emission area 232, and the amount of an electron transport host in the emission layer 230 may be gradually increased from the first emission area 231 to the second emission area 232.

The hole transport host may be understood by referring to the description of the first hole transport host and the second hole transport host above, and the electron transport host may independently be substantially the same or identical as defined above as the first electron transport host and the second electron transport host. In addition, the phosphorescent dopant may independently be substantially the same or identical as defined above as the first phosphorescent dopant and the second phosphorescent dopant.

According to one embodiment, the emission layer 230 may emit blue light having the maximum emission wavelength of about 400 nm to about 500 nm.

Other elements of the organic light-emitting device 20 may be, independently, as corresponding elements as the organic light-emitting device 10, as described above.

One embodiment provides an organic light-emitting device including: a first electrode; a second electrode facing the first electrode; m emission units between the first electrode and the second electrode; and m-1 charge generating unit(s) between adjacent emission units, wherein m is two or more natural numbers, and

each of the emission units includes at least one emission layer 230.

According to one embodiment, at least one of the emission units may include a first emission layer 131 and a second emission layer 132 as described above, or a first emission layer 131, a second emission layer 132, and a third emission layer 133 as described above.

According to one embodiment, at least one of the emission units may include an emission layer 230 including the first emission area 231 and the second emission area 232 as described above. According to one embodiment, the maximum emission wavelength of light emitted from at least one emission unit of the m emission units may be identical to the maximum emission wavelength of light emitted from at least one emission unit of the remaining emission units.

According to one embodiment, the maximum emission wavelength of light emitted from at least one emission unit of the m emission units may be different from the maximum emission wavelength of light emitted from at least one emission unit of the remaining emission units.

In one embodiment, m may be 2,the m emission units may include a first emission unit and a second emission unit,

the first emission unit and the second emission unit may be understood by referring to the description of the emission

unit, as described above,

m-1 charge generating layers may include a first charge generating layer,

the first charge generating layer is located between the first emission unit and the second emission unit,

the first emission unit is located between the first electrode and the first charge generating layer,

the second emission unit is located between the first charge generating layer and a second electrode,

the first charge generating layer includes a 1n-type charge generating layer and a 1p-type charge generating layer, wherein the 1n-type charge generating layer is located between the first emission unit and the second emission unit, and the 1p-type charge generating layer is located between the 1n-type charge generating layer and the second emission unit,

the first emission unit emits first-color light, the second emission unit emits second-color light, the maximum emission wavelength of the first-color light and the maximum emission wavelength of the second-color light may be identical to or different from each other, and

mixed color-light in which the first-color light and the second-color light are mixed with each other may be emitted.

In one embodiment, m may be 3,

the m emission units may include a first emission unit, a second emission unit, and a third emission unit,

the first emission unit, the second emission unit, and the third emission unit may be understood by referring to the description of the emission unit as described herein,

m-1 charge generating layers may include a first charge generating layer and a second charge generating layer,

the first charge generating layer is located between the first emission unit and the second emission unit,

the second charge generating layer is located between the second emission unit and the third emission unit,

the first emission unit may be located between the first electrode and the first charge generating layer,

the second emission unit may be located between the first charge generating layer and the second charge generating layer,

the third emission unit may be located between the second charge generating layer and the second electrode,

the first charge generating layer may include a 1n-type charge generating layer and a 1p-type charge generating layer, wherein the 1n-type charge generating layer is located between the first emission unit and the second emission unit, and the 1p-type charge generating layer is located between the 1n-type charge generating layer and the second emission unit,

the second charge generating layer may include an 2n-type charge generating layer and an 2p-type charge generating layer, wherein the 2n-type charge generating layer is located between the second emission unit and the third emission unit, and the 2p-type charge generating layer is located between the 2n-type charge generating layer and the third emission unit,

the first emission unit emits a first-color light, the second emission unit emits a second-color light, the third emission unit emits a third color light,

the maximum emission wavelength of the first color light, the maximum emission wavelength of the second color light, and the maximum emission wavelength of the third color light may be identical to or different from each other, and

mixed color-light in which the first-color light, the second-color light, and the third-color light are mixed with each other may be emitted.

The organic light-emitting device 10 or 20 may further include a capping layer positioned in a direction in which light is emitted. The capping layer may increase external luminescence efficiency according to the principle of constructive interference.

The capping layer may be an organic capping layer consisting of an organic material, an inorganic capping layer consisting of an inorganic material, or a composite capping layer including an organic material and an inorganic material.

The capping layer may include at least one material selected from carbocyclic compounds, heterocyclic compounds, amine-based compounds, porphyrine derivatives, phthalocyanine derivatives, a naphthalocyanine derivatives, alkali metal complexes, and alkaline earth metal complexes. The carbocyclic compound, the heterocyclic compound, and the amine-based compound may be optionally substituted with a substituent containing at least one element selected from O, N, S, Se, Si, F, Cl, Br, and I. In one embodiment, the capping layer may include an amine-based compound.

In one or more embodiments, the capping layer may include a compound represented by Formula 201 or a compound represented by Formula 202.

In one or more embodiments, the capping layer may include a compound selected from Compounds HT28 to HT33 and Compounds CP1 to CP5 below, but the embodiments are not limited thereto.

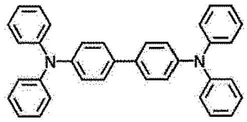

CP1

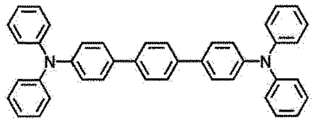

CP2

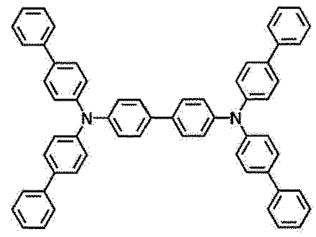

CP3

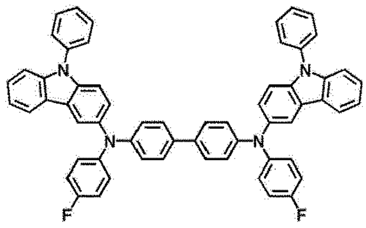

CP4

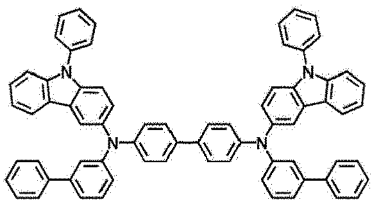

CP5

Hereinbefore, the organic light-emitting device 10 or 20 has been described in connection with FIGS. 1 to 4, but the embodiments are not limited thereto.

Layers constituting the hole transport region, an emission layer 130 or 230, and layers constituting the electron transport region may be formed in a certain region by using one or more suitable methods selected from vacuum deposition, spin coating, casting, Langmuir-Blodgett (LB) deposition, ink-jet printing, laser-printing, and laser-induced thermal imaging (LITI).

When layers constituting the hole transport region, an emission layer 130 or 230, and layers constituting the electron transport region are formed by vacuum deposition, the deposition may be performed at a deposition temperature of about 100 °C to about 500 °C, a vacuum degree of about $10^{-8}$ torr to about $10^{-3}$ torr, and a deposition speed of about 0.01 Å/sec to about 100 Å/sec by taking into account a material to be included in a layer to be formed, and the structure of a layer to be formed.

When layers constituting the hole transport region, an emission layer 130 or 230, and layers constituting the electron transport region are formed by spin coating, the spin coating may be performed at a coating speed of about 2,000 rpm to about 5,000 rpm and at a heat treatment temperature of about 80 °C to 200 °C by taking into account a material to be included in a layer to be formed, and the structure of a layer to be formed.

FIG. 4 is a schematic diagram of an exemplary embodiment of an apparatus containing an organic light-emitting device constructed according to principles of the invention.

The organic light-emitting device 10 or 20 may be included in various apparatuses.

Another aspect of the invention provides an apparatus 300 including the organic light-emitting device 10.

The apparatus 300 may further include, in addition to the organic light-emitting device 10, a thin film transistor 310. Here, the thin film transistor 310 may include a source electrode 320, an activation layer 330, and a drain electrode 340, wherein the first electrode 110 of the organic light-emitting device 10 may be in electrical connection with one or both of the source electrode 320 and the drain electrode 340 of the thin-film transistor 310.

For example, the apparatus 300 may be a light-emitting apparatus, an authentication apparatus, or an electronic apparatus, but the embodiments are not limited thereto.

The light-emitting apparatus 300 may be used as various displays, light sources, and the like.

The authentication apparatus 300 may be, for example, a biometric authentication apparatus for authenticating an individual by using biometric information of a biometric body (for example, a finger tip, a pupil, or the like).

The authentication apparatus may further include, in addition to the organic light-emitting device, a biometric information collector.

The electronic apparatus may be applied to personal computers (for example, a mobile personal computer), mobile phones, digital cameras, electronic organizers, electronic dictionaries, electronic game machines, medical instruments (for example, electronic thermometers, sphygmomanometers, blood glucose meters, pulse measurement devices, pulse wave measurement devices, electrocardiogram (ECG) displays, ultrasonic diagnostic devices, or endoscope displays), fish finders, various measuring instruments, meters (for example, meters for a vehicle, an aircraft, and a vessel), projectors, and the like, but the embodiments are not limited thereto.

The term "$C_1$-$C_{60}$ alkyl group" as used herein refers to a linear or branched aliphatic saturated hydrocarbon monovalent group having 1 to 60 carbon atoms, and examples thereof include a methyl group, an ethyl group, a propyl

group, an isobutyl group, a sec-butyl group, a tert-butyl group, a pentyl group, an isoamyl group, and a hexyl group. The term "$C_1$-$C_{60}$ alkylene group" as used herein refers to a divalent group having a structure corresponding to the $C_1$-$C_{60}$ alkyl group. Corresponding definitions apply to other ranges given for the number of carbon atoms in an alkyl/alkylene group.

The term "$C_2$-$C_{60}$ alkenyl group" as used herein refers to a hydrocarbon group having at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having a structure corresponding to the $C_2$-$C_{60}$ alkenyl group. Corresponding definitions apply to other ranges given for the number of carbon atoms in an alkenyl/alkenylene group.

The term "$C_2$-$C_{60}$ alkynyl group" as used herein refers to a hydrocarbon group having at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having a structure corresponding to the $C_2$-$C_{60}$ alkynyl group. Corresponding definitions apply to other ranges given for the number of carbon atoms in an alkynyl/alkynylene group.

The term "$C_1$-$C_{60}$ alkoxy group" as used herein refers to a monovalent group represented by $-OA_{101}$ (wherein $A_{101}$ is the $C_1$-$C_{60}$ alkyl group), and examples thereof include a methoxy group, an ethoxy group, and an isopropyloxy group. Corresponding definitions apply to other ranges given for the number of carbon atoms in an alkoxy group.

The term "$C_3$-$C_{10}$ cycloalkyl group" as used herein refers to a monovalent saturated hydrocarbon monocyclic group having 3 to 10 carbon atoms, and examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having a structure corresponding to the $C_3$-$C_{10}$ cycloalkyl group.

The term "$C_1$-$C_{10}$ heterocycloalkyl group" as used herein refers to a monovalent monocyclic group having at least one heteroatom selected from N, O, Si, P, and S as a ring-forming atom and 1 to 10 carbon atoms, and examples thereof include a 1,2,3,4-oxatriazolidinyl group, a tetrahydrofuranyl group, and a tetrahydrothiophenyl group. The term "$C_1$-$C_{10}$ heterocycloalkylene group" as used herein refers to a divalent group having a structure corresponding to the $C_1$-$C_{10}$ heterocycloalkyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and examples thereof include a cyclopentenyl group, a cyclohexenyl group, and a cycloheptenyl group. The term "$C_3$-$C_{10}$ cycloalkenylene group" as used herein refers to a divalent group having a structure corresponding to the $C_3$-$C_{10}$ cycloalkenyl group.

The term "$C_1$-$C_{10}$ heterocycloalkenyl group" as used herein refers to a monovalent monocyclic group that has at least one heteroatom selected from N, O, Si, P, and S as a ring-forming atom, 1 to 10 carbon atoms, and at least one carbon-carbon double bond in its ring. Non-limiting examples of the $C_1$-$C_{10}$ heterocycloalkenyl group include a 4,5-dihydro-1,2,3,4-oxatriazolyl group, a 2,3-dihydrofuranyl group, and a 2,3-dihydrothiophenyl group. The term "$C_1$-$C_{10}$ heterocycloalkenylene group" as used herein refers to a divalent group having a structure corresponding to the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and a $C_6$-$C_{60}$ arylene group used herein refers to a divalent group having a carbocyclic aromatic system having 6 to 60 carbon atoms. Non-limiting examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other. Corresponding definitions apply to other ranges given for the number of carbon atoms in an aryl/arylene group.

The term "$C_1$-$C_{60}$ heteroaryl group" as used herein refers to a monovalent group having a carbocyclic aromatic system that has at least one heteroatom selected from N, O, Si, P, and S as a ring-forming atom, in addition to 1 to 60 carbon atoms. The term "$C_1$-$C_{60}$ heteroarylene group" as used herein refers to a divalent group having a carbocyclic aromatic system that has at least one heteroatom selected from N, O, Si, P, and S as a ring-forming atom, in addition to 1 to 60 carbon atoms. Non-limiting examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include two or more rings, the rings may be fused with each other. Corresponding definitions apply to other ranges given for the number of carbon atoms in an heteroaryl/heteroarylene group.

The term "$C_6$-$C_{60}$ aryloxy group" as used herein refers to -OA102 (wherein $A_{102}$ is the $C_6$-$C_{60}$ aryl group), and the term "$C_6$-$C_{60}$ arylthio group" as used herein refers to -SA103 (wherein $A_{103}$ is the $C_6$-$C_{60}$ aryl group). Corresponding definitions apply to other ranges given for the number of carbon atoms in an aryloxy group and an arylthio group.

The term "$C_1$-$C_{60}$ heteroaryloxy group" as used herein refers to -OA104 (wherein A104 is the $C_1$-$C_{60}$ heteroaryl group), and a $C_1$-$C_{60}$ heteroarylthio group used herein refers to - $SA_{105}$ (wherein $A_{105}$ is the $C_1$-$C_{60}$ heteroaryl group). Corresponding definitions apply to other ranges given for the number of carbon atoms in an heteroaryloxy group and an heteroarylthio group

The term "monovalent non-aromatic fused polycyclic group" or "monovalent non-aromatic condensed polycyclic group" as used herein refers to a monovalent group (for example, having 8 to 60 carbon atoms) having two or more rings fused with each other, only carbon atoms as ring-forming atoms, and no aromaticity in its entire molecular structure. A detailed example of the monovalent non-aromatic fused polycyclic group is a fluorenyl group. The term "divalent non-aromatic fused polycyclic group" or "divalent non-aromatic condensed polycyclic group" as used herein refers to a divalent group having a structure corresponding to the monovalent non-aromatic fused polycyclic group.

The term "monovalent non-aromatic fused heteropolycyclic group" or "monovalent non-aromatic condensed heteropolycyclic group" as used herein refers to a monovalent group (for example, having 1 to 60 carbon atoms) having two or more rings fused to each other, at least one heteroatom selected from N, O, Si, P, and S, other than carbon atoms, as a ring-forming atom, and no aromaticity in its entire molecular structure. An example of the monovalent non-aromatic fused heteropolycyclic group is a carbazolyl group. The term "divalent non-aromatic fused heteropolycyclic group" or "divalent non-aromatic condensed heteropolycyclic group" as used herein refers to a divalent group having a structure corresponding to the monovalent non-aromatic fused heteropolycyclic group.

The term "$C_5$-$C_{60}$ carbocyclic group" as used herein refers to a monocyclic or polycyclic group having 5 to 60 carbon atoms in which a ring-forming atom is a carbon atom only. The term "$C_5$-$C_{60}$ carbocyclic group" as used herein refers to an aromatic carbocyclic group or a non-aromatic carbocyclic group. The $C_5$-$C_{60}$ carbocyclic group may be a ring, such as benzene, a monovalent group, such as a phenyl group, or a divalent group, such as a phenylene group. In one or more embodiments, depending on the number of substituents connected to the $C_5$-$C_{60}$ carbocyclic group, the $C_5$-$C_{60}$ carbocyclic group may be a trivalent group or a quadrivalent group. Corresponding definitions apply to other ranges given for the number of carbon atoms in a carbocyclic group.

The term "$C_1$-$C_{60}$ heterocyclic group" as used herein refers to a group having a structure corresponding to the $C_5$-$C_{60}$ carbocyclic group, except that as a ring-forming atom, at least one heteroatom selected from N, O, Si, P, and S is used in addition to carbon (the number of carbon atoms may be in a range of 1 to 60). Corresponding definitions apply to other ranges given for the number of carbon atoms in a heterocyclic group.

The terms "hydrogen" and "deuterium" refer to their respective atoms and corresponding radicals, and the terms "-F, -Cl, -Br, and -I" are radicals of, respectively, fluorine, chlorine, bromine, and iodine.

In the embodiments, at least one substituent of the substituted $C_5$-$C_{60}$ (*e.g.* $C_5$-$C_{60}$) carbocyclic group, the substituted $C_1$-$C_{60}$ *(e.g.* $C_1$-$C_{20}$) heterocyclic group, the substituted $C_1$-$C_{20}$ alkylene group, the substituted $C_2$-$C_{20}$ alkenylene group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ (*e.g.* $C_6$-$C_{30}$) arylene group, the substituted $C_1$-$C_{60}$ (*e.g.* $C_1$-$C_{20}$) heteroarylene group, the substituted divalent non-aromatic fused polycyclic group, the substituted divalent non-aromatic fused heteropolycyclic group, the substituted $C_1$-$C_{60}$ (*e.g.* $C_1$-$C_{20}$) alkyl group, the substituted $C_2$-$C_{60}$ (*e.g.* $C_2$-$C_{20}$) alkenyl group, the substituted $C_2$-$C_{60}$ (*e.g.* $C_2$-$C_{20}$) alkynyl group, the substituted $C_1$-$C_{60}$ (*e.g.* $C_1$-$C_{20}$) alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ (*e.g.* $C_6$-$C_{30}$) aryl group, the substituted $C_6$-$C_{60}$ (*e.g.* $C_6$-$C_{30}$) aryloxy group, the substituted $C_6$-$C_{60}$ (*e.g.* $C_6$-$C_{30}$) arylthio group, the substituted $C_1$-$C_{60}$ (*e.g.* $C_1$-$C_{20}$) heteroaryl group, the substituted $C_1$-$C_{60}$ (*e.g.* $C_1$-$C_{20}$) heteroaryloxy group, the substituted $C_1$-$C_{60}$ (*e.g.* $C_1$-$C_{20}$) heteroarylthio group, the substituted monovalent non-aromatic fused polycyclic group, and the substituted monovalent non-aromatic fused heteropolycyclic group may be selected from:

deuterium (-D), -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, and a $C_1$-$C_{60}$ (*e.g.* $C_1$-C20) alkoxy group;

a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, and a $C_1$-$C_{60}$ (*e.g.* $C_1$-$C_{20}$) alkoxy group, each substituted with at least one selected from deuterium, -F, -Cl, -Br, -I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic fused polycyclic group, a monovalent non-aromatic fused heteropolycyclic group, -Si($Q_{11}$)($Q_{12}$)($Q_{13}$), - N($Q_{11}$)($Q_{12}$), -B($Q_{11}$)($Q_{12}$), -C(=O)($Q_{11}$), -S(=O)$_2$($Q_{11}$), and -P(=O)($Q_{11}$)($Q_{12}$);

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a C6-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic fused polycyclic group, and a monovalent non-aromatic fused heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a C6-C60 (*e.g.* $C_6$-$C_{30}$) aryloxy group, a $C_6$-$C_{60}$ (*e.g.* $C_6$-$C_{30}$) arylthio

group, a $C_1$-$C_{60}$ (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-$C_{20}$) heteroarylthio group, a monovalent non-aromatic fused polycyclic group, and a monovalent non-aromatic fused heteropolycyclic group, each substituted with at least one selected from deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_6$-$C_{60}$ (*e.g.* $C_6$-$C_{30}$) aryloxy group, a $C_6$-$C_{60}$ (*e.g.* $C_6$-$C_{30}$) arylthio group, a $C_1$-$C_{60}$ (*e.g.* $C_1$-$C_{20}$) heteroaryl group, a $C_1$-$C_{60}$ (*e.g.* $C_1$-C20) heteroaryloxy group, a $C_1$-$C_{60}$ (e.g. $C_1$-$C_{20}$) heteroarylthio group, a monovalent non-aromatic fused polycyclic group, a monovalent non-aromatic fused heteropolycyclic group, - $Si(Q_{21})(Q_{22})(Q_{23})$, $-N(Q_{21})(Q_{22})$, $-B(Q_{21})(Q_{22})$, $-C(=O)(Q_{21})$, $-S(=O)_2(Q_{21})$, and $-P(=O)(Q_{21})(Q_{22})$; and

$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and - $P(=O)(Q_{31})(Q_{32})$,

wherein $Q_{11}$ to $Q_{13}$, $Q_{21}$ to $Q_{23}$, and $Q_{31}$ to $Q_{33}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{60}$ (*e.g.* $C_1$-$C_{20}$) alkyl group, a $C_2$-$C_{60}$ (*e.g.* $C_2$-$C_{20}$) alkenyl group, a $C_2$-$C_{60}$ (*e.g.* $C_2$-$C_{20}$) alkynyl group, a $C_1$-$C_{60}$ (*e.g.* $C_1$-$C_{20}$) alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ (*e.g.* $C_6$-$C_{30}$) aryl group, a $C_1$-C60 (*e.g.* $C_1$-$C_{20}$) heteroaryl group, a $C_1$-$C_{60}$ (*e.g.* $C_1$-$C_{20}$) heteroaryloxy group, a $C_1$-$C_{60}$ (*e.g.* $C_1$-C20) heteroarylthio group, a monovalent non-aromatic fused polycyclic group, a monovalent non-aromatic fused heteropolycyclic group, a $C_1$-$C_{60}$ (*e.g.* $C_1$-$C_{20}$) alkyl group substituted with at least one selected from deuterium, -F, and a cyano group, a $C_6$-$C_{60}$ (*e.g.* $C_1$-$C_{20}$) aryl group substituted with at least one selected from deuterium, -F, and a cyano group, a biphenyl group, and a terphenyl group.

As used herein, a substituent for a monovalent group, e.g., alkyl, may also be, independently, a substituent for a corresponding divalent group, e.g., alkylene.

The term "Ph" as used herein refers to a phenyl group, the term "Me" as used herein refers to a methyl group, the term "Et" as used herein refers to an ethyl group, the term "ter-Bu" or "$Bu^t$" as used herein refers to a tert-butyl group, and the term "OMe" as used herein refers to a methoxy group.

The term "biphenyl group" as used herein refers to "a phenyl group substituted with a phenyl group". In other words, the "biphenyl group" is a substituted phenyl group having a $C_6$-$C_{60}$ aryl group as a substituent.

The term "terphenyl group" as used herein refers to "a phenyl group substituted with a biphenyl group". In other words, the "terphenyl group" is a substituted phenyl group having, as a substituent, a $C_6$-$C_{60}$ aryl group substituted with a $C_6$-$C_{60}$ aryl group.

**[0277]** * and *' as used herein, unless defined otherwise, each refer to a binding site to a neighboring atom in a corresponding formula.

Hereinafter, a light-emitting device according to embodiments will be described in detail with reference to Examples. The wording "B was used instead of A" used in describing Examples refers to that an identical molar equivalent of B was used in place of A.

Examples

**Example 1**

A 15 Ω/cm$^2$ (1,200 Å) ITO glass substrate (first electrode) from Corning, Inc. of Corning, New York was cut to the size of 50 mm x 50 mm x 0.7 mm, sonicated with isopropyl alcohol and pure water, each for 5 minutes, and then cleaned by exposure to ultraviolet rays and ozone for 30 minutes. Then, the ITO glass substrate was provided to a vacuum deposition apparatus.

Compounds HT1, and 2,3,5,6-tetrafluoro-7,7,8,8-tetracyanoquinodimethane (F4-TCNQ), which was used as a p-dopant in amount of 2 wt%, were vacuum-deposited on the glass substrate to form a hole injection layer having a thickness of 100 Å, and then, HT1 was vacuum-deposited thereon to form a hole transport layer having a thickness of 700 Å.

The compound TCTA was vacuum-deposited on the hole transport layer to form an electron blocking layer having a thickness of 100 Å.

Compounds CBP and 2,4-diphenyl-6-bis(12-phenylindolo)([2,3-a]carbazole-11-yl)-1,3,5-triazine (DIC-TRZ) (see the weight ratios of Table 1), which were used as hosts, and the compound PD26 (8 wt%), which was used as a dopant, were co-deposited on the electron blocking layer to form an emission layer (i.e., a first emission layer and a second emission layer) having a thickness of 200 Å.

DIC-TRZ was vacuum-deposited on the emission layer to form a hole blocking layer having a thickness of 100 Å.

The compounds ET1 and LiQ (weight ratio of 5:5) were vacuum-deposited on the hole blocking layer to form an electron transport layer having a thickness of 150 Å. LiF was vacuum-deposited on the electron transport layer to form an electron injection layer having a thickness of 150 Å, and Al was vacuum-deposited on the electron transport layer to form a second electrode having a thickness of 1000 Å, thereby completing the manufacture of an organic light-emitting device.

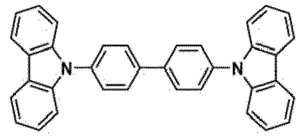
CBP

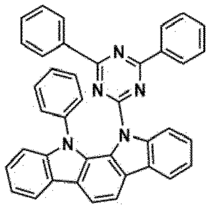
DIC-TRZ

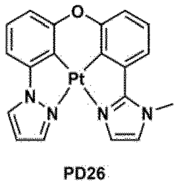
PD26

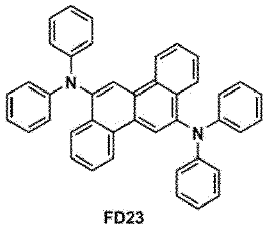
FD23

**Examples 2 to 4 and Comparative Examples 1 to** 3

Organic light-emitting devices were manufactured in the same manner as in Example 1, except that the structures of the emission layer and the compound compositions of Table 1 were used. The first light-emitting layer of Example 2 was formed so that the weight ratio of the hosts CBP and DIC-TRZ gradually changed from 10:0 to 2:8, and the second light-emitting layer of Example 2 was formed so that the weight ratio of the hosts CBP and DIC-TRZ gradually changed from 2:8 to 0:10.

**Evaluation Example** 2: **Evaluation of organic light-emitting devices**

The driving voltage, current efficiency, and lifespan ($T_{95}$) of the organic light-emitting devices manufactured according to Examples 1 to 4 and Comparative Examples 1 to 3 were measured using a source-measure unit sold under the trade designation Keithley SMU 236 by Tektronix, Inc., of Beaverton, Oregon and a luminance meter sold under the trade designation PR650, and the results are shown in Table 1. The lifespan is a measure of how long it took to reach 95% of the initial luminance.

Table 1

| | First emission layer | | Third emission layer | | Second emission layer | | Driving voltage (V) | Current efficiency (cd/A) | $T_{95}$(relative value) |
|---|---|---|---|---|---|---|---|---|---|
| | Host | Dopant | Host | Dopant | Host | Dopant | | | |
| Example 1 | CBP+DIC-TRZ(6:4) | PD26 | - | - | CBP+DIC-TRZ(3:7) | PD26 | 4.5 | 21 | 207% |
| Example 2 | CBP+DIC-TRZ (CBP 100 wt% → 20 wt%) | PD26 | - | - | CBP+DIC-TRZ (CBP 20wt% →0wt%) | PD26 | 4.5 | 26 | 230% |
| Example 3 | CBP+DIC-TRZ(8:2) | PD26 | CBP+DIC -TRZ (5:5) | PD26 | CBP+DIC-TRZ(2:8) | PD26 | 4.3 | 25 | 246% |
| Example 4 | CBP+DIC-TRZ (6:4) | PD26+FD23 | | | CBP+DIC-TRZ (3:7) | PD26+FD23 | 4.6 | 23 | 221% |
| Comparativ e Example 1 | CBP | PD26 | - | - | - | - | 5.1 | 14 | 100% |
| Comparativ e Example 2 | CBP+DIC-TRZ(7:3) | FD23 | - | - | CBP+DIC-TRZ (3:7) | FD23 | 4.6 | 19 | 171% |
| Comparativ e Example 3 | CBP+DIC-TRZ (6:4) | PD26 | - | - | CBP+DIC-TRZ(8:2) | PD26 | 4.9 | 16 | 161% |

From Table 1, it can be seen that the organic light-emitting devices of Examples 1 to 4 have a lower or equivalent driving voltage, higher current efficiency, and longer lifespan than those of Comparative Example 1 to 3.

Although certain embodiments and implementations have been described herein, other embodiments and modifications will be apparent from this description. Accordingly, the inventive concepts are not limited to such embodiments, but rather to the broader scope of the appended claims and various obvious modifications and equivalent arrangements as would be apparent to a person of ordinary skill in the art.

## Claims

**1.** An organic light-emitting device comprising:

a first electrode;
a second electrode facing the first electrode; and
an organic layer disposed between the first electrode and the second electrode and comprising a first emission layer and a second emission layer;
wherein the first emission layer is located closer to the first electrode than the second emission layer and comprises a first hole transport host, a first electron transport host, and a first phosphorescent dopant, and, in the first emission layer, an amount of the first hole transport host is greater than an amount of the first electron transport host,
the second emission layer comprises a second hole transport host, a second electron transport host, and a second phosphorescent dopant, and, in the second emission layer, an amount of the second electron transport host is greater than an amount of the second hole transport host, and
the first emission layer and the second emission layer are configured to emit light of substantially the same color.

**2.** An organic light-emitting device according to claim 1, wherein
the first hole transport host and the second hole transport host are each, independently from one another, at least one of a compound represented by Formula 1:

<Formula 1>

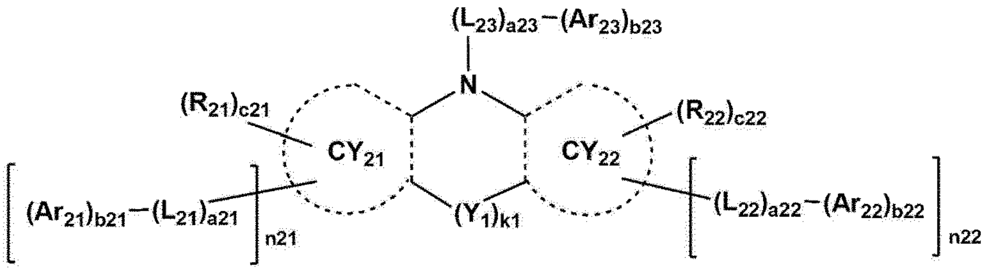

the first electron transport host and the second electron transport host are each, independently from one another, a compound represented by Formula 2:

<Formula 2>

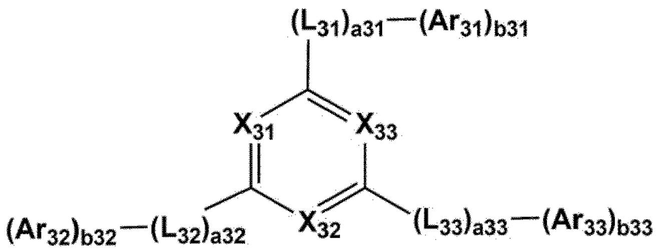

wherein, in Formula 1 and Formula 2,

$Y_1$ is a single bond, -O-, -S-, $-C(R_{24})(R_{25})-$, $-N(R_{24})-$, $-Si(R_{24})(R_{25})-$, -C(=O)-, $-S(=O)_2-$, - $B(R_{24})-$, $-P(R_{24})-$, or $-P(=O)(R_{24})(R_{25})-$;
k1 is 0 or 1;
$CY_{21}$ and $CY_{22}$ are each, independently from one another, a $C_5$-$C_{60}$ carbocyclic group or a $C_1$-$C_{60}$ heterocyclic group;
$X_{31}$ is N or $C[(L_{34})_{a34}-(R_{31})]$, $X_{32}$ is N or $C[(L_{35})_{a35}-(R_{32})]$, and $X_{33}$ is N or $C[(L_{36})_{a36}-(R_{33})]$;
$L_{21}$ to $L_{23}$ and $L_{31}$ to $L_{36}$ are each, independently from one another, a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted C6-C60 arylene group, a substituted or unsubstituted $C_1$-$C_{60}$ heteroarylene group, a substituted or unsubstituted divalent non-aromatic fused polycyclic group, or a substituted or unsubstituted divalent non-aromatic fused heteropolycyclic group;
a21 to a23 and a31 to a36 are each, independently from one another, an integer from 0 to 5;
$Ar_{21}$ to $Ar_{23}$ and $Ar_{31}$ to $Ar_{33}$ are each, independently from one another, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_1$-$C_{60}$ heteroaryl group, a substituted or unsubstituted monovalent non-aromatic fused polycyclic group, or a substituted or unsubstituted monovalent non-aromatic fused heteropolycyclic group;
b21 to b23 and b31 to b33 are each, independently from one another, an integer from 1 to 8;
$R_{21}$, $R_{22}$, $R_{24}$, $R_{25}$, and $R_{31}$ to $R_{33}$ are each, independently from one another, hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_1$-$C_{60}$ heteroaryloxy group, a substituted or unsubstituted $C_1$-$C_{60}$heteroarylthio group, a substituted or unsubstituted monovalent non-aromatic fused polycyclic group, a substituted or unsubstituted monovalent non-aromatic fused heteropolycyclic group, $-Si(Q_1)(Q_2)(Q_3)$, $-N(Q_1)(Q_2)$, - $B(Q_1)(Q_2)$, $-C(=O)(Q_1)$, $-S(=O)_2(Q_1)$ and $-P(=O)(Q_1)(Q_2)$;
c21 and c22 are each, independently from one another, an integer from 1 to 8;
n21 and n22 are each, independently from one another, an integer from 1 to 8;
at least two of $Ar_{21}$ to $Ar_{23}$, $R_{21}$ and $R_{22}$ are optionally linked to each other to form a substituted or unsubstituted $C_5$-$C_{60}$ carbocyclic group or a substituted or unsubstituted $C_1$-$C_{60}$ heterocyclic group;
at least two of $Ar_{31}$ to $Ar_{33}$ and $R_{31}$ to $R_{33}$ are optionally linked to each other to form a substituted or unsubstituted $C_5$-$C_{60}$ carbocyclic group or a substituted or unsubstituted $C_1$-$C_{60}$ heterocyclic group; and
at least one substituent of the substituted $C_5$-$C_{60}$ carbocyclic group, the substituted $C_1$-$C_{60}$ heterocyclic group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic fused polycyclic group, the substituted divalent non-aromatic fused heteropolycyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted $C_1$-$C_{60}$ heteroaryloxy group, the substituted $C_1$-$C_{60}$ heteroarylthio group, the substituted monovalent non-aromatic fused polycyclic group, and the substituted monovalent non-aromatic fused heteropolycyclic group is:

deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a C2-C60 alkynyl group, and a $C_1$-$C_{60}$ alkoxy group;
a $C_1$-$C_{60}$ alkyl group, a $C_2$-$C_{60}$ alkenyl group, a $C_2$-$C_{60}$ alkynyl group, and a $C_1$-$C_{60}$ alkoxy group, each, independently from one another, substituted with at least one of deuterium, - F, -Cl, -Br, -I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group,

a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic fused polycyclic group, a monovalent non-aromatic fused heteropolycyclic group, -Si($Q_{11}$)($Q_{12}$)($Q_{13}$), - N($Q_{11}$)($Q_{12}$), -B($Q_{11}$)($Q_{12}$), -C(=O)($Q_{11}$), -S(=O)$_2$($Q_{11}$), and -P(=O)($Q_{11}$)($Q_{12}$);
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic fused polycyclic group, and a monovalent non-aromatic fused heteropolycyclic group, each, independently from one another, optionally substituted with at least one of deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic fused polycyclic group, a monovalent non-aromatic fused heteropolycyclic group, -Si($Q_{21}$)($Q_{22}$)($Q_{23}$), -N($Q_{21}$)($Q_{22}$), -B($Q_{21}$)($Q_{22}$), - C(=O)($Q_{21}$), -S(=O)$_2$($Q_{21}$), and -P(=O)($Q_{21}$)($Q_{22}$); and
-Si($Q_{31}$)($Q_{32}$)($Q_{33}$), -N($Q_{31}$)($Q_{32}$), -B($Q_{31}$)($Q_{32}$), -C(=O)($Q_{31}$), -S(=O)$_2$($Q_{31}$), and - P(=O)($Q_{31}$)($Q_{32}$);
wherein $Q_1$ to $Q_3$, $Q_{11}$ to $Q_{13}$, $Q_{21}$ to $Q_{23}$, and $Q_{31}$ to $Q_{33}$ are each, independently from one another, hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a C6-C60 aryl group, a $C_1$-$C_{60}$ heteroaryl group, a monovalent non-aromatic fused polycyclic group, a monovalent non-aromatic fused heteropolycyclic group; a biphenyl group, and a terphenyl group.

**3.** An organic light-emitting device according to claim 1 or claim 2, wherein:

(i) the first hole transport host and the second hole transport host are substantially identical to each other; and/or
(ii) the first electron transport host and the second electron transport host are substantially identical to each other; and/or
(iii) the first emission layer and the second emission layer each configured to emit blue light having a maximum emission wavelength of about 400 nm to about 500 nm; and/or
(iv) the first phosphorescent dopant and the second phosphorescent dopant are substantially identical to each other; and/or
(v) at least one of the first emission layer and the second emission layer further comprises at least one of a fluorescence dopant and a delayed fluorescence dopant.

**4.** An organic light-emitting device according to any one of claims 1 to 3, wherein
the organic layer further comprises a third emission layer disposed between the first emission layer and the second emission layer, and
the third emission layer includes a third hole transport host, a third electron transport host, and a third phosphorescent dopant.

**5.** An organic light-emitting device according to claim 4, wherein
the amount of the first hole transport host in the first emission layer is greater than an amount of the third hole transport host in the third emission layer, and
the amount of the third hole transport host in the third emission layer is greater than the amount of the second hole transport host in the second emission layer.

**6.** An organic light-emitting device according to claim 4 or claim 5, wherein
the amount of the second electron transport host in the second emission layer is greater than an amount of the third electron transport host in the third emission layer, and
the amount of the third electron transport host in the third emission layer is greater than the amount of the first electron transport host in the first emission layer.

**7.** An organic light-emitting device according to any one of claims 4 to 6, wherein:

(i) the third hole transport host and the third electron transport host of the third emission layer have a weight ratio in the range of about 4: 6 to about 6: 4; and/or
(ii) the first hole transport host, the second hole transport host, and the third hole transport host are substantially

identical to each other; and/or
(iii) the first electron transport host, the second electron transport host, and the third electron transport host are substantially identical to each other; and/or
(iv) the first phosphorescent dopant, the second phosphorescent dopant, and the third phosphorescent dopant are substantially identical to each other.

**8.** An organic light-emitting device according to any one of claims 1 to 7, wherein
the first electrode is an anode;
the second electrode is a cathode; and
the organic layer further comprises a hole transport region disposed between the first electrode and the first emission layer and an electron transport region disposed between the second emission layer and the second electrode.

**9.** An organic light-emitting device according to claim 8, wherein:

(i) the hole transport region comprises at least one of a hole injection layer, a hole transport layer, a buffer layer, an emission auxiliary layer, and an electron blocking layer, and
the electron transport region comprises at least one of a hole blocking layer, an electron transport layer, and an electron injection layer; and/or
(ii) the hole transport region comprises a p-dopant having a lowest unoccupied molecular orbital energy level of less than about -3.5 eV.

**10.** An organic light-emitting device according to claim 8 or claim 9, wherein:

(i) the electron transport region comprises a hole blocking layer including a hole blocking material,
the hole blocking layer directly contacts the second emission layer, and
the hole blocking material is substantially the same as the second electron transport host; and/or
(ii) the electron transport region comprises a metal-containing material.

**11.** An organic light-emitting device comprising:

a first electrode;
a second electrode facing the first electrode; and
an organic layer disposed between the first electrode and the second electrode and including an emission layer, having a first emission area and a second emission area;
wherein, in the emission layer, the first emission area is located closer to the first electrode than the second emission area;
each of the first emission area and the second emission area includes a hole transport host, an electron transport host, and a phosphorescent dopant;
an amount of the hole transport host in the first emission area is greater than an amount of the electron transport host in the first emission area;
an amount of the electron transport host in the second emission area is greater than an amount of the hole transport host in the second emission area; and
the phosphorescent dopant is an organometallic compound represented by Formula 4 or 5:

<Formula 4>

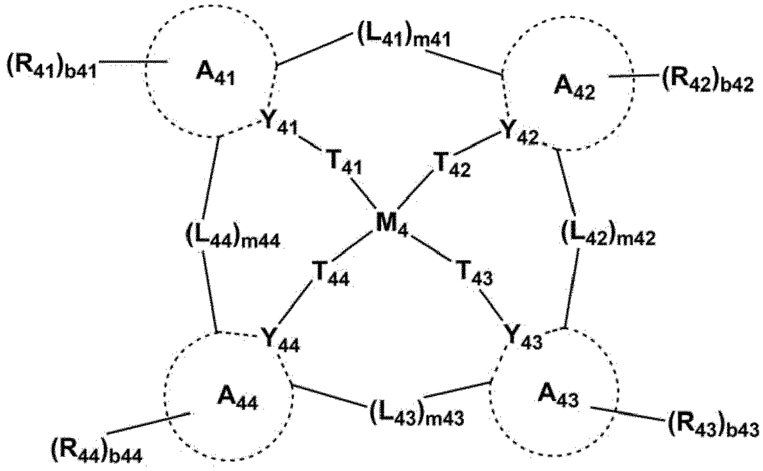

<Formula 5>

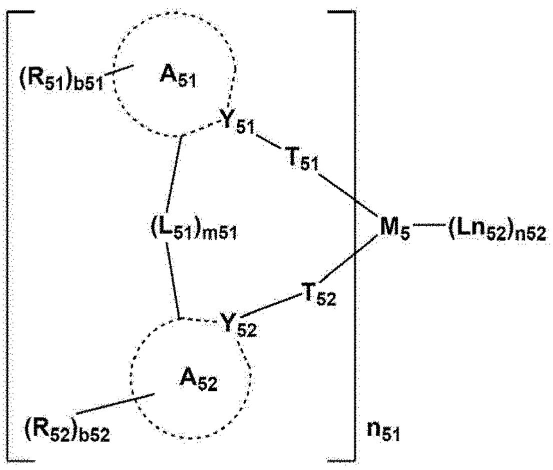

wherein, in Formulae 4 and 5,
$M_4$ and $M_5$ are each, independently from one another, platinum (Pt), palladium (Pd), copper (Cu), silver (Ag), gold (Au), rhodium (Rh), iridium (Ir), ruthenium (Ru), osmium (Os), titanium (Ti), zirconium (Zr), hafnium (Hf), europium (Eu), terbium (Tb), or thulium (Tm);
n51 is an integer from 1 to 3;
$Ln_{52}$ is an organic ligand, and n52 is an integer from 0 to 2;
$Y_{41}$ to $Y_{44}$, $Y_{51}$ and $Y_{52}$ are each, independently from one another, N or C;
$A_{41}$ to $A_{44}$, $A_{51}$ and $A_{52}$ are each, independently from one another, a $C_5$-$C_{60}$ carbocyclic group, or a $C_1$-$C_{60}$ heterocyclic group;
at least one of $A_{41}$ to $A_{44}$ is a carbene ring, and at least one of $A_{51}$ and $A_{52}$ is a carbene ring;
$T_{41}$ to $T_{44}$, $T_{51}$, and $T_{52}$ are each, independently from one another, a single bond, *-O-*', or *-S-*';
$L_{41}$ to $L_{44}$ and $L_{51}$ are each, independently from one another, of a single bond, *-O-*', *-S-*', *-C($R_{45}$)($R_{46}$)-*', *-C($R_{45}$)=*', *=C($R_{45}$)-*', *-C($R_{45}$)=C($R_{46}$)-*', *-C(=O)-*', *-C(=S)-*', *-C≡C-*', *-B($R_{45}$)-*', *-N($R_{45}$)-*', *-P($R_{45}$)-*', *-Si($R_{45}$)($R_{46}$)-*', *-P(=O)($R_{45}$)-*', or *-Ge($R_{45}$)($R_{46}$)-*';
m41 to m44 and m51 are each, independently from one another, an integer from 0 to 3,
$R_{41}$ to $R_{46}$, $R_{51}$, and $R_{52}$ are each, independently from one another, hydrogen, deuterium, - F, -Cl, -Br, -I, a hydroxyl group, a cyano group, a nitro group, an amidino group, a hydrazine group, a hydrazone group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substi-

tuted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic fused polycyclic group, a substituted or unsubstituted monovalent non-aromatic fused heteropolycyclic group, -Si($Q_{41}$)($Q_{42}$)($Q_{43}$), -N($Q_{41}$)($Q_{42}$), -B($Q_{41}$)($Q_{42}$), -C(=O)($Q_{41}$), - S(=O)$_2$($Q_{41}$), or -P(=O)($Q_{41}$)($Q_{42}$);

regarding a pair of $R_{45}$ and $R_{41}$, a pair of $R_{45}$ and $R_{42}$, a pair of $R_{45}$ and $R_{43}$, or a pair of $R_{45}$ and $R_{44}$, components of each pair are optionally linked to form a substituted or unsubstituted C5-C60 carbocyclic group or a substituted or unsubstituted $C_1$-$C_{60}$ heterocyclic group;

b41 to b44, b51 and b52 are each, independently from one another, an integer from 1 to 8;

* and *' each indicate a binding site to a neighboring atom; and

at least one substituent of the substituted $C_5$-$C_{60}$ carbocyclic group, the substituted $C_1$-$C_{60}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic fused polycyclic group, and the substituted monovalent non-aromatic fused heteropolycyclic group is:

deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a C2-C60 alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one of deuterium, -F, -Cl, -Br, -I, a hydroxyl group, a cyano group, a nitro group, an amidino group, a hydrazino group, a hydrazono group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic fused polycyclic group, a monovalent non-aromatic fused heteropolycyclic group, -Si($Q_{51}$)($Q_{52}$)($Q_{53}$), -N($Q_{51}$)($Q_{52}$), -B($Q_{51}$)($Q_{52}$), - C(=O)($Q_{51}$), -S(=O)$_2$($Q_{51}$) and -P(=O)($Q_{51}$)($Q_{52}$);

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic fused polycyclic group, and a monovalent non-aromatic fused heteropolycyclic group, each optionally substituted with at least one of deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a C6-C60 aryl group, a $C_6$-$C_{60}$ aryloxy group, a $C_6$-$C_{60}$ arylthio group, a $C_1$-$C_{60}$ heteroaryl group, a monovalent non-aromatic fused polycyclic group, a monovalent non-aromatic fused heteropolycyclic group, -Si($Q_{61}$)($Q_{62}$)($Q_{63}$), -N($Q_{61}$)($Q_{62}$), -B($Q_{61}$)($Q_{62}$), -C(=O)($Q_{61}$), - S(=O)$_2$($Q_{61}$), and -P(=O)($Q_{61}$)($Q_{62}$); and

-Si($Q_{71}$)($Q_{72}$)($Q_{73}$), -N($Q_{71}$)($Q_{72}$), -B($Q_{71}$)($Q_{72}$), -C(=O)($Q_{71}$), -S(=O)$_2$($Q_{71}$) and - P(=O)($Q_{71}$)($Q_{72}$),

wherein $Q_{41}$ to $Q_{43}$, $Q_{51}$ to $Q_{53}$, $Q_{61}$ to $Q_{63}$, and $Q_{71}$ to $Q_{73}$ are each, independently from one another, hydrogen, deuterium, -F, -Cl, -Br, -I, a hydroxyl group, a cyano group, a nitro group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a $C_1$-$C_{60}$ heteroaryloxy group, a $C_1$-$C_{60}$ heteroarylthio group, monovalent non-aromatic fused polycyclic group, monovalent non-aromatic fused heteropolycyclic group; a $C_1$-$C_{60}$ alkyl group optionally substituted with at least one of deuterium, -F, and a cyano group; a $C_6$-$C_{60}$ aryl group optionally substituted with at least one of deuterium, -F, and a cyano group; a biphenyl group, or a terphenyl group.

**12.** An organic light-emitting device according to claim 11, wherein:

(i) the emission layer is configured to emit blue light having a maximum emission wavelength of about 400 nm to about 500 nm; and/or

(ii) an amount of the hole transport host in the emission layer gradually decreases from the first emission area toward the second emission area, and

an amount of the electron transport host in the emission layer gradually increases from the first emission area toward the second emission area.

**13.** An organic light-emitting device according to claim 11 or claim 12, wherein
the first electrode is an anode,
the second electrode is a cathode,
the organic layer further comprises a hole transport region disposed between the first electrode and the emission layer and an electron transport region disposed between the emission layer and the second electrode,
the hole transport region comprises at least one of a hole injection layer, a hole transport layer, a buffer layer, an emission auxiliary layer, and an electron blocking layer, and
the electron transport region comprises at least one of a hole blocking layer, an electron transport layer, and an electron injection layer, optionally wherein the hole transport region comprises a p-dopant having a lowest unoccupied molecular orbital energy level of less than about -3.5 eV.

**14.** An organic light-emitting device according to claim 13, wherein:

(i) the electron transport region comprises the hole blocking layer including a hole blocking material,
the hole blocking layer directly contacts the emission layer, and
the hole blocking material is substantially identical to the hole transport host; and/or
(ii) the electron transport region comprises a metal-containing material.

**15.** An apparatus comprising:

a thin-film transistor including a source electrode, a drain electrode, and an activation layer; and
the organic light-emitting device according to any one of claims 1 to 14;
wherein the first electrode of the organic light-emitting device is electrically connected with one of the source electrode and the drain electrode of the thin-film transistor.

FIG. 1

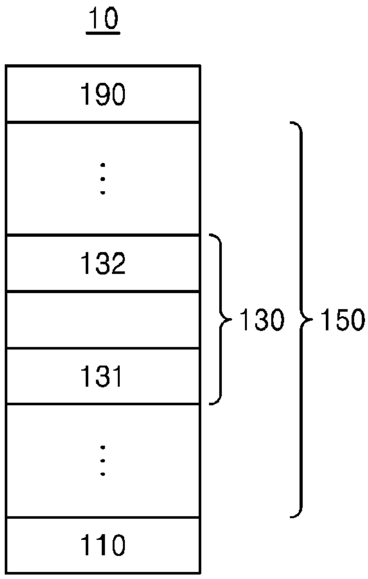

FIG. 2

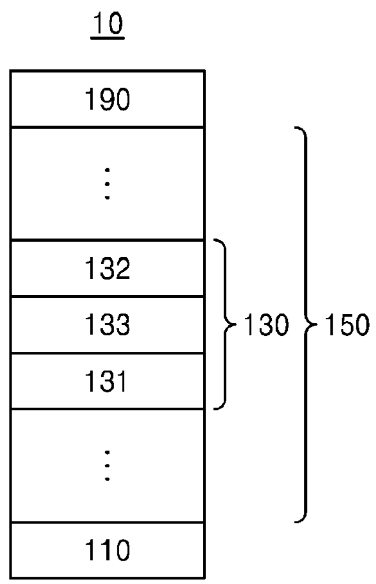

FIG. 3

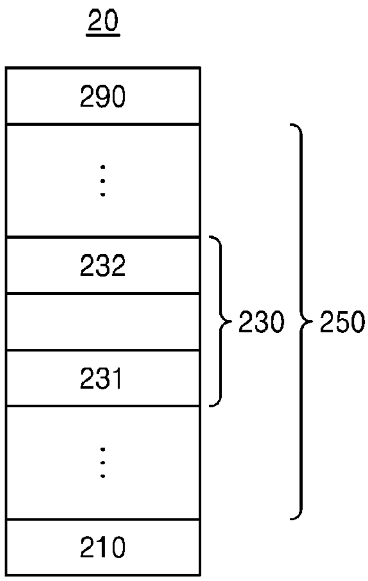

FIG. 4

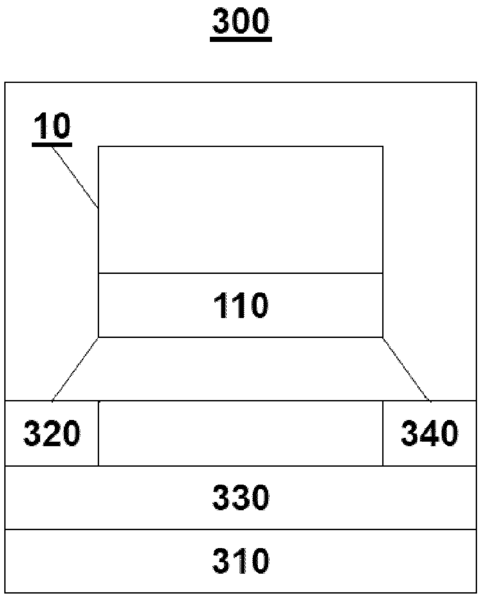

Europäisches Patentamt
European Patent Office
Office européen des brevets

# EUROPEAN SEARCH REPORT

Application Number
EP 20 20 7360

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/352829 A1 (SEO HIROMI [JP] ET AL) 7 December 2017 (2017-12-07)<br>* paragraphs [0080] - [0087], [0104], [0116], [0130] - [0132], [0163] - [0166], [0245], [0134]; figures 1a,5 * | 1-15 | INV.<br>H01L51/00<br>H01L51/50 |
| A | US 2019/058144 A1 (LEE SUNGHUN [KR] ET AL) 21 February 2019 (2019-02-21)<br>* paragraphs [0261], [0200] - [0204], [0347] - [0379] * | 1,2 | |
| A | US 2005/260440 A1 (SEO SATOSHI [JP] ET AL) 24 November 2005 (2005-11-24)<br>* paragraphs [0044], [0075]; figure 10 * | 1,11,12 | |
| A | US 2014/291647 A1 (SUZUKI TSUNENORI [JP] ET AL) 2 October 2014 (2014-10-02)<br>* paragraphs [0051], [0076] - [0080], [0086] - [0096]; figures 1a,1b * | 1,11 | |

TECHNICAL FIELDS SEARCHED (IPC)

H01L

The present search report has been drawn up for all claims

1

| Place of search | Date of completion of the search | Examiner |
|---|---|---|
| The Hague | 30 March 2021 | Chin, Patrick |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 20 20 7360

This annex lists the patent family members relating to the patent documents cited in the above-mentioned European search report. The members are as contained in the European Patent Office EDP file on
The European Patent Office is in no way liable for these particulars which are merely given for the purpose of information.

30-03-2021

| Patent document cited in search report | Publication date | Patent family member(s) | Publication date |
|---|---|---|---|
| US 2017352829 A1 | 07-12-2017 | CN 104205398 A | 10-12-2014 |
| | | CN 107425125 A | 01-12-2017 |
| | | JP 6785812 B2 | 18-11-2020 |
| | | JP 2013232629 A | 14-11-2013 |
| | | JP 2018101637 A | 28-06-2018 |
| | | JP 2021009856 A | 28-01-2021 |
| | | KR 20150005575 A | 14-01-2015 |
| | | KR 20210003940 A | 12-01-2021 |
| | | TW 201349616 A | 01-12-2013 |
| | | TW 201742289 A | 01-12-2017 |
| | | TW 201901999 A | 01-01-2019 |
| | | US 2014061604 A1 | 06-03-2014 |
| | | US 2016315275 A1 | 27-10-2016 |
| | | US 2017352829 A1 | 07-12-2017 |
| | | WO 2013150968 A1 | 10-10-2013 |
| US 2019058144 A1 | 21-02-2019 | CN 109326733 A | 12-02-2019 |
| | | EP 3439063 A1 | 06-02-2019 |
| | | KR 20190013105 A | 11-02-2019 |
| | | US 2019058144 A1 | 21-02-2019 |
| US 2005260440 A1 | 24-11-2005 | CN 1362746 A | 07-08-2002 |
| | | CN 1551697 A | 01-12-2004 |
| | | EP 1220340 A2 | 03-07-2002 |
| | | EP 2256840 A2 | 01-12-2010 |
| | | JP 5613816 B2 | 29-10-2014 |
| | | JP 5820350 B2 | 24-11-2015 |
| | | JP 2011109153 A | 02-06-2011 |
| | | JP 2012238896 A | 06-12-2012 |
| | | JP 2014017532 A | 30-01-2014 |
| | | KR 20020055416 A | 08-07-2002 |
| | | KR 20070013254 A | 30-01-2007 |
| | | KR 20080075480 A | 18-08-2008 |
| | | MY 146765 A | 14-09-2012 |
| | | SG 115435 A1 | 28-10-2005 |
| | | SG 138466 A1 | 28-01-2008 |
| | | SG 138467 A1 | 28-01-2008 |
| | | SG 148030 A1 | 31-12-2008 |
| | | SG 2009086778 A | 29-11-2016 |
| | | TW 543342 B | 21-07-2003 |
| | | US 2002086180 A1 | 04-07-2002 |
| | | US 2005260440 A1 | 24-11-2005 |
| | | US 2009273280 A1 | 05-11-2009 |
| US 2014291647 A1 | 02-10-2014 | JP 6411045 B2 | 24-10-2018 |
| | | JP 6723305 B2 | 15-07-2020 |

EPO FORM P0459

For more details about this annex : see Official Journal of the European Patent Office, No. 12/82

page 1 of 2

## ANNEX TO THE EUROPEAN SEARCH REPORT ON EUROPEAN PATENT APPLICATION NO. EP 20 20 7360

This annex lists the patent family members relating to the patent documents cited in the above-mentioned European search report. The members are as contained in the European Patent Office EDP file on
The European Patent Office is in no way liable for these particulars which are merely given for the purpose of information.

30-03-2021

| Patent document cited in search report | Publication date | Patent family member(s) | Publication date |
|---|---|---|---|
| | | JP 2014209607 A | 06-11-2014 |
| | | JP 2019050378 A | 28-03-2019 |
| | | JP 2020155787 A | 24-09-2020 |
| | | KR 20140118790 A | 08-10-2014 |
| | | KR 20200123764 A | 30-10-2020 |
| | | US 2014291647 A1 | 02-10-2014 |
| | | US 2018151815 A1 | 31-05-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2011140046 A
- JP 2013034967 A
- JP 2015530745 A
- JP 2014512416 A
- JP 2015525248 A
- JP 2013524707 A
- JP 2013547225 A
- JP 2012274324 A
- JP 2015504322 A
- US 20120217869
- WO 2015118035 A
- WO 2016091887 A
- WO 2016096851 A
- KR 20177005332
- JP 2014518737 A
- US 20160197286
- US 20140138627
- US 20140145149
- US 20140158992
- US 20140145151
- US 20150021555
- US 20140332758
- KR 20140154391
- JP 2015148588 A
- JP 2016506442 A
- JP 2015531748 A
- JP 2016538300 A
- JP 2016538393 A
- JP 2015095814 A
- JP 2012538639 A
- JP 2014525803 A
- JP 2012546858 A
- JP 2014538540 A
- WO 2015158692 A
- JP 2016538435 A
- JP 2016538426 A
- JP 2015500308 A
- JP 2015527231 A
- KR 20127017497
- KR 20137001396
- KR 20140068027
- KR 20147003327
- US 20110304262
- US 20140027734
- JP 2015508569 A
- JP 2014554306 A